# EUROPEAN PATENT SPECIFICATION

(11) **EP 4 123 000 B1**
(45) Date of publication and mention of the grant of the patent: **29.05.2024**
(21) Application number: 22177963.0
(22) Date of filing: 08.06.2022
(51) Int. Cl.: C09K 11/06, C07F 15/00, H10K 85/30, H10K 50/11, H10K 101/10

(54) **ORGANOMETALLIC COMPOUND AND ORGANIC LIGHT-EMITTING DEVICE INCLUDING THE SAME**
ORGANOMETALLISCHE VERBINDUNG UND ORGANISCHE LICHTEMITTIERENDE VORRICHTUNG DAMIT
COMPOSÉ ORGANOMÉTALLIQUE ET DISPOSITIF ÉLECTROLUMINESCENT ORGANIQUE L'INCLUANT

(30) Priority: 22.07.2021 KR 20210096715
(43) Date of publication of application: 25.01.2023
(73) Proprietor: Samsung Electronics Co., Ltd., Gyeonggi-do, 16677 (KR)
(72) Inventor: CHOI, Hyesung, 16678 Suwon-si (KR); KIM, Hwang Suk, 16678 Suwon-si (KR); MIN, Minsik, 16678 Suwon-si (KR); PARK, Sangho, 16678 Suwon-si (KR); BAE, Hyejin, 16678 Suwon-si (KR); JEON, Soonok, 16678 Suwon-si (KR); KANG, Hosuk, 16678 Suwon-si (KR); KIM, Jong Soo, 16678 Suwon-si (KR); SON, Youngmok, 16678 Suwon-si (KR); CHWAE, Jun, 16678 Suwon-si (KR)
(74) Representative: Elkington and Fife LLP

(56) References cited:
- US-A1- 2015 105 556

## Description

### FIELD OF THE INVENTION

The present disclosure relates to organometallic compounds and organic light-emitting devices including the same.

### BACKGROUND OF THE INVENTION

Organic light-emitting devices (OLEDs) are self-emissive devices that produce full-color images, and also have wide viewing angles, high contrast ratios, short response times, and excellent characteristics in terms of luminance, driving voltage, and response speed, compared to devices in the art.

In an example, an organic light-emitting device includes an anode, a cathode, and an organic layer arranged between the anode and the cathode, wherein the organic layer includes an emission layer. A hole transport region may be arranged between the anode and the emission layer, and an electron transport region may be arranged between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transition from an excited state to a ground state, thereby generating light.

US 2015/105556 A1 discloses platinum complexes and devices including the same.

### SUMMARY OF THE INVENTION

Provided are organometallic compounds and organic light-emitting devices including the same.

Additional aspects will be set forth in part in the description, which follows and, in part, will be apparent from the description, or may be learned by practice of the presented embodiments of the disclosure.

According to an aspect of the invention, provided is an organometallic compound in accordance with claim 1.

According to another aspect of the invention, provided is an organic light-emitting device including: a first electrode; a second electrode; and an organic layer arranged between the first electrode and the second electrode, wherein the organic layer includes an emission layer, and wherein the organic layer further includes at least one organometallic compound represented by Formula 1.

### BRIEF DESCRIPTION OF THE DRAWING

The above and other aspects, features, and advantages of certain embodiments of the disclosure will be more apparent from the following description taken in conjunction with the drawing.

The FIGURE is a schematic cross-sectional view of an organic light-emitting device according to one or more embodiments.

### DETAILED DESCRIPTION OF THE EMBODIMENTS

Reference will now be made in detail to embodiments, examples of which are illustrated in the accompanying drawings, wherein like reference numerals refer to like elements throughout the specification. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the same associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

According to an aspect of the invention, an organometallic compound is represented by Formula 1:

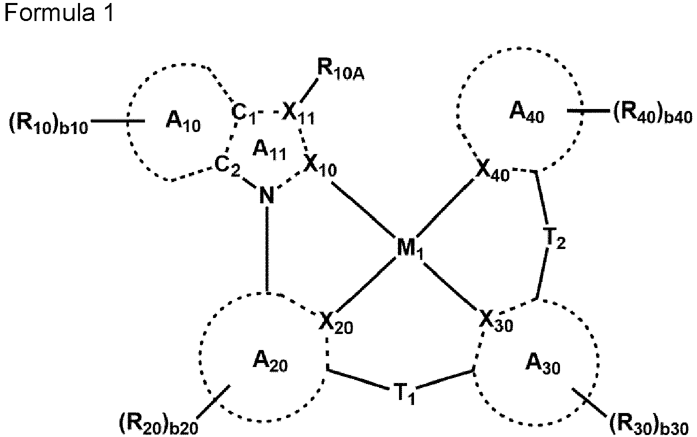

In Formula 1, M₁ is a transition metal.

In Formula 1, M₁ may be a Period 1 transition metal of the Periodic Table of Elements, a Period 2 transition metal of the Periodic Table of Elements, or a Period 3 transition metal of the Periodic Table of Elements.

In one or more embodiments, M₁ may be iridium (Ir), platinum (Pt), osmium (Os), titanium (Ti), zirconium (Zr), hafnium (Hf), europium (Eu), terbium (Tb), thulium (Tm), rhodium (Rh), palladium (Pd), or gold (Au).

In one or more embodiments, M₁ may be Pt, Pd, or Au.

In Formula 1, X₁₀, X₁₁, X₂₀, X₃₀, and X₄₀ are each independently C or N, provided that one of X₁₀ and X₁₁ is N, and the other of X₁₀ and X₁₁ is C.

In one or more embodiments, X₂₀ and X₃₀ may each be C, and X₄₀ may be N.

In Formula 1, two bonds of a bond between X₁₀ and M₁, a bond between X₂₀ and M₁, a bond between X₃₀ and M₁, and a bond between X₄₀ and M₁ may be coordinate bonds, and the other two bonds may be covalent bonds. In this regard, the organometallic compound represented by Formula 1 may be electrically neutral.

In one or more embodiments, a bond between X₁₀ and M₁ in Formula 1 may be a coordinate bond.

In one or more embodiments, in Formula 1, one bond of a bond between X₂₀ and M₁, a bond between X₃₀ and M₁, and a bond between X₄₀ and M₁ may be a coordinate bond, and the other two bonds may be covalent bonds. For example, in Formula 1, a bond between X₂₀ M₁ and a bond between X₃₀ and M₁ may be covalent bonds, and a bond between X₄₀ and M₁ may be a coordinate bond.

In Formula 1, ring A₁₀ is present or absent, and each of C₁ and C₂ is C when ring A₁₀ is present, and C₁ is C(R₁₁) and C₂ is C(R₁₂) when ring A₁₀ is not present.

In Formula 1, ring A₁₁, which is a 5-membered ring including N, X₁₀, X₁₁, C₁, and C₂ as ring members, is a pyrazole ring or an imidazole ring.

In Formula 1, ring A₁₀ may be absent, or ring A₁₀ may be a C₅-C₃₀ carbocyclic group or a C₁-C₃₀ heterocyclic group.

In Formula 1, ring A₂₀, ring A₃₀, and ring A₄₀ are each independently a C₅-C₃₀ carbocyclic group or a C₁-C₃₀ heterocyclic group.

In one or more embodiments, in Formula 1, ring A₁₀, ring A₂₀, ring A₃₀, and ring A₄₀ may each independently be i) a first ring, ii) a second ring, iii) a condensed ring in which two or more first rings are condensed with each other, iv) a condensed ring in which two or more second rings are condensed with each other, or v) a condensed ring in which one or more first rings and one or more second rings are condensed with each other,
the first ring may be a cyclopentane group, a cyclopentadiene group, a furan group, a thiophene group, a pyrrole group, a silole group, a borole group, a phosphole group, a germole group, a selenophene group, an oxazole group, an isoxazole group, an oxadiazole group, an oxatriazole group, a thiazole group, an isothiazole group, a thiadiazole group, a thiatriazole group, a pyrazole group, an imidazole group, a triazole group, a tetrazole group, an azasilole group, a diazasilole group, or a triazasilole group, and
the second ring may be an adamantane group, a norbornane group, a norbornene group, a cyclohexane group, a cyclohexene group, a cyclohexadiene group, a benzene group, a pyridine group, a pyrimidine group, a pyrazine group, a pyridazine group, a triazine group, an oxazine group, a thiazine group, a dihydropyrazine group, a dihydropyridine group, or a dihydroazasilole group.

For example, in Formula 1, ring A₁₀, ring A₂₀, ring A₃₀, and ring A₄₀ may each independently be a cyclopentane group, a cyclopentene group, a cyclohexane group, a cyclohexene group, a cyclohexadiene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, a borole group, a phosphole group, a germole group, a selenophene group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group.

In one or more embodiments, a moiety represented by 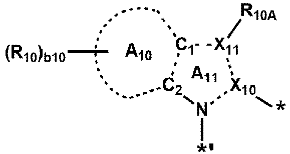
in Formula 1 may be represented by one of Formulae A10(1) to A10(4): 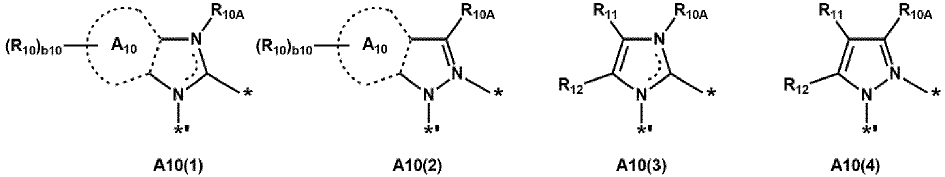
wherein, in Formulae A10(1) to A10(4),
   ring A₁₀ may be a C₅-C₃₀ carbocyclic group or a C₁-C₃₀ heterocyclic group,
   R_{10A}, R₁₀ to R₁₂, and b10 may respectively be as described herein,
   two or more of a plurality of R₁₀(s) are optionally linked together to form a substituted or unsubstituted C₅-C₃₀ carbocyclic group or a substituted or unsubstituted C₁-C₃₀ heterocyclic group,
   neighboring two or more of R₁₀ and R₁₀ₐ are optionally linked together to form a substituted or unsubstituted C₅-C₃₀ carbocyclic group or a substituted or unsubstituted C₁-C₃₀ heterocyclic group,
   * indicates a binding site to M₁, and
   *' indicates a binding site to ring A₂₀.

In one or more embodiments, a moiety represented by 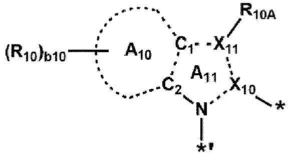
in Formula 1 may be represented by Formula A10-1, A10-2, A10(3), or A10(4): 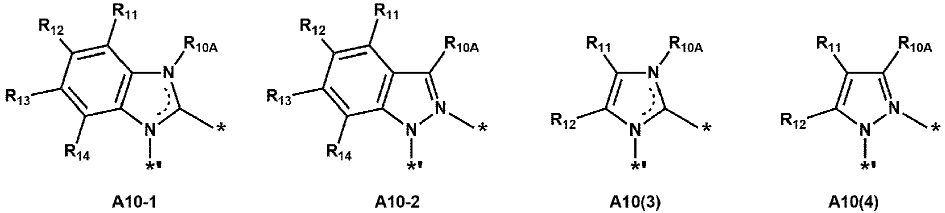
wherein, in Formulae A10-1, A10-2, A10(3), and A10(4),
   R_{10A}, R₁₁, and R₁₂ may respectively be as described herein,
   R₁₃ and R₁₄ may each be as described in connection with R₁₀,
   two or more of R₁₁ to R₁₄, and R_{10A} are optionally linked together to form a substituted or unsubstituted C₅-C₃₀ carbocyclic group or a substituted or unsubstituted C₁-C₃₀ heterocyclic group,
   * indicates a binding site to M₁ in Formula 1, and
   *' indicates a binding site to ring A₂₀ in Formula 1.

In one or more embodiments, ring A₂₀ in Formula 1 may be represented by one of Formulae A20(1) to A20(15): 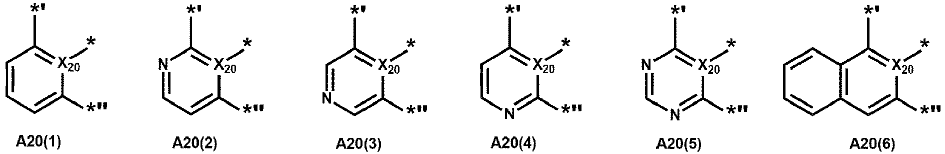 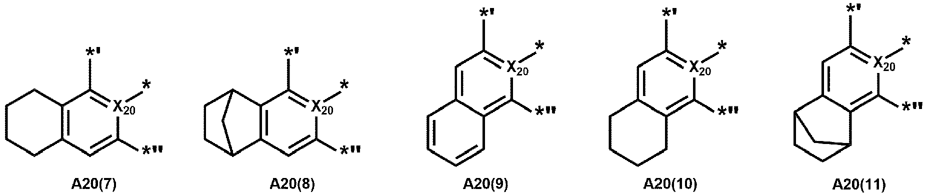 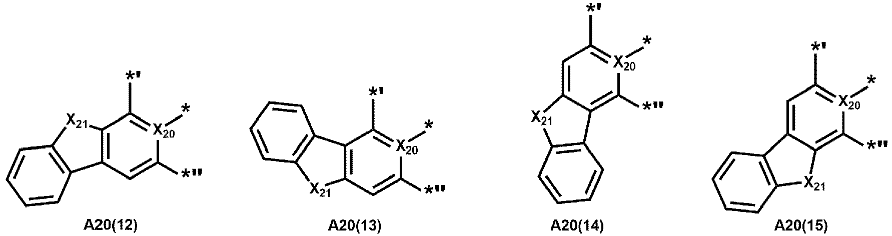 wherein, in Formulae A20(1) to A20(15),
X₂₀ may be C or N,
X₂₁ may be O, S, N(R₂₆), C(R₂₆)(R₂₇), or Si(R₂₆)(R₂₇), wherein R₂₆ and R₂₇ may each be as described in connection with R₂₀,
* indicates a binding site to M₁ in Formula 1, and
* indicates a binding site to a nitrogen (N) atom in Formula 1, and
*" indicates a binding site to T₁ in Formula 1.

In one or more embodiments, ring A₃₀ in Formula 1 may be represented by one of Formulae A30(1) to A30(12): 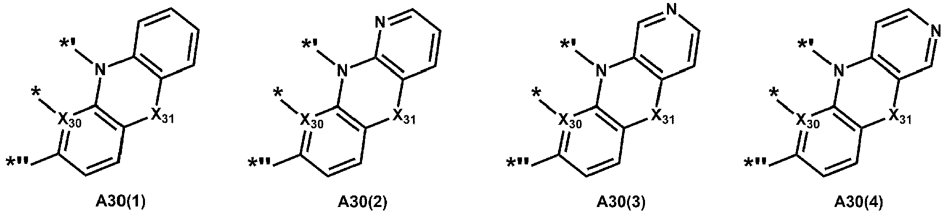 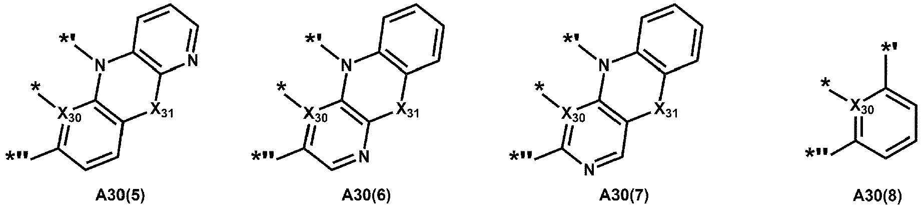 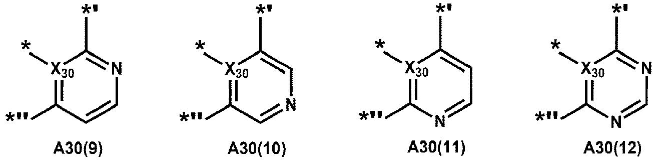 wherein, in Formulae A30(1) to A30(12),
X₃₀ may be C or N,
X₃₁ may be a single bond, O, S, N(R₃₇), C(R₃₇)(R₃₈), or Si(R₃₇)(R₃₈), wherein R₃₇ and R₃₈ may each be as described in connection with R₃₀,
* indicates a binding site to M₁ in Formula 1,
*' indicates a binding site to T₂ in Formula 1, and
*" indicates a binding site to T₁ in Formula 1.

For example, ring A₃₀ in Formula 1 may be represented by Formula A30(1), and accordingly, a moiety represented by 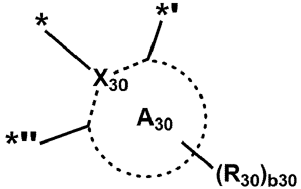
in Formula 1 may be represented by Formula A30-1: 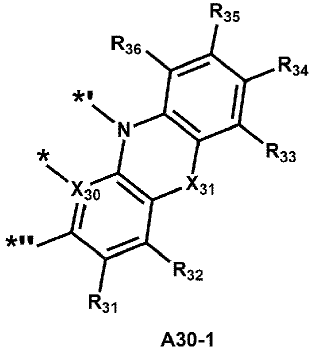
wherein, in Formula A30-1,
   X₃₀ and X₃₁ may respectively be as described herein,
   R₃₁ to R₃₆ may each be as described in connection with R₃₀,
   two or more of R₃₁ to R₃₆ are optionally linked together to form a substituted or unsubstituted C₅-C₃₀ carbocyclic group or a substituted or unsubstituted C₁-C₃₀ heterocyclic group,
   * indicates a binding site to M₁ in Formula 1,
   *' indicates a binding site to T₂ in Formula 1, and
   *" indicates a binding site to T₁ in Formula 1.

For example, X₃₁ in Formula A30-1 may be a single bond.

In one or more embodiments, ring A₄₀ in Formula 1 may be represented by one of Formulae A40(1) to A40(34): 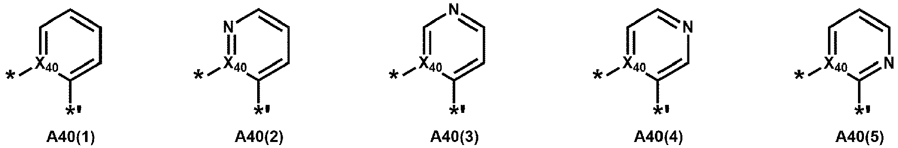 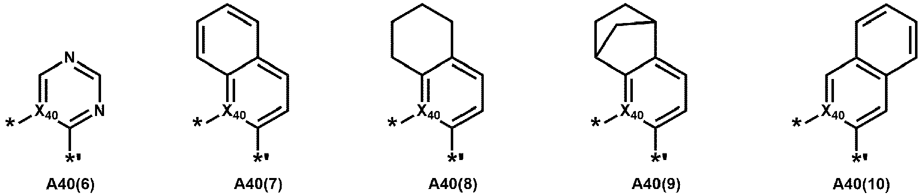 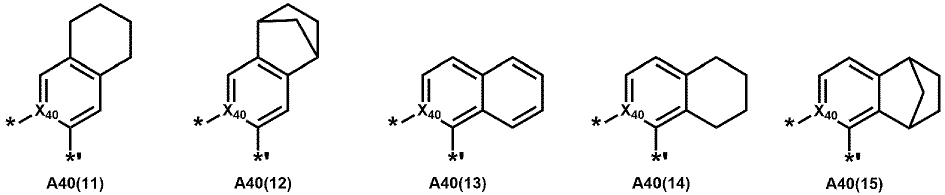 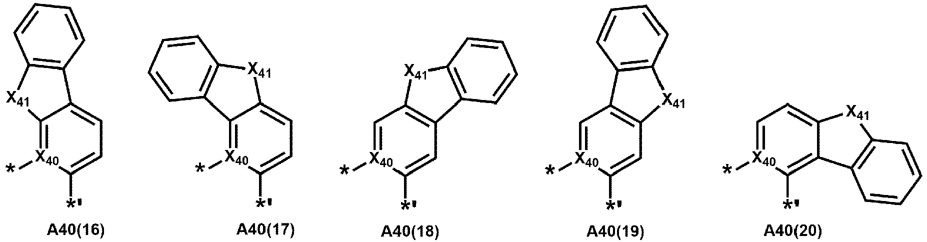 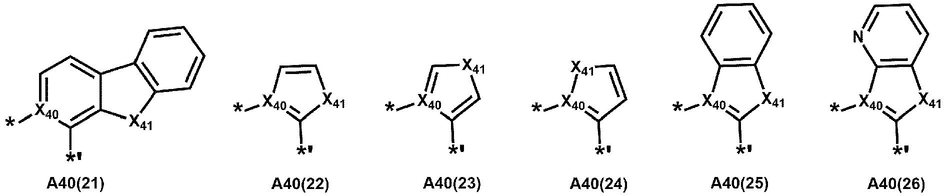 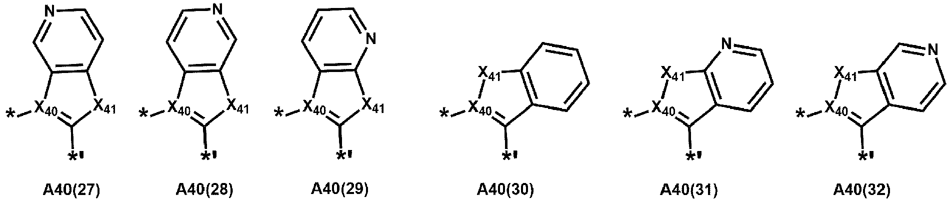 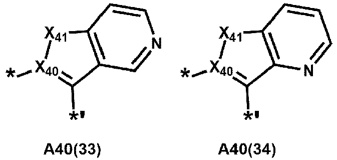 wherein, in Formulae A40(1) to A40(34),
X₄₀ may be C or N,
X₄₁ may be a single bond, O, S, N(R₄₇), C(R₄₇)(R₄₈), or Si(R₄₇)(R₄₈), wherein R₄₇ and R₄₈ may each be as described in connection with R₄₀,
* indicates a binding site to M₁ in Formula 1, and
*' indicates a binding site to T₂ in Formula 1.

In Formula 1, T₁ and T₂ are each independently a single bond, *-N(R₅₁)-*', *-B(R₅₁)-*', *-P(R₅₁)-*', *-C(R₅₁)(R₅₂)-*', *-Si(R₅₁)(R₅₂)-*', *-Ge(R₅₁)(R₅₂)-*', *-S-*', *-Se-*', *-O-*', *-C(=O)-*', *-S(=O)-*', *-S(=O)₂-*', *-C(R₅₁)=C(R₅₂)-*', *-C(=S)-*', or *-C=C-*'.

In Formula 1, R₁₀ to R₁₂, R_{10A}, R₂₀, R₃₀, R₄₀, R₅₁, and R₅₂ are each independently be a group represented by Formula 2, hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), -P(Q₈)(Q₉), or -P(=O)(Q₈)(Q₉), and
in Formula 1,
two or more of a plurality of R₁₀(s) are optionally linked together to form a substituted or unsubstituted C₅-C₃₀ carbocyclic group or a substituted or unsubstituted C₁-C₃₀ heterocyclic group,
two or more of a plurality of R₂₀(s) are optionally linked together to form a substituted or unsubstituted C₅-C₃₀ carbocyclic group or a substituted or unsubstituted C₁-C₃₀ heterocyclic group,
two or more of a plurality of R₃₀(s) are optionally linked together to form a substituted or unsubstituted C₅-C₃₀ carbocyclic group or a substituted or unsubstituted C₁-C₃₀ heterocyclic group,
two or more of a plurality of R₄₀(s) are optionally linked together to form a substituted or unsubstituted C₅-C₃₀ carbocyclic group or a substituted or unsubstituted C₁-C₃₀ heterocyclic group,
neighboring two or more of R₁₀, R_{10A}, R₂₀, R₃₀, R₄₀, R₅₁, and R₅₂ may optionally be linked together to form a substituted or unsubstituted C₅-C₃₀ carbocyclic group or a substituted or unsubstituted C₁-C₃₀ heterocyclic group, and

In one or more embodiments, R₁₀ to R₁₂, R_{10A}, R₂₀, R₃₀, R₄₀, R₅₁, and R₅₂ may each independently be:
a group represented by Formula 2, hydrogen, deuterium, -F, -Cl, -Br, -I, - SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₂₀ alkyl group, a C₁-C₂₀ alkoxy group, or a C₁-C₆₀ alkylthio group, each unsubstituted or substituted with at least one of deuterium, -F, -Cl, -Br, -I, - SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, -Si(Q₃₃)(Q₃₄)(Q₃₅), or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a furanyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a benzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a furanyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a benzocarbazolyl group, an imidazopyridinyl group, an imidazopyrimidinyl group, an azacarbazolyl group, an azadibenzofuranyl group, an azadibenzothiophenyl group, -Si(Q₃₃)(Q₃₄)(Q₃₅), or a combination thereof; or
-Si(Q₃)(Q₄)(Q₅), and
Q₃ to Q₅ and Q₃₃ to Q₃₅ may each independently be a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, -F, a C₁-C₁₀ alkyl group, a phenyl group, or a combination thereof.

In Formula 1, b10, b20, b30, and b40 each indicate the number of R₁₀(s), the number of R₂₀(s), the number of R₃₀(s), and the number of R₄₀(s), respectively, and are each independently an integer from 1 to 10.

In Formula 1, at least one of R₁₀, R₁₁, R₁₂, R₂₀, R₃₀, or R₄₀ is a group represented by Formula 2: 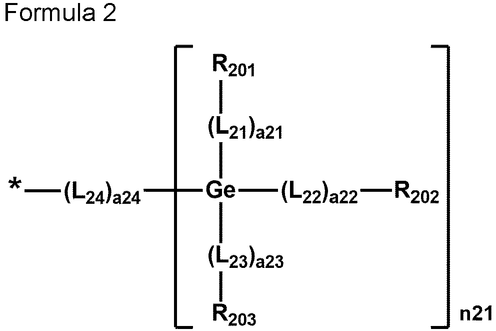
wherein, in Formula 2,
L₂₁ to L₂₄ are each independently a substituted or unsubstituted C₅-C₆₀ carbocyclic group or a substituted or unsubstituted C₁-C₆₀ heterocyclic group.

In one or more embodiments, L₂₁ to L₂₄ in Formula 2 may each independently be:
a benzene group, a naphthalene group, an anthracene group, a phenanthrene group, a triphenylene group, a pyrene group, a chrysene group, a cyclopentadiene group, a 1,2,3,4-tetrahydronaphthalene group, a pyrrole group, a thiophene group, a furan group, an indole group, an indene group, a benzothiophene group, a benzofuran group, a carbazole group, a fluorene group, a dibenzothiophene group, or a dibenzofuran group, each unsubstituted or substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a furanyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a benzocarbazolyl group, an imidazopyridinyl group, an imidazopyrimidinyl group, an azacarbazolyl group, an azadibenzofuranyl group, an azadibenzothiophenyl group, -Si(Q₃₃)(Q₃₄)(Q₃₅), or a combination thereof, and
Q₃₃ to Q₃₅ may each independently be a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, -F, a C₁-C₁₀ alkyl group, a phenyl group, or a combination thereof.

In one or more embodiments, L₂₁ to L₂₄ in Formula 2 may each independently be:
a benzene group, a naphthalene group, a carbazole group, a fluorene group, a dibenzothiophene group, or a dibenzofuran group, each unsubstituted or substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a cyclopentyl group, a cyclohexyl group, a phenyl group, a biphenyl group, a terphenyl group, a naphthyl group, a carbazolyl group, a fluorenyl group, a dibenzofuranyl group, a dibenzothiophenyl group, or a combination thereof.

In Formula 2, a21 to a24 re each independently an integer from 0 to 3.

In one or more embodiments, in Formula 1, a21 to a24 may each independently be 0 or 1. In one or more embodiments, in Formula 2, a21 to a23 may each independently be 0, and a24 may be 0 or 1.

In one or more embodiments, in Formula 2, R₂₀₁ to R₂₀₃ may each independently be a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

In one or more embodiments, in Formula 2, R₂₀₁ to R₂₀₃ may each independently be:
a C₁-C₂₀ alkyl group unsubstituted or substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkoxy group, a C₁-C₁₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, -Si(Q₃₃)(Q₃₄)(Q₃₅), or a combination thereof; or
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a furanyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a benzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a furanyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a benzocarbazolyl group, an imidazopyridinyl group, an imidazopyrimidinyl group, an azacarbazolyl group, an azadibenzofuranyl group, an azadibenzothiophenyl group, -Si(Q₃₃)(Q₃₄)(Q₃₅), or a combination thereof; and
Q₃₃ to Q₃₅ may each independently be a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, -F, a C₁-C₁₀ alkyl group, a phenyl group, or a combination thereof.

In one or more embodiments, in Formula 2, R₂₀₁ to R₂₀₃ may each independently be:
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof; or
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, or a pyrimidinyl group, each unsubstituted or substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof.

In Formula 2 n21 is an integer from 1 to 5.

For example, in one or more embodiments, in Formula 2, n21 may be 1 or 2.

In one or more embodiments, a compound represented by Formula 2 may be represented by Formula 2(1): 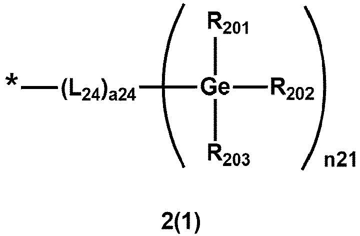 wherein, in Formula 2(1),
L₂₄, R₂₀₁ to R₂₀₃, and n21 may respectively be as described herein,
a24 may be 0 or 1, and
* indicates a binding site to a neighboring atom.

For example, in Formula 2(1), L₂₄ may be a benzene group, a naphthalene group, a carbazole group, a fluorene group, a dibenzothiophene group, or a dibenzofuran group, each substituted or unsubstituted deuterium, -F, -Cl, -Br, -I, -SF₅, -CD₃, -CD₂H, -CDH₂, - CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a cyclopentyl group, a cyclohexyl group, a phenyl group, a biphenyl group, a terphenyl group, a naphthyl group, a carbazolyl group, a fluorenyl group, a dibenzofuranyl group, a dibenzothiophenyl group, or a combination thereof.

In one or more embodiments, a group represented by Formula 2 may be a group represented by one of Formulae 2-1 to 2-4: 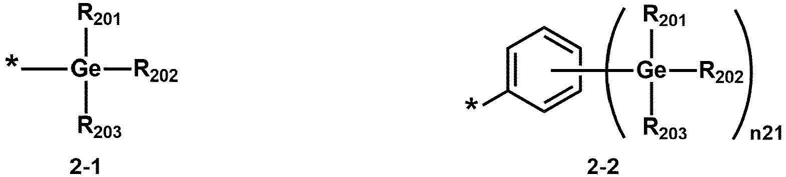 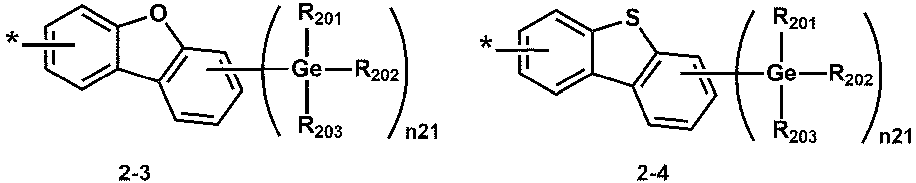 wherein, in Formulae 2-1 to 2-4,
R₂₀₁ to R₂₀₃ and n21 may respectively be as described herein, and
* indicates a binding site to a neighboring atom.

In one or more embodiments, in Formulae 2-1 to 2-4, R₂₀₁ to R₂₀₃ may each independently be:
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof; or
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, or a pyrimidinyl group, each unsubstituted or substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof.

In one or more embodiments, n21 in Formula 2-2 may be 1 or 2, and n21 in Formulae 2-3 and 2-4 may be 1.

In one or more embodiments, each group represented by Formula 2 independently may be a group represented by one of Formulae 2-101 to 2-134: 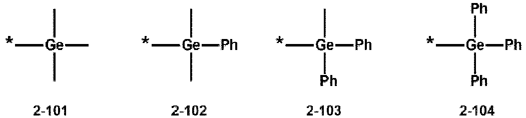 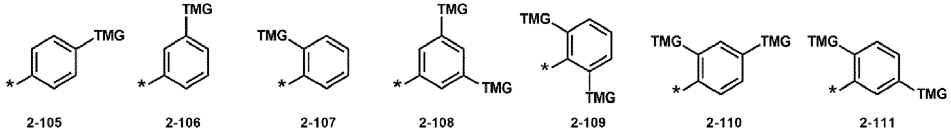 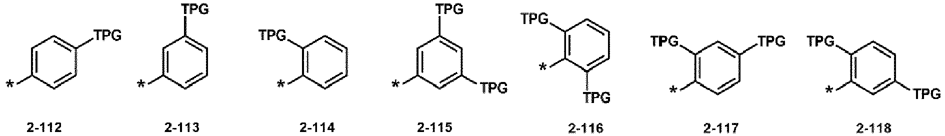 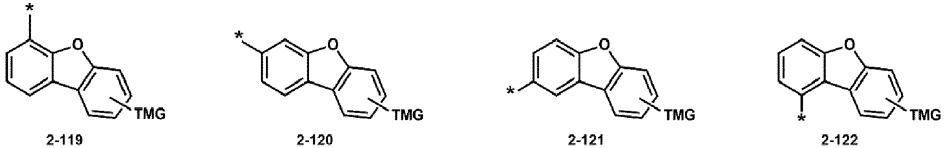 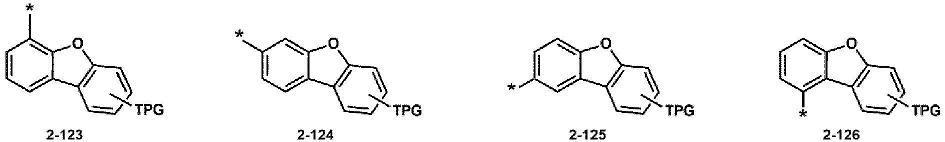 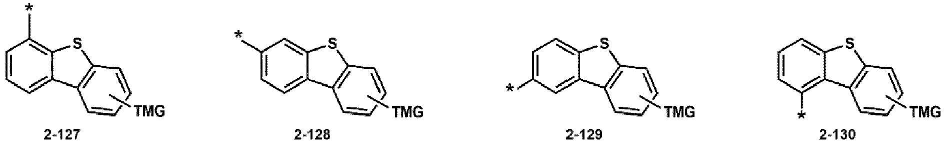 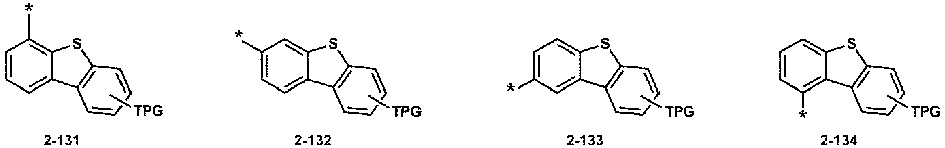 wherein, in Formulae 2-101 to 2-134,
TMG is a trimethyl-germyl group,
TPG is a triphenyl-germyl group, and
* indicates a binding site to a neighboring atom.

In one or more embodiments, in Formula 1, one of R₁₀, R₁₁, R₁₂, R₂₀, R₃₀, and R₄₀ may be a group represented by Formula 2.

In one or more embodiments, the organometallic compound may be represented by one or more of Formulae 1A to 1D: 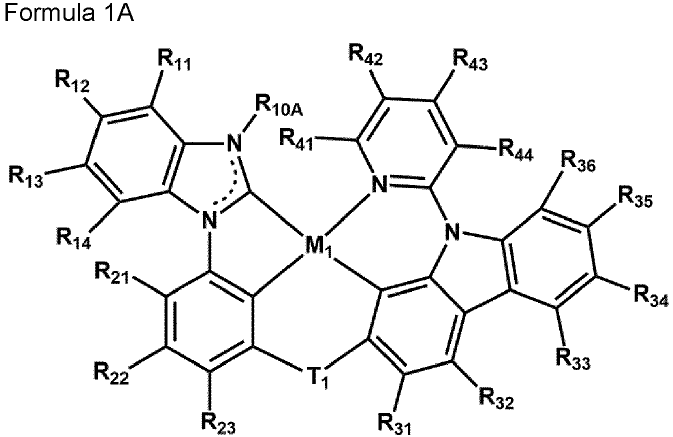 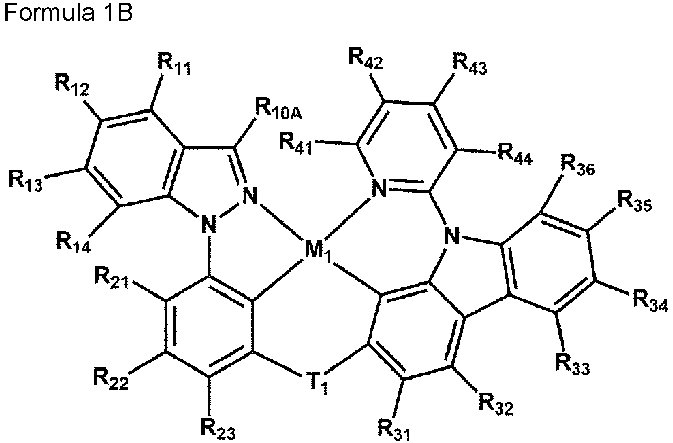 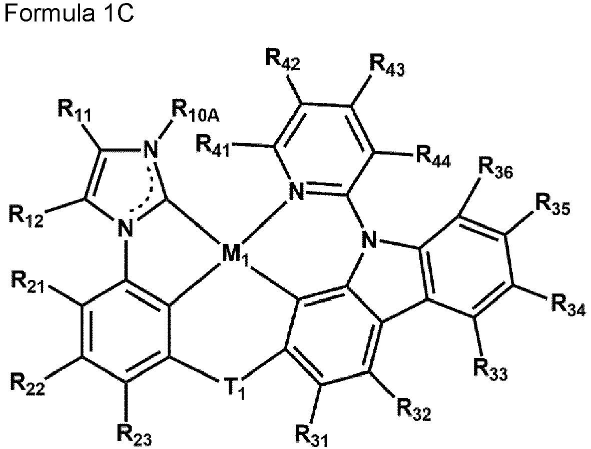 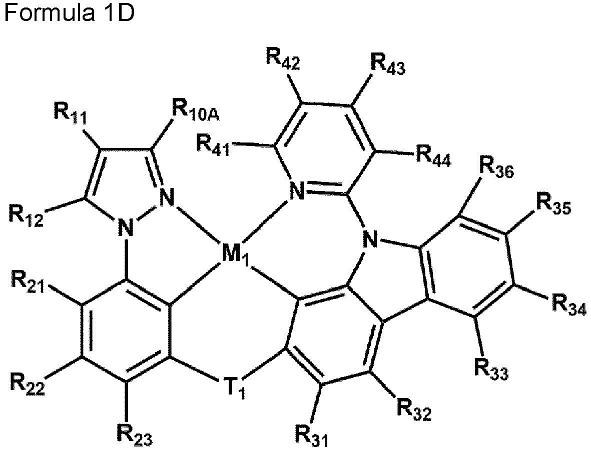 wherein, in Formulae 1A to 1D,
M₁, T₁, R_{10A}, R₁₁, and R₁₂ may respectively be as described herein,
R₁₃ and R₁₄ may each be as described in connection with R₁₀,
R₂₁ to R₂₃ may each be as described in connection with R₂₀,
R₃₁ to R₃₆ may each be as described in connection with R₃₀,
R₄₁ to R₄₄ may each be as described in connection with R₄₀, and
at least one of R₁₁ to R₁₄, R₂₁ to R₂₃, R₃₁ to R₃₆, and R₄₁ to R₄₄ in Formulae 1A and 1B is a group represented by Formula 2, and
at least one of R₁₁, R₁₂, R₂₁ to R₂₃, R₃₁ to R₃₆, and R₄₁ to R₄₄ in Formulae 1C and 1D is a group represented by Formula 2.

In the present specification, as used herein, at least one substituent of the substituted C₅-C₆₀ carbocyclic group, the substituted C₁-C₆₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may be:
deuterium, -F, -Cl, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each unsubstituted or substituted with at least one of deuterium, -F, -Cl, -Br, -I, -SF₅, -CD₃, -CD₂H, -CDH₂, -CF₃, - CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(O₁₁)(O₁₂), - Si(Q₁₃)(Q₁₄)(Q₁₅), -B(Q₁₆)(Q₁₇), -P(Q₁₈)(Q₁₉), -P(=O)(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, -SF₅, - CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -B(Q₂₆)(Q₂₇), -P(Q₂₈)(Q₂₉), -P(=O)(Q₂₈)(Q₂₉), or a combination thereof;
-N(Q₃₁)(Q₃₂), -Si(Q₃₃)(Q₃₄)(Q₃₅), -B(Q₃₆)(Q₃₇), -P(Q₃₈)(Q₃₉), or - P(=O)(Q38)(Q39); or
a combination thereof, and
Q₁ to Q₉, Q₁₁ to Q₁₉, Q₂₁ to Q₂₉, and Q₃₁ to Q₃₉ may each independently be: hydrogen, deuterium, -F, -Cl, -Br, -I, -SF₅, a hydroxyl group, a cyano group, a nitro group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each of which is unsubstituted or substituted with at least one of deuterium, a C₁-C₆₀ alkyl group, a C₆-C₆₀ aryl group, or a combination thereof, .

In the present specification, as used herein, * and *' each indicate a binding site to a neighboring atom.

In one or more embodiments, the organometallic compound may be one or more of Compounds 1 to 218: 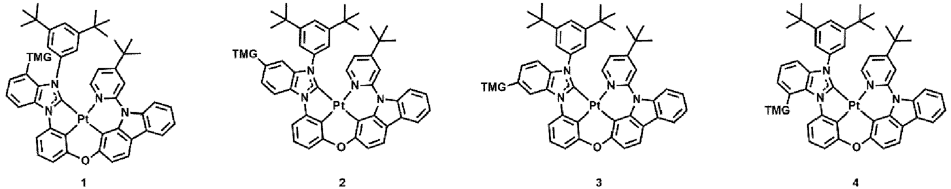 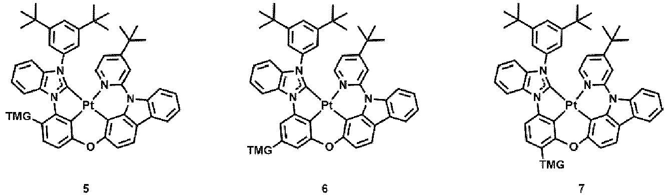 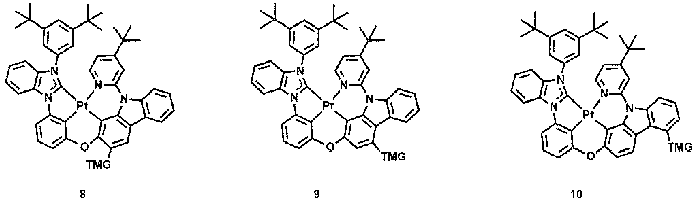 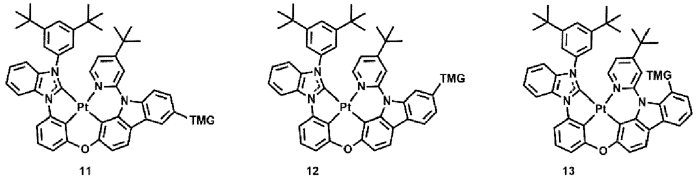 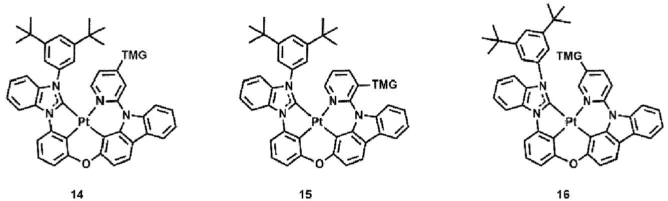 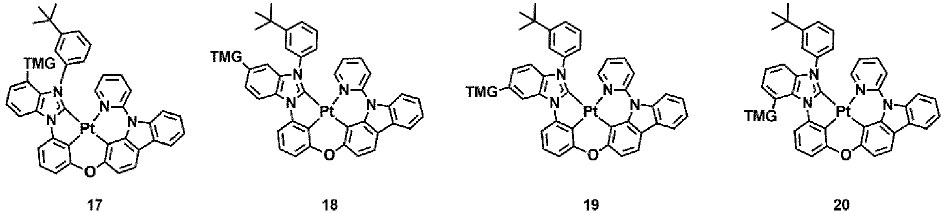 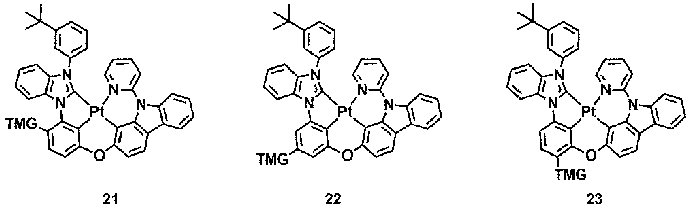 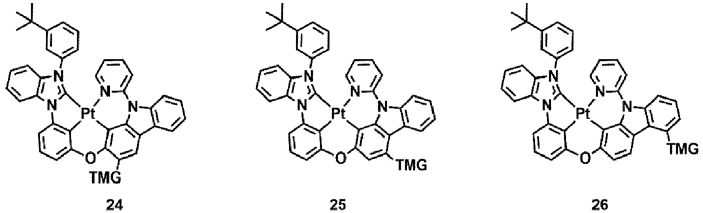 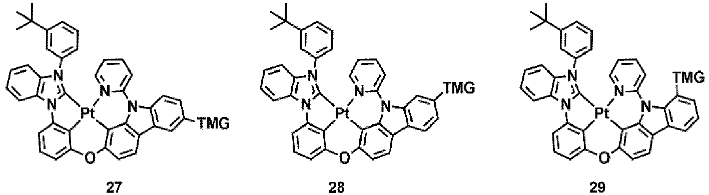 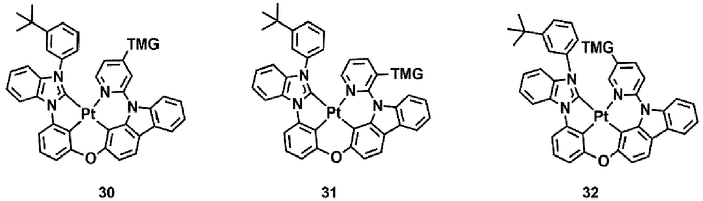 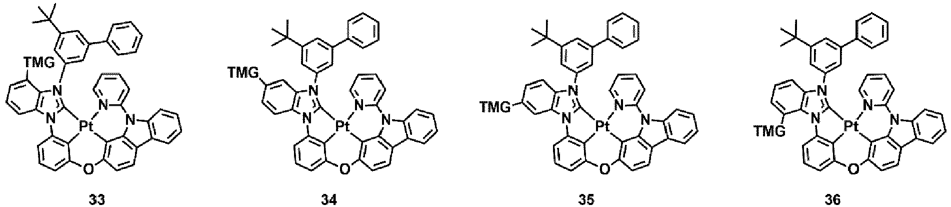 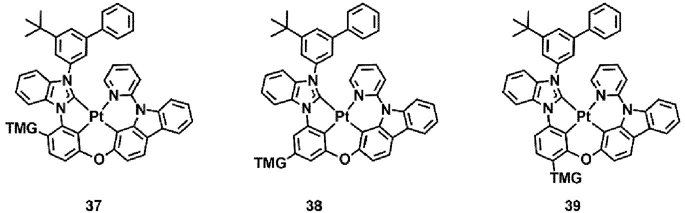 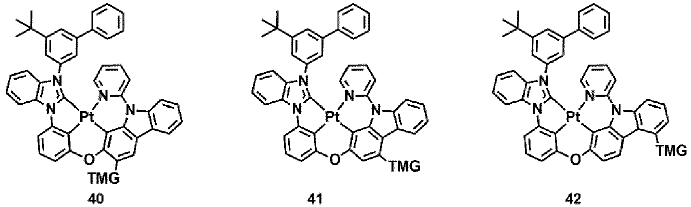 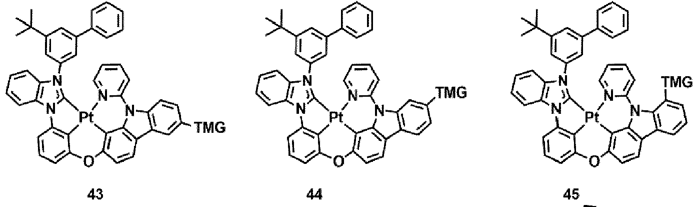 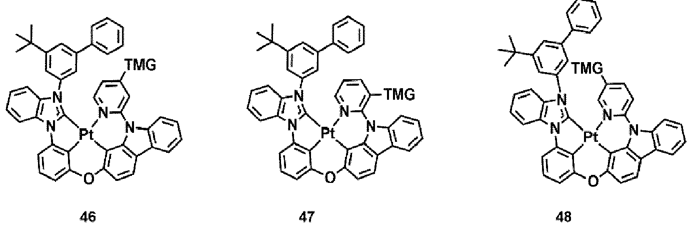 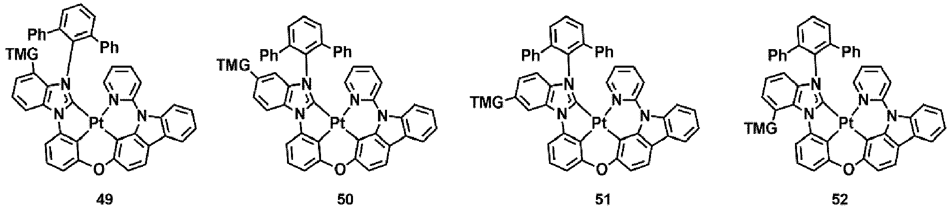 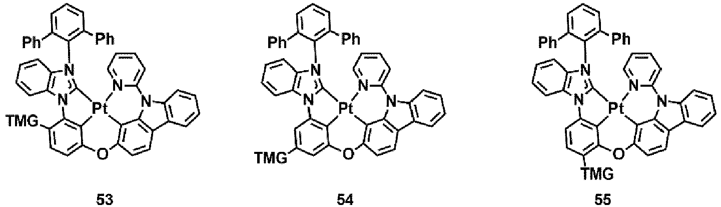 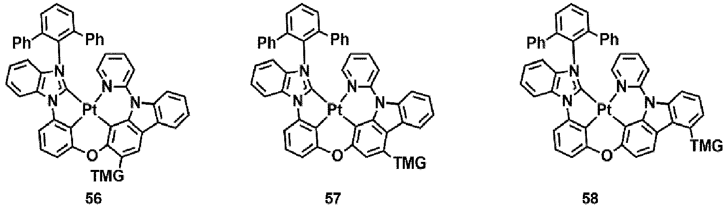 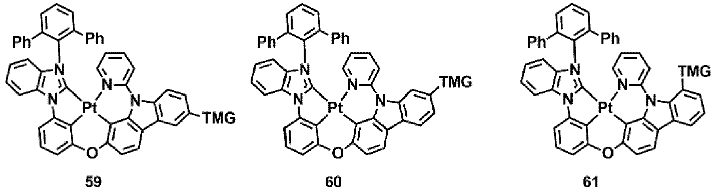 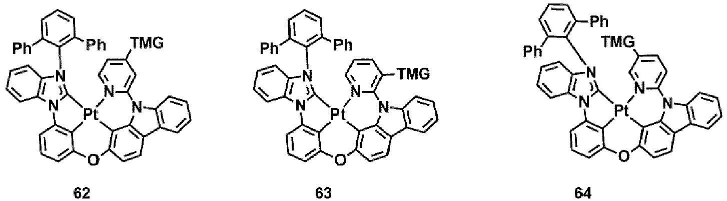 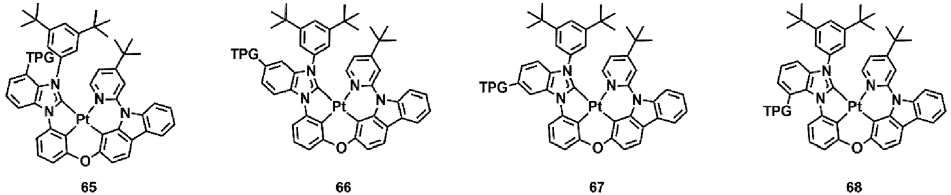 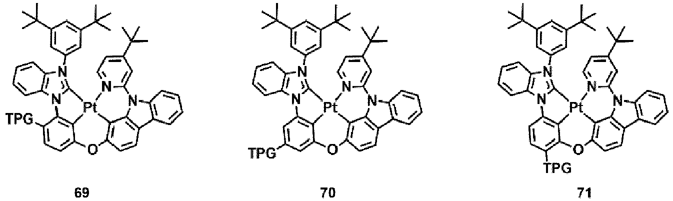 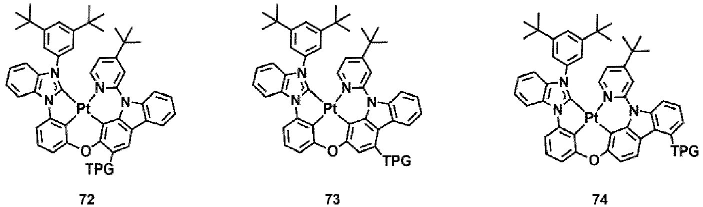 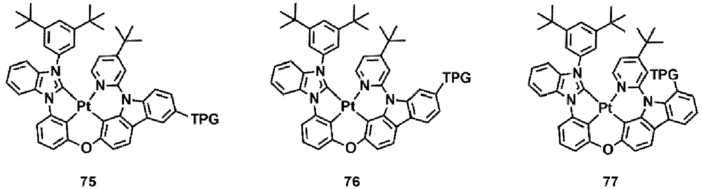 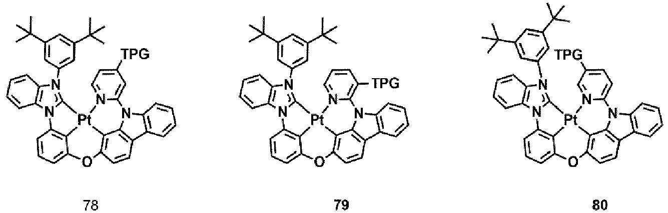 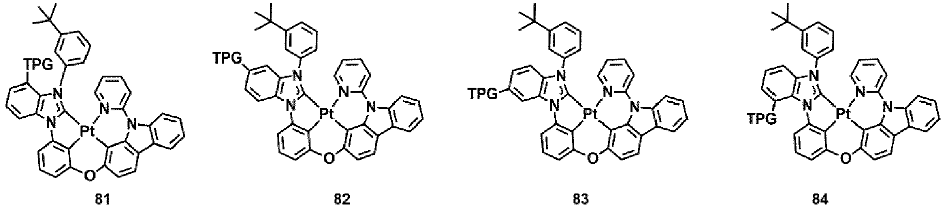 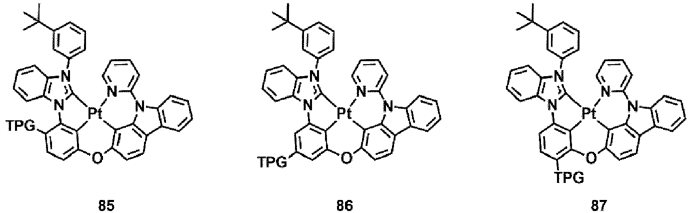 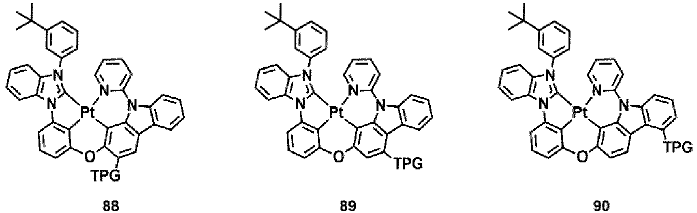 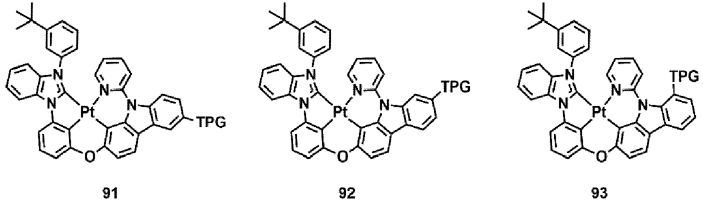 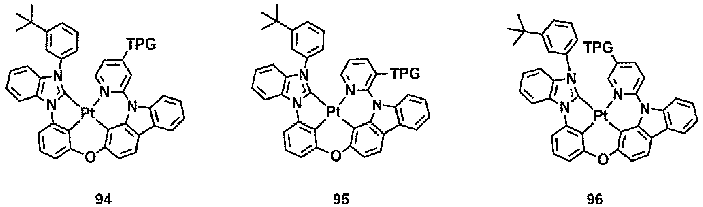 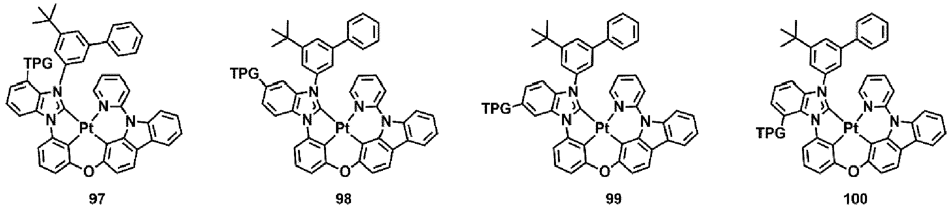 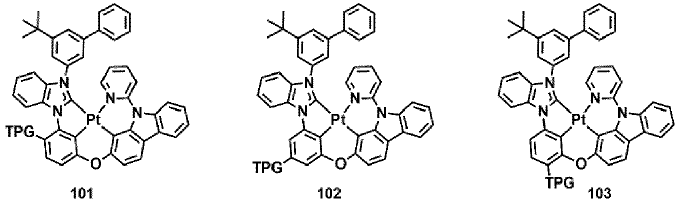 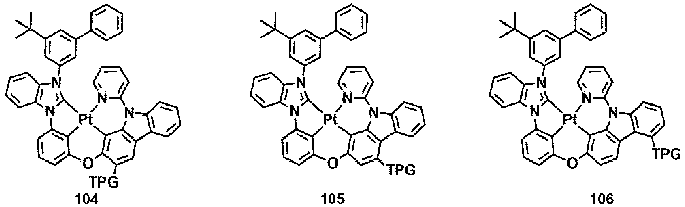 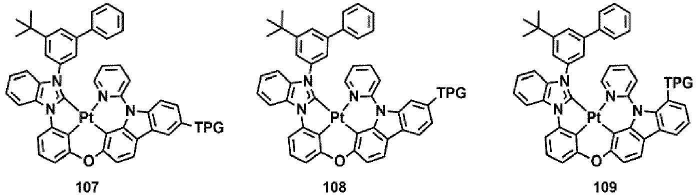 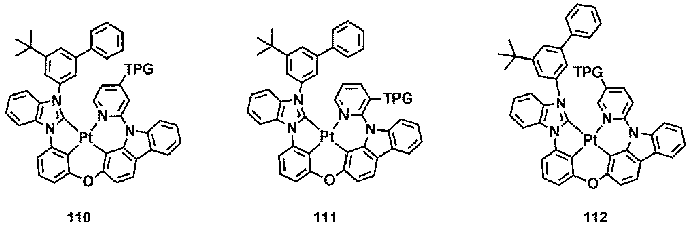 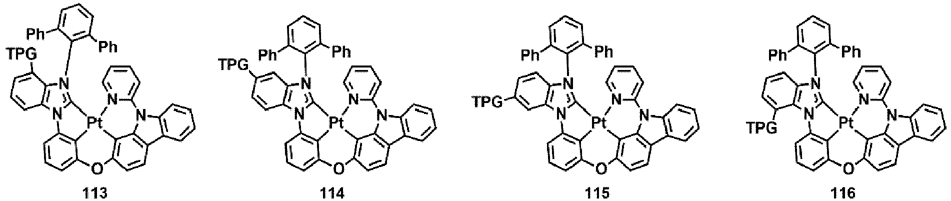 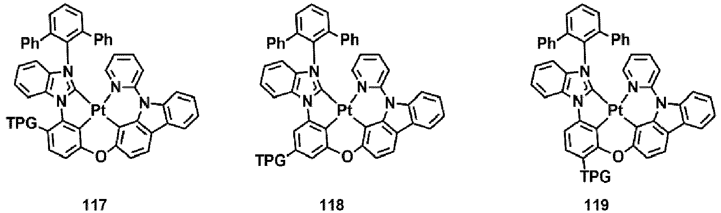 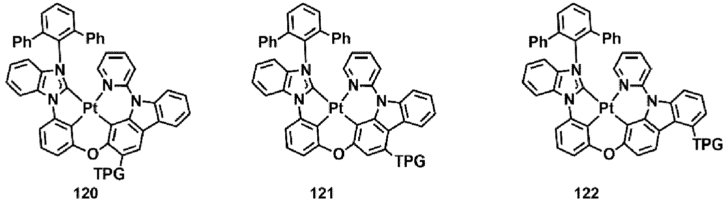 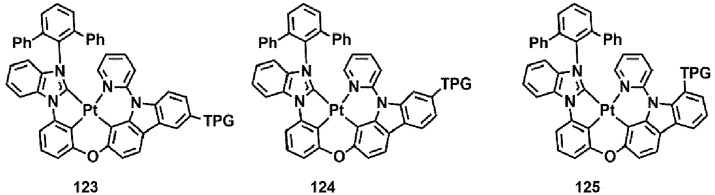 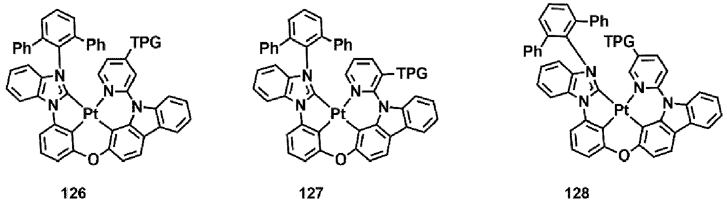 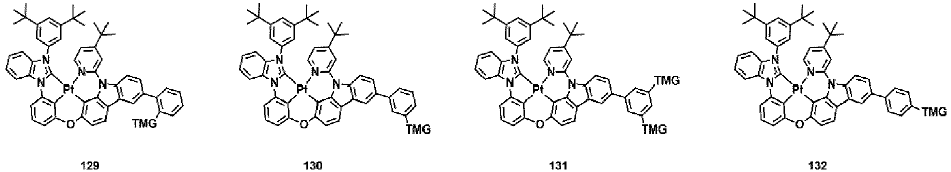 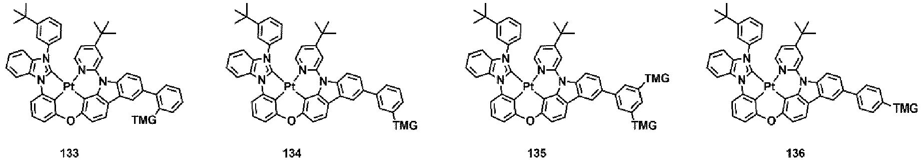 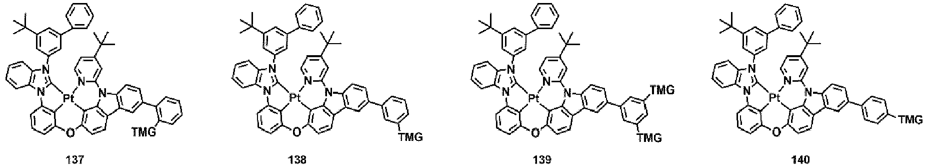 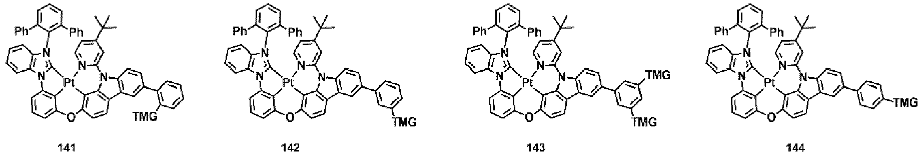 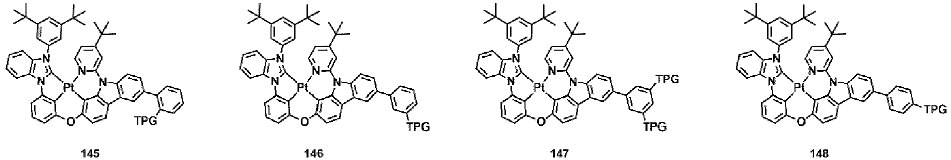 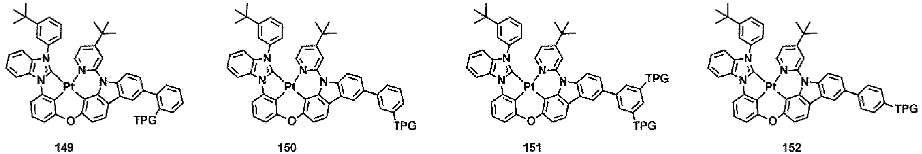 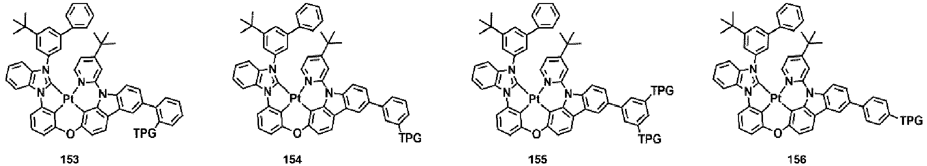 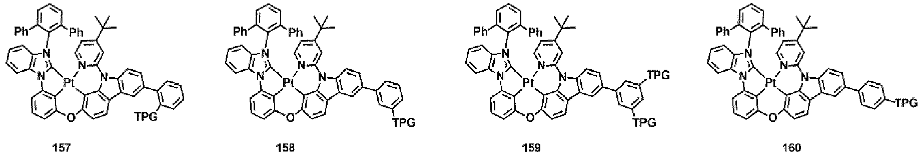 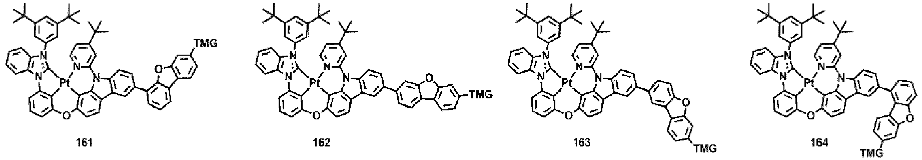 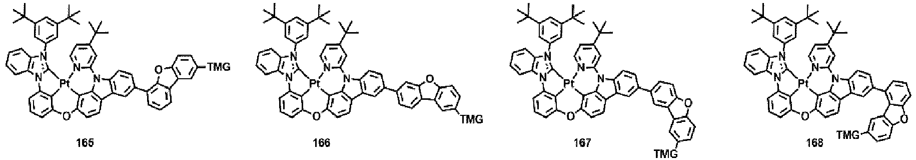 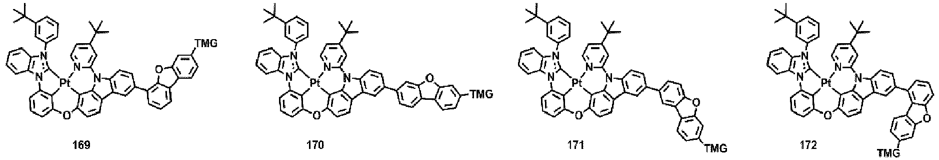 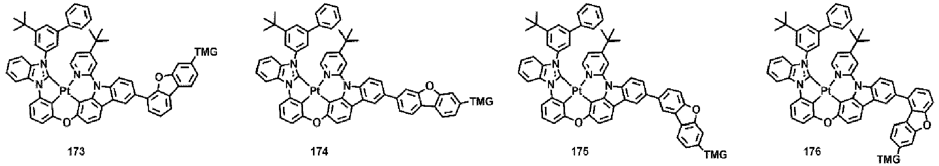 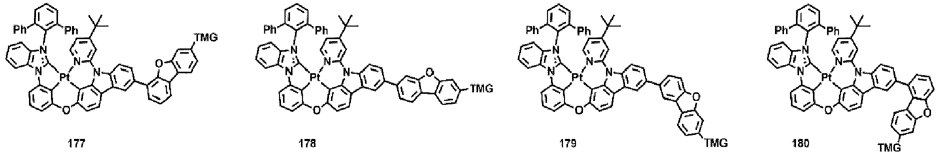 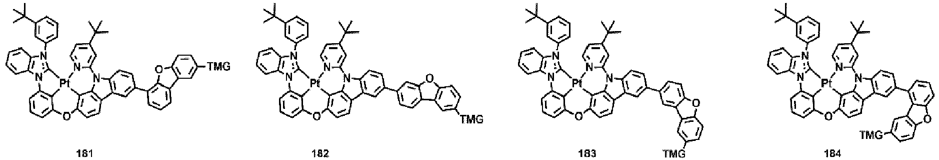 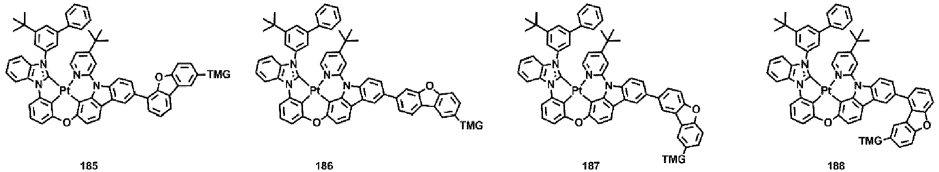 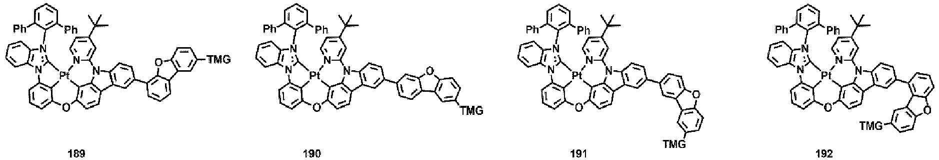 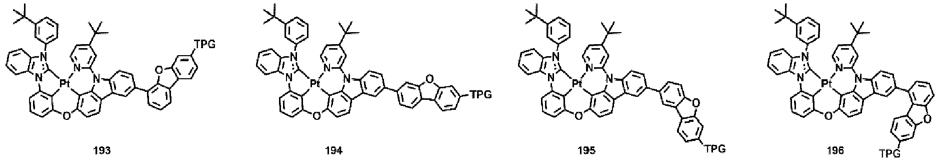 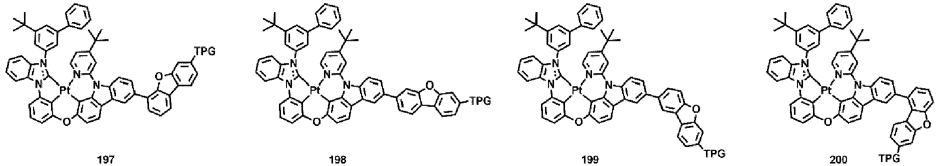 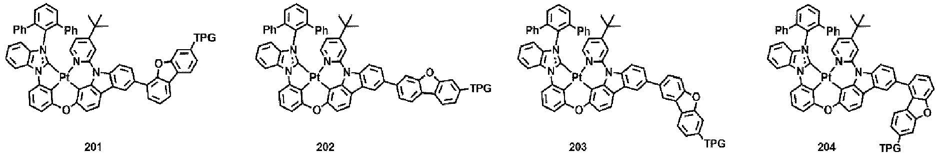 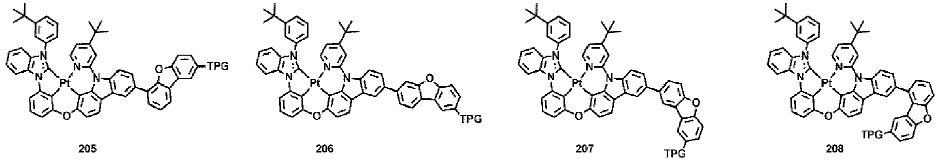 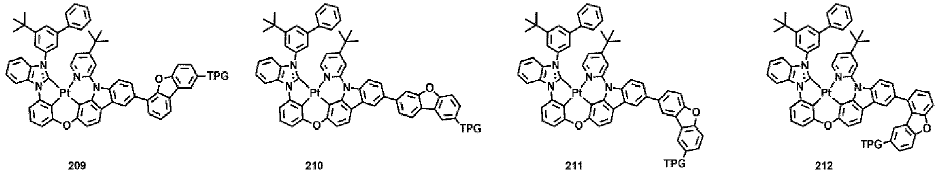 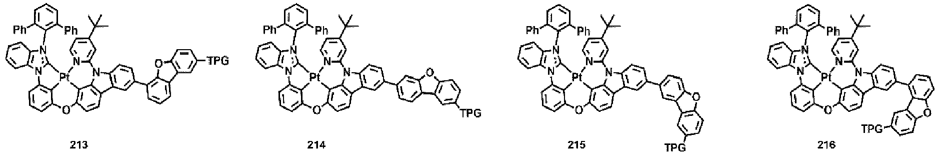 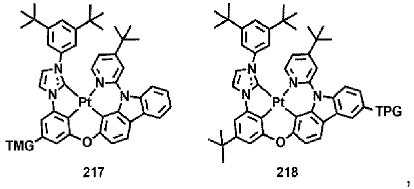 wherein "TMG" is a trimethyl-germyl group, and "TPG" is a triphenyl-germyl group.

The organometallic compound represented by Formula 1 may include, as a ligand substituent, at least one group represented by Formula 2. The organometallic compound may include a group represented by Formula 2 which is a bulky germanium (Ge)-containing substituent so that the emission waveform may be improved. For example, the organometallic compound may exhibit an emission spectrum having a narrow full width at half maximum (FWHM) and a small second peak intensity. Accordingly, an organic light-emitting device including the organometallic compound may have improved color purity.

In one embodiment, the organometallic compound may have an electroluminescence (EL) and/or photoluminescence (PL) spectrum that includes a first peak and a second peak, wherein the maximum emission wavelength of the second peak is greater than the maximum emission wavelength of the first peak, and the intensity of the second peak may be less than the intensity of the first peak.

In addition, when the organometallic compound represented by Formula 1 includes a bulky Ge-containing substituent and is used as an emitter of an emission layer, the formation of exciplex with a host molecule may be suppressed. Accordingly, a decrease in efficiency of an organic light-emitting device including the organometallic compound may be substantially suppressed, and thus high luminescence efficiency may be achieved.

The highest occupied molecular orbital (HOMO) energy level (electron Volts, eV), lowest unoccupied molecular orbital (LUMO) energy level (eV), lowest triplet (T₁) energy level (eV), and FWHM (nm) of select organometallic compound represented by Formula 1 were evaluated by density functional theory (DFT) using the Gaussian 09 program with the molecular structure optimization obtained at the B3LYP-basis level, and results thereof are shown in Table 1.

**Table 1**

| Compound No. | HOMO (eV) | LUMO (eV) | T₁ (eV) | FWHM (nm) |
|---|---|---|---|---|
| 12 | -4.65 | -1.21 | 2.65 | 31 |
| 75 | -4.67 | -1.22 | 2.66 | 31 |
| 76 | -4.67 | -1.19 | 2.65 | 31 |
| 130 | -4.67 | -1.23 | 2.66 | 30 |
| 132 | -4.67 | -1.23 | 2.66 | 29 |
| 146 | -4.67 | -1.23 | 2.66 | 30 |
| 148 | -4.69 | -1.25 | 2.66 | 29 |
| 161 | -4.66 | -1.23 | 2.66 | 29 |
| 217 | -4.59 | -1.10 | 2.72 | 30 |
| 218 | -4.58 | -1.11 | 2.71 | 32 |
| C1 | -4.65 | -1.22 | 2.65 | 32 |
| C3 | -4.59 | -1.12 | 2.72 | 32 |
| C4 | -4.63 | -1.16 | 2.66 | 49 |
| C5 | -4.55 | -1.10 | 2.71 | 34 |

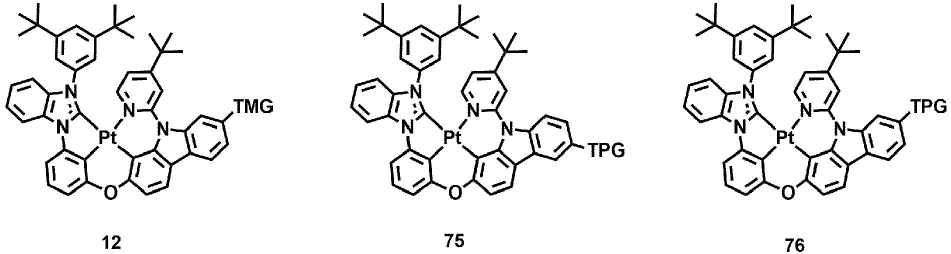

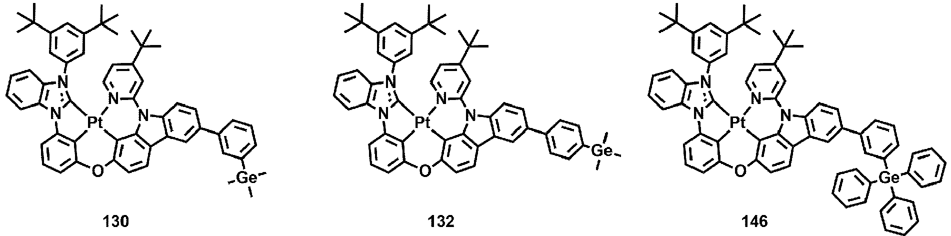

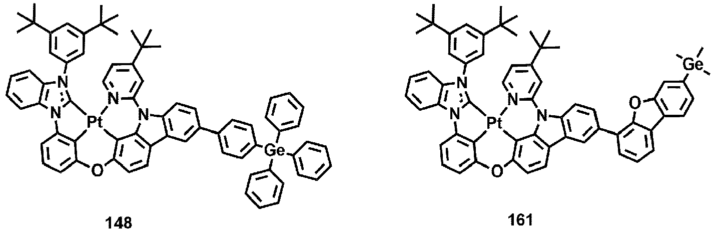

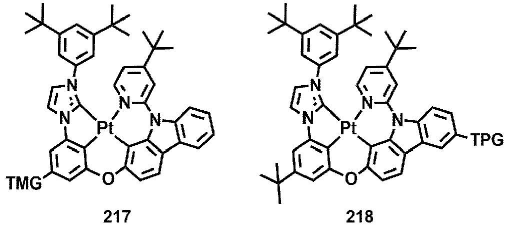

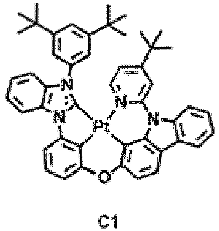

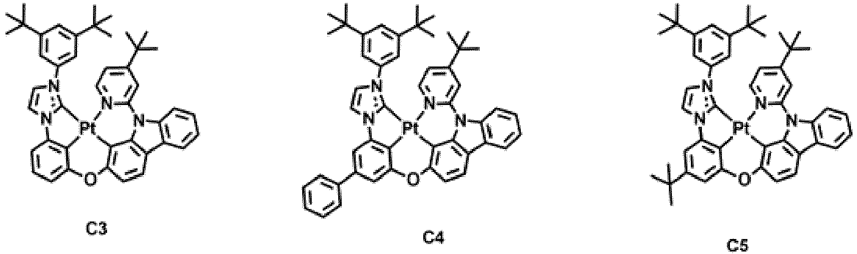

wherein "TMG" is a trimethyl-germyl group, and "TPG" is a triphenyl-germyl group.

Referring to Table 1, it was confirmed that, as a result of molecular simulation, the organometallic compound according to one or more embodiments exhibits a relatively narrow FWHM compared to Comparative Compounds C1 to C5.

Synthesis methods of the organometallic compound represented by Formula 1 may be recognizable by one of ordinary skill in the art by referring to Synthesis Examples described below.

Accordingly, the organometallic compound represented by Formula 1 may be suitable for use as a material for an organic layer of an organic light-emitting device, for example, a material for an emission layer of the organic layer. Thus, another aspect of the present disclosure provides an organic light-emitting device including: a first electrode; a second electrode; and an organic layer arranged between the first electrode and the second electrode and including an emission layer, wherein the organic layer includes at least one organometallic compound represented by Formula 1.

The organic light-emitting device may have, due to the inclusion of the organic layer including the organometallic compound represented by Formula 1, excellent external quantum efficiency, an emission waveform with a reduced second peak intensity, and excellent color purity.

The expression "(an organic layer) includes at least one organometallic compound represented by Formula 1" as used herein may include a case in which "(an organic layer) includes identical organometallic compounds represented by Formula 1" and a case in which "(an organic layer) includes two or more different organometallic compounds represented by Formula 1".

In one or more embodiments, the organic layer may include, as the organometallic compound, only Compound 1. In this regard, Compound 1 may be included in the emission layer of the organic light-emitting device. In one or more embodiments, the organic layer may include, as the organometallic compound, Compound 1 and Compound 2. In this regard, Compound 1 and Compound 2 may exist in an identical layer (for example, Compound 1 and Compound 2 may all exist in the emission layer).

In one or more embodiments, the at least one organometallic compound may be included in the emission layer of the organic light-emitting device.

For example, the emission layer may further include a host, and an amount of the host in the emission layer may be greater than that of the at least one organometallic compound in the emission layer.

The emission layer may emit red light, green light, or blue light. For example, the emission layer may emit blue light having a maximum emission wavelength of 410 nm to 490 nm.

For example, the emission layer may have a configuration as described in First exemplary configuration or the second exemplary configuration, but embodiments are not limited thereto.

### First exemplary configuration

The emission layer may include the organometallic compound represented by Formula 1, and the organometallic compound represented by Formula 1 may serve as a phosphorescent emitter. For example, a ratio of a luminescent component emitted from the organometallic compound with respect to all luminescent components of the emission layer may be 80 % or greater, or about 85 % or greater, or about 90 % or greater, or about 95 % or greater.

In one or more embodiments, light emitted from the organometallic compound may be blue light.

### Second exemplary configuration

The emission layer may include, in addition to the organometallic compound represented by Formula 1, a phosphorescent dopant, a fluorescent dopant, or a combination thereof, which is different from the organometallic compound. In this regard, the organometallic compound may serve not as a phosphorescent emitter, but as a sensitizer or an auxiliary dopant. For example, the emission layer may further include a fluorescent dopant, and the fluorescent dopant may be different from the organometallic compound. The ratio of a luminescent component emitted from the fluorescent dopant with respect to all luminescent components of the emission layer may be 80 % or greater, or about 85 % or greater, or about 90 % or greater, or about 95 % or greater.

In the second embodiment, an amount of the fluorescent dopant may be, based on 100 parts by weight of the organometallic compound represented by Formula 1, in a range of about 1 part by weight to about 100 parts by weight, or about 5 parts by weight to about 50 parts by weight, or about 10 parts by weight to about 20 parts by weight.

In the second embodiment, a total amount of the organometallic compound represented by Formula 1 and the fluorescent dopant may be, based on 100 parts by weight of the emission layer, in a range of about 1 part by weight to 30 parts by weight, or about 3 parts by weight to about 20 parts by weight, or about 5 parts by weight to about 15 parts by weight.

The fluorescent dopant that may be used in the second embodiment may not include a transition metal.

In the second embodiment, the emission layer may emit fluorescence generated while triplet excitons of the organometallic compound represented by Formula 1 are delivered to the fluorescent dopant and then transferred.

For example, the fluorescent dopant may include a compound represented by Formula 503-1 or 503-2: 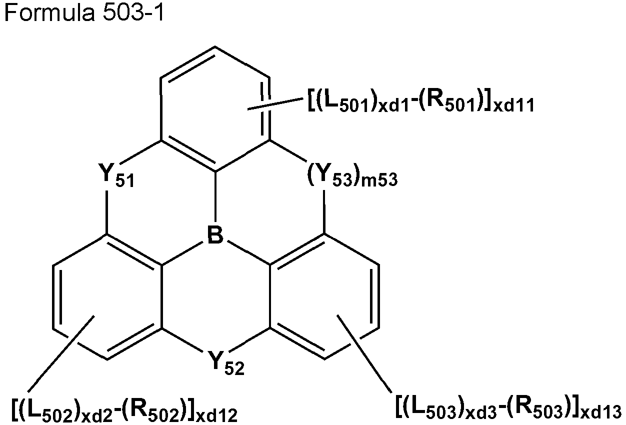 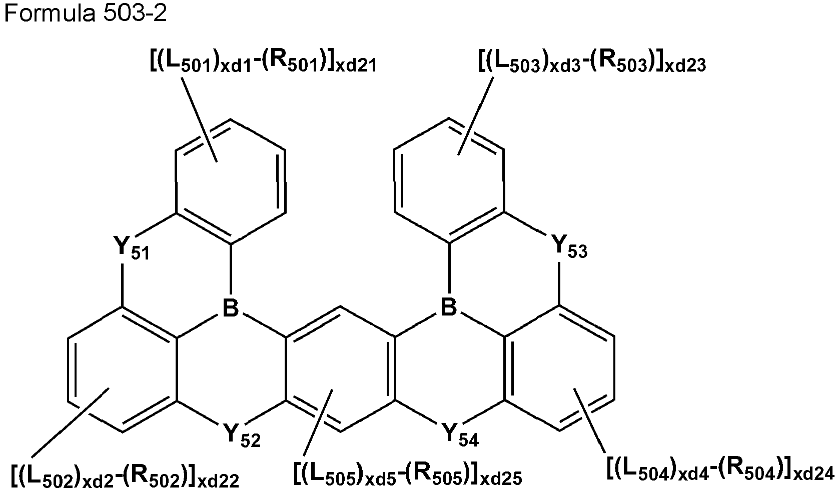 wherein, in Formulae 503-1 and 503-2,
Y₅₁ to Y₅₄ are each independently a single bond, O, S, N[(L₅₀₆)_{xd6}-R₅₀₆], C[(L₅₀₆)_{xd6}-R₅₀₆₁[(L₅₀₇)_{xd7}-R₅₀₇], or Si[(L₅₀₆)_{xd6}-R₅₀₆][(L₅₀₇)_{xd7}-R₅₀₇],
m53 may be 0 or 1,
L₅₀₁ to L₅₀₇ may each independently be a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, or a substituted or unsubstituted divalent non-aromatic condensed heteropolycyclic group,
xd1 to xd7 may each independently be 0, 1, 2, or 3,
R₅₀₁ to R₅₀₇ may each independently be:
   hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, or a dibenzothiophenyl group; or
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, or a combination thereof,
   xd11 and xd13 may each independently be 0, 1, 2, 3, or 4 when m53 is 0,
   xd11 and xd13 may each independently be 0, 1, 2, or 3 when m53 is 1,
   xd21 and xd23 may each independently be 0, 1, 2, 3, or 4,
   xd12, xd22, and xd24 may each independently be 0, 1, 2, or 3,
   xd25 may be 0, 1, or 2, and
   two of R₅₀₁ to R₅₀₇ may optionally be linked to each other to form a saturated ring or an unsaturated ring.

In one or more embodiments, the first electrode may be an anode, which is a hole injection electrode, and the second electrode may be a cathode, which is an electron injection electrode. In one or more embodiments, the first electrode may be a cathode, which is an electron injection electrode, and the second electrode may be an anode, which is a hole injection electrode.

In one or more embodiments, the first electrode may be an anode, the second electrode may be a cathode, and the organic layer may include a hole transport region between the first electrode and the emission layer and an electron transport region between the emission layer and the second electrode, wherein the hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

For example, the organometallic compound may be included in at least one of the hole transport region and the electron transport region.

The term "organic layer" as used herein refers to a single layer and/or a plurality of layers between the first electrode and the second electrode of the organic light-emitting device. The "organic layer" may include, in addition to an organic compound, an organometallic complex including metal.

### Description of FIGURE

The FIGURE is a schematic cross-sectional view of an organic light-emitting device 10 according to one or more embodiments. Hereinafter, the structure and manufacturing method of the organic light-emitting device 10 according to an exemplary embodiment will be described in further detail in connection with the FIGURE.

The organic light-emitting device 10 of the FIGURE includes a first electrode 11, an organic layer 15, and a second electrode 19, which are sequentially stacked.

A substrate may be additionally arranged under the first electrode 11 or above the second electrode 19. For use as the substrate 1, any substrate that is used in organic light-emitting devices of the related art may be used, and for example, a glass substrate or a transparent plastic substrate, each having excellent mechanical strength, thermal stability, transparency, surface smoothness, ease of handling, and water resistance, may be used.

The first electrode 11 may be, for example, formed by depositing or sputtering a material for forming the first electrode 11 on the substrate. The first electrode 11 may be an anode. The material for forming the first electrode 11 may be selected from materials with a high work function to facilitate hole injection.

The first electrode 11 may be a reflective electrode, a semi-transmissive electrode, or a transmissive electrode. In one or more embodiments, the material for forming the first electrode 11 may be indium tin oxide (ITO), indium zinc oxide (IZO), tin oxide (SnO₂), or zinc oxide (ZnO). In one or more embodiments, the material for forming the first electrode 11 may be metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO, but the structure of the first electrode 11 is not limited thereto.

The organic layer 15 is arranged on the first electrode 11.

The organic layer 15 may include a hole transport region, an emission layer, and an electron transport region.

The hole transport region may be arranged between the first electrode 11 and the emission layer.

The hole transport region may include at least one selected from a hole injection layer, a hole transport layer, an electron blocking layer, and a buffer layer.

The hole transport region may include only either a hole injection layer or a hole transport layer. The hole transport region may have a hole injection layer/hole transport layer structure or a hole injection layer/hole transport layer/electron blocking layer structure, wherein constituting layers for each structure are sequentially stacked in this stated order from the first electrode 11.

When the hole transport region includes a hole injection layer, the hole injection layer may be formed on the first electrode 11 by using one or more suitable methods such as vacuum deposition, spin coating, casting, and/or Langmuir-Blodgett (L-B) deposition.

When the hole injection layer is formed by vacuum deposition, the deposition conditions may vary according to a material that is used to form the hole injection layer, and the structure and thermal characteristics of the hole injection layer. For example, the deposition conditions may include a deposition temperature in a range of about 100°C to about 500°C, a vacuum pressure in a range of about 10⁻⁸ torr (1.333×10⁻⁶Pa) to about 10⁻³ torr (0.1333 Pa), and a deposition rate in a range of about 0.01 angstroms per second (Å/sec) to about 100 Å/sec. However, the deposition conditions are not limited thereto.

When the hole injection layer is formed by spin coating, the coating conditions may vary according to a material that is used to form the hole injection layer, and the structure and thermal properties of the hole injection layer. For example, the coating conditions may include a coating speed in a range of about 2,000 revolutions per minute (rpm) to about 5,000 rpm and a heat treatment temperature for removing a solvent after coating in a range of about 80°C to about 200°C. However, the coating conditions are not limited thereto.

Conditions for forming the hole transport layer and the electron blocking layer may be as the conditions for forming the hole injection layer.

The hole transport region may include, for example, at least one of 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(naphthalene-1-yl)-N,N'-diphenyl-benzidine (NPB), β-NPB, N,N'-bis(3-methylphenyl)-N,N'-diphenyl-[1,1-biphenyl]-4,4'-diamine (TPD), spiro-TPD, spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, or a compound represented by Formula 202: 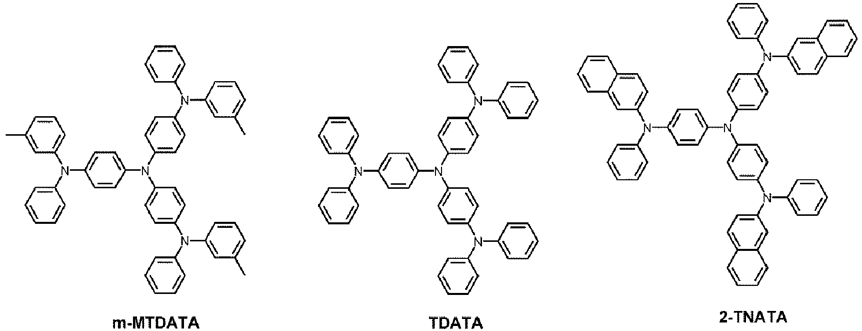 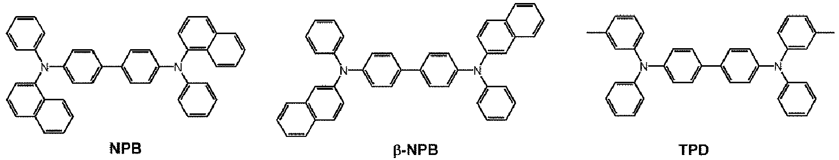 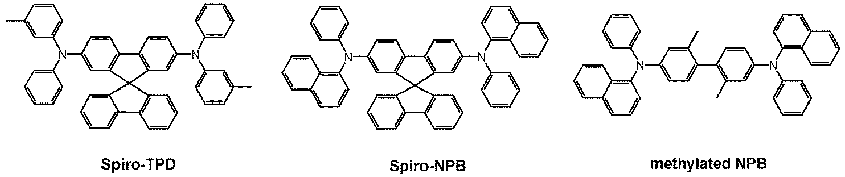 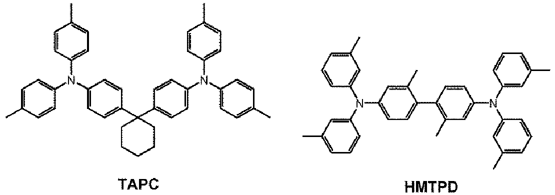 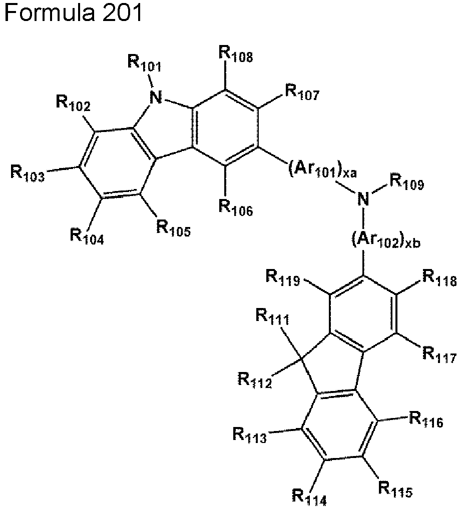 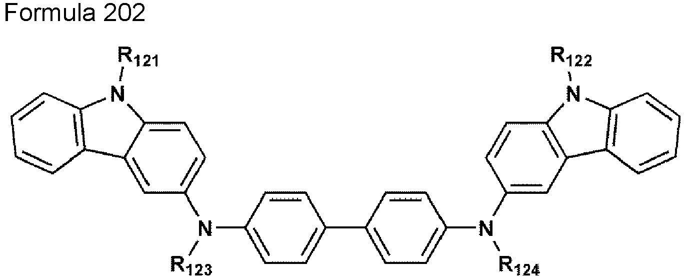 wherein, in Formula 201, Ar₁₀₁ and Ar₁₀₂ may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or a combination thereof.

In Formula 201, xa and xb may each independently be an integer from 0 to 5, or may each independently be 0, 1, or 2. For example, xa may be 1, and xb may be 0, but xa and xb are not limited thereto.

In Formulae 201 and 202, R₁₀₁ to R₁₀₈, R₁₁₁ to R₁₁₉, and R₁₂₁ to R₁₂₄ may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, pentyl group, a hexyl group, or the like) a C₁-C₁₀ alkoxy group (for example, a methoxy group, an ethoxy group, a propoxy group, a butoxy group, a pentoxy group, or the like), or a C₁₋₁₀ alkylthio group;
a C₁-C₁₀ alkyl group, a C₁-C₁₀ alkoxy group, or a C₁₋₁₀ alkylthio group, each unsubstituted or substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof, or a combination thereof; or
a phenyl group, a naphthyl group, an anthracenyl group, a fluorenyl group, or a pyrenyl group, each unsubstituted or substituted with deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁₋₁₀ alkylthio group, or a combination thereof.

In Formula 201, R₁₀₉ may be a phenyl group, a naphthyl group, an anthracenyl group, or a pyridinyl group, each unsubstituted or substituted with deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁₋₂₀ alkylthio group, a phenyl group, a naphthyl group, an anthracenyl group, a pyridinyl group, or a combination thereof.

In one or more embodiments, the compound represented by Formula 201 may be represented by Formula 201A: 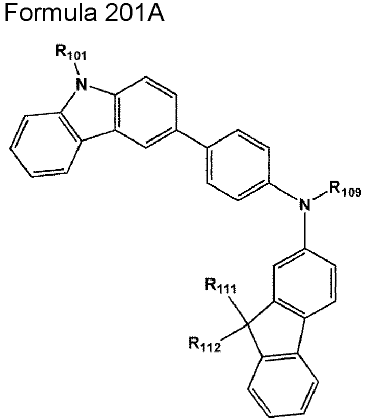 wherein, in Formula 201A, R₁₀₁, R₁₁₁, R₁₁₂, and R₁₀₉ may respectively be as described herein.

For example, the hole transport region may include one of Compounds HT1 to HT20, or a combination thereof:

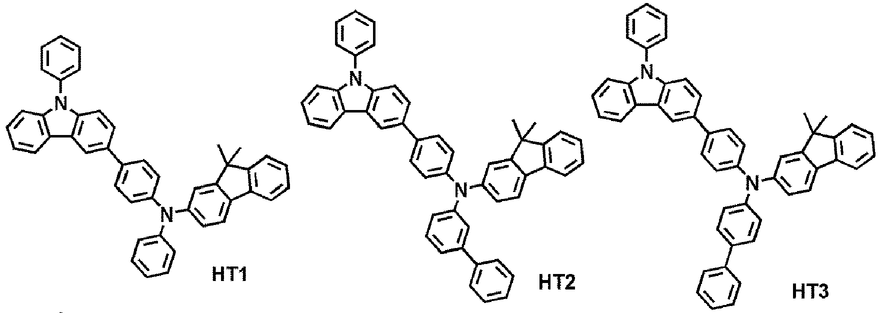

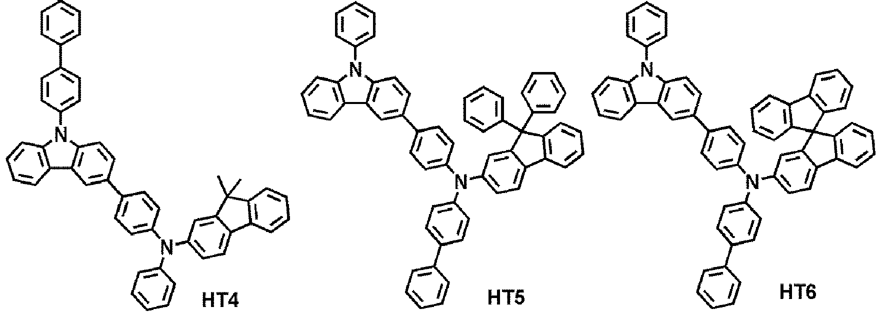

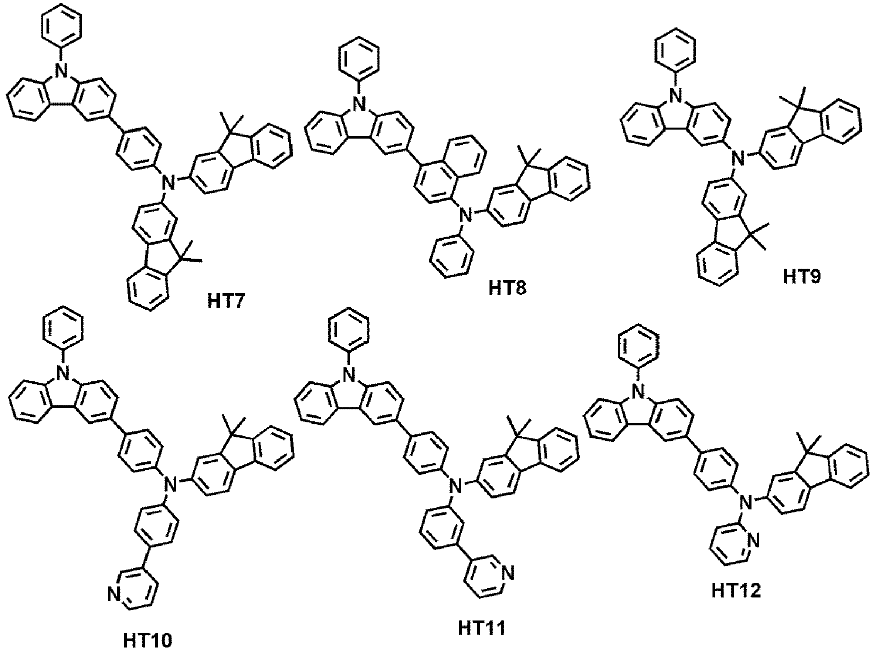

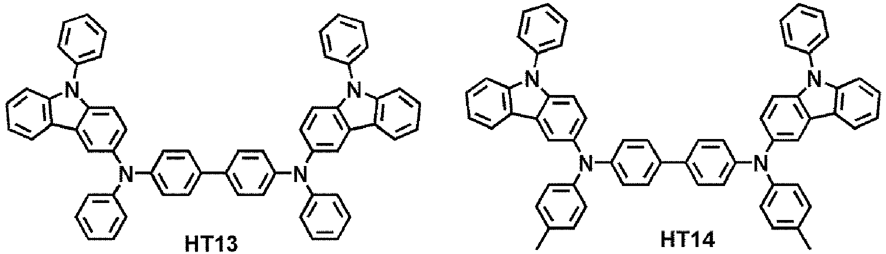

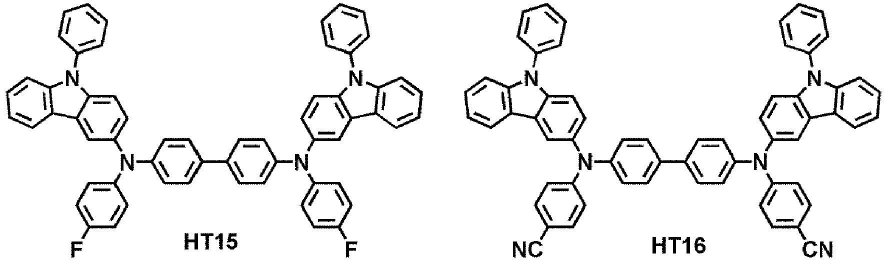

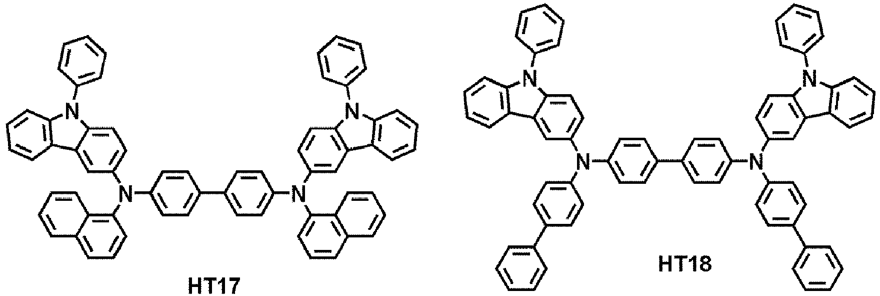

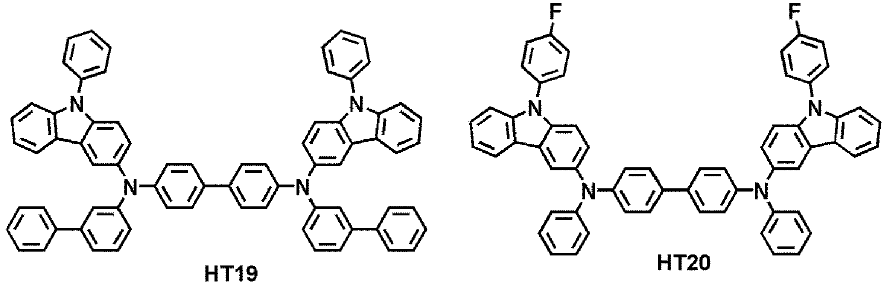

A thickness of the hole transport region may be in a range of about 100 angstroms (Å) to about 10,000 Å, for example, about 100 Å to about 1,000 Å. When the hole transport region includes at least one of a hole injection layer and a hole transport layer, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may include a quinone derivative, a metal oxide, a cyano group-containing compound, or a combination thereof, but embodiments of the present disclosure are not limited thereto. For example, non-limiting examples of the p-dopant are a quinone derivative, such as tetracyanoquinodimethane (TCNQ), 2,3,5,6-tetrafluoro-tetracyano-1,4-benzoquinonedimethane (F4-TCNQ), or F6-TCNQ; a metal oxide, such as a tungsten oxide or a molybdenum oxide; or a cyano group-containing compound, such as Compounds HT-D1 and F12, but are not limited thereto:

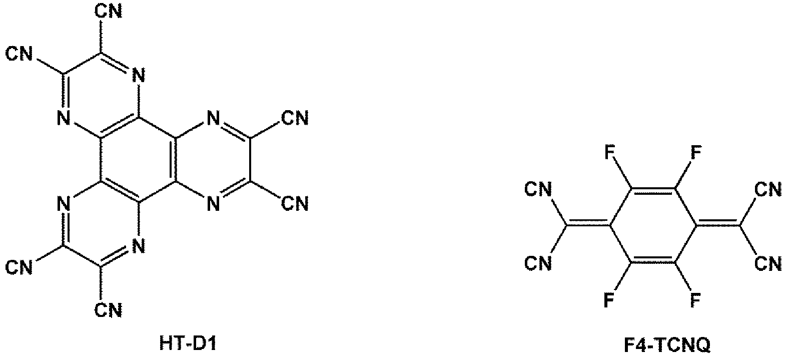

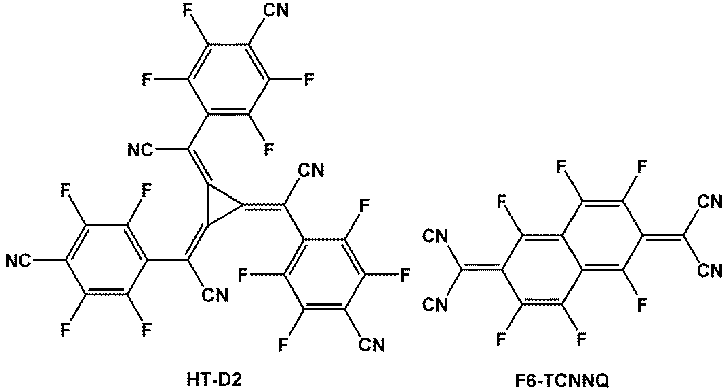

The hole transport region may further include a buffer layer.

The buffer layer may compensate for an optical resonance distance according to a wavelength of light emitted from the emission layer, and thus, efficiency of the light-emitting device may be improved.

Then, the emission layer may be formed on the hole transport region by using methods such as vacuum deposition, spin coating, casting, and/or L-B deposition. When the emission layer is formed by vacuum deposition or spin coating, the deposition or coating conditions may be similar to those applied in forming the hole injection layer although the deposition or coating conditions may vary according to a material that is used to form the hole transport layer.

The hole transport region may further include an electron blocking layer. The electron blocking layer may include a material available in the art, for example, mCP, but embodiments of the present disclosure are not limited thereto:

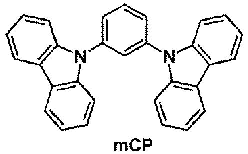

A thickness of the electron blocking layer may be about 50 Å to about 1,000 Å, for example about 70 Å to about 500 Å. When the thickness of the electron blocking layer is within the range described above, the electron blocking layer may have satisfactory electron blocking characteristics without a substantial increase in driving voltage.

When the organic light-emitting device 10 is a full-color organic light-emitting device, the emission layer may be patterned into a red emission layer, a green emission layer, and a blue emission layer. In one or more embodiments, based on a stacked structure including a red emission layer, a green emission layer, and/or a blue emission layer, the emission layer may emit white light, and various modifications are possible.

The emission layer may include the organometallic compound represented by Formula 1.

The emission layer may include a host and a dopant, and the dopant may include the organometallic compound represented by Formula 1.

The host may include 1,3,5-tri(1-phenyl-1H-benzo[d]imidazol-2-yl)phenyl (TPBi), 3-tert-butyl-9,10-di(naphth-2-yl)anthracene (TBADN), 9,10-di(naphthalene-2-yl)anthracene (ADN, also referred to as "DNA"), 4,4'-bis(N-carbazolyl)-1,1'-biphenyl (CBP), 4,4'-bis(9-carbazolyl)-2,2'-dimethyl-biphenyl (CDBP), TCP, mCP, Compound H50, Compound H51, Compound H52, or a combination thereof:

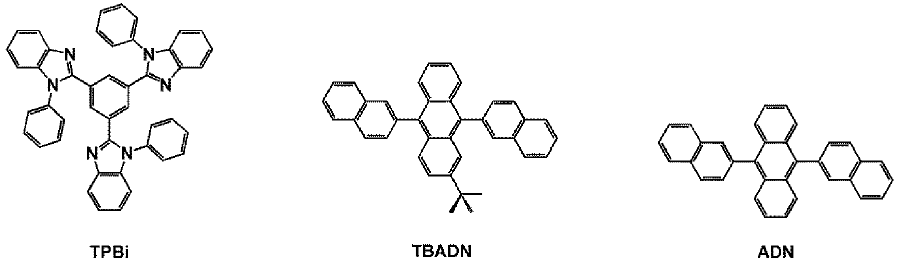

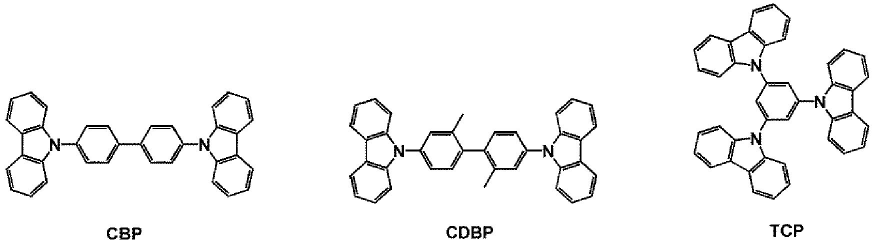

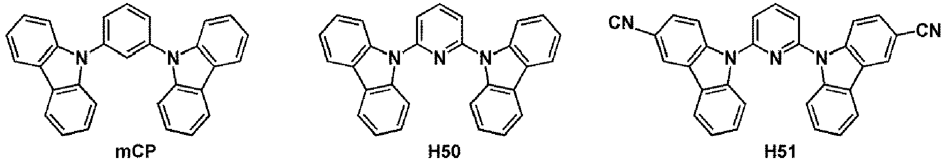

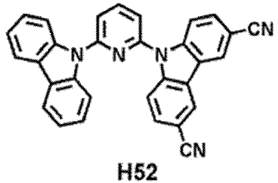

In one or more embodiments, the host may further include a compound represented by Formula 301: 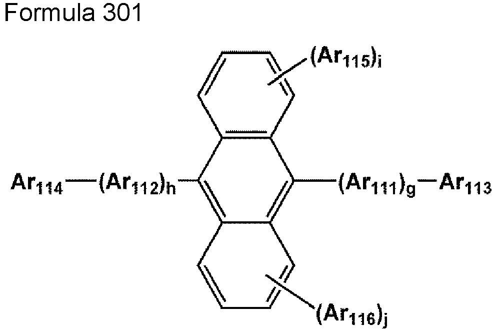 wherein, in Formula 301, Ar₁₁₁ and Ar₁₁₂ may each independently be:
a phenylene group, a naphthylene group, a phenanthrenylene group, or a pyrenylene group; or
a phenylene group, a naphthylene group, a phenanthrenylene group, or a pyrenylene group, each substituted with a phenyl group, a naphthyl group, an anthracenyl group, or a combination thereof.

In Formula 301, Ar₁₁₃ to Ar₁₁₆ may each independently be:
a C₁-C₁₀ alkyl group, a phenyl group, a naphthyl group, a phenanthrenyl group, or a pyrenyl group; or
a phenyl group, a naphthyl group, a phenanthrenyl group, or a pyrenyl group, each substituted with at least one of a phenyl group, a naphthyl group, an anthracenyl group, or a combination thereof.

In Formula 301, g, h, i, and j may each independently be 0, 1, 2, 3, or 4, and for example, may each independently be 0, 1, or 2.

In Formula 301, Ar₁₁₃ to Ar₁₁₆ may each independently be:
a C₁-C₁₀ alkyl group substituted with at least one of a phenyl group, a naphthyl group, an anthracenyl group, or a combination thereof;
a phenyl group, a naphthyl group, an anthracenyl group, a pyrenyl group, a phenanthrenyl group, or a fluorenyl group;
a phenyl group, a naphthyl group, an anthracenyl group, a pyrenyl group, a phenanthrenyl group, or a fluorenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a phenyl group, a naphthyl group, an anthracenyl group, a pyrenyl group, a phenanthrenyl group, a fluorenyl group, or a combination thereof; or 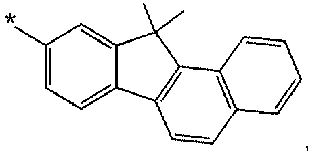 but embodiments are not limited thereto.

In one or more embodiments, the host may include a compound represented by Formula 302: 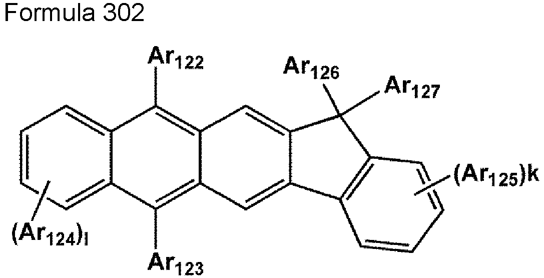 wherein, in Formula 302, Ar₁₂₂ to Ar₁₂₅ may each independently be as described in connection with Ar₁₁₃ in Formula 301.

In Formula 302, Ar₁₂₆ and Ar₁₂₇ may each independently be a C₁-C₁₀ alkyl group (for example, a methyl group, an ethyl group, or a propyl group).

In Formula 302, k and l may each independently be 0, 1, 2, 3, or 4. For example, k and I may each independently be 0, 1, or 2.

When the emission layer includes both a host and a dopant, an amount of the dopant may be in a range of about 0.01 parts by weight to about 20 parts by weight based on 100 parts by weight of the host, but embodiments of the present disclosure are not limited thereto. When the amount of the dopant is within the ranges above, emission without extinction phenomenon may be implemented.

In one or more embodiments, the organic layer of the organic light-emitting device may further include, in addition to the organometallic compound represented by Formula 1, a fluorescent dopant.

For example, the fluorescent dopant may be a condensation polycyclic compound, a styryl-based compound, or a combination thereof.

In one or more embodiments, the fluorescent dopant may include a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a group represented by one of Formulae 501-1 to 501-21, or a combination thereof:

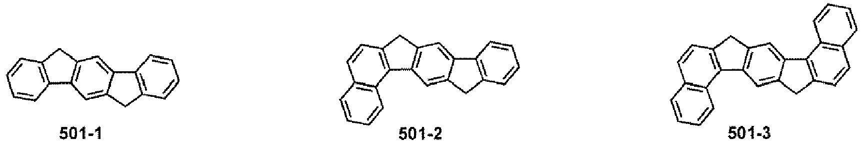

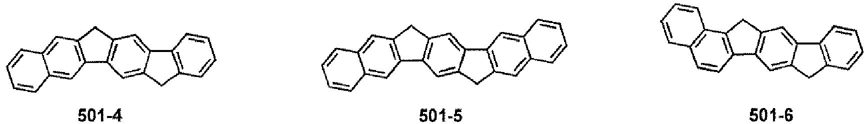

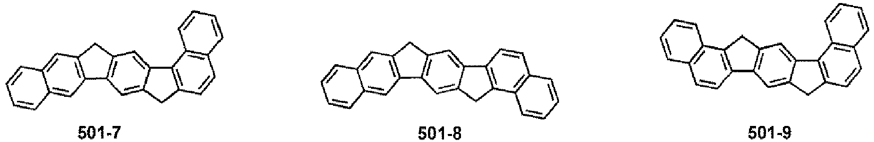

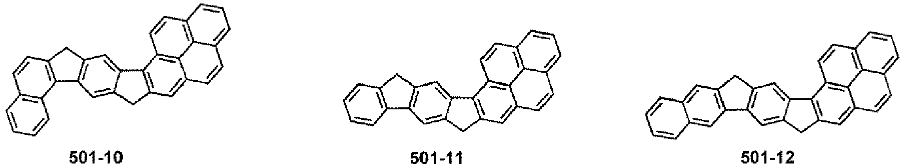

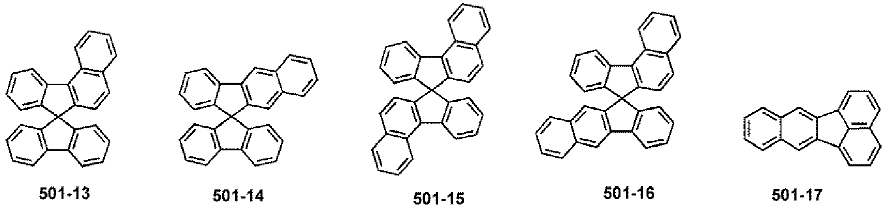

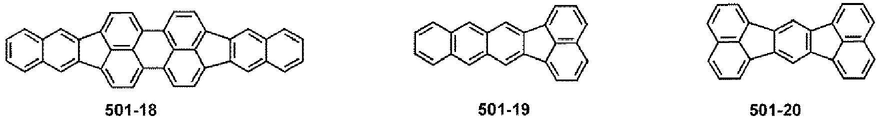

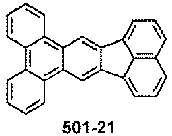

In one or more embodiments, the fluorescent dopant may be a compound represented by Formula 501: 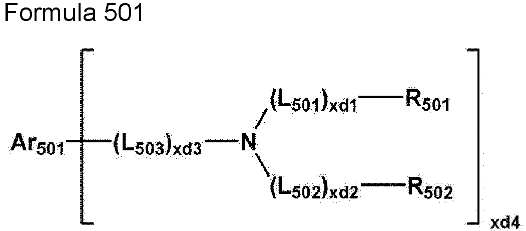 wherein, in Formula 501,
Ar₅₀₁ may be: a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formulae 501-1 to 501-21; or
a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene indenoanthracene group, a tetracene group, a bisanthracene group, or a groups represented by one of Formulae 501-1 to 501-21, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₅₀₁)(Q₅₀₂)(Q₅₀₃) (wherein Q₅₀₁ to Q₅₀₃ may each independently be hydrogen, a C₁-C₆₀ alkyl group, a C₁-C₆₀ alkoxy group, a C₆-C₆₀ aryl group, a C₁-C₆₀ heteroaryl group, a monovalent non-aromatic condensed polycyclic group, or a monovalent non-aromatic condensed heteropolycyclic group), or a combination thereof,
L₅₀₁ to L₅₀₃ may each independently be a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, or a substituted or unsubstituted divalent non-aromatic condensed heteropolycyclic group,
R₅₀₁ and R₅₀₂ may each independently be:
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, or a dibenzothiophenyl group; or
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, or a combination thereof,
   xd1 to xd3 may each independently be 0, 1, 2, or 3, and
   xd4 may be 0, 1, 2, 3, 4, 5, or 6.

For example, Ar₅₀₁ in Formula 501 may be:
a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formulae 501-1 to 501-21; or
a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formula 501-1 to 501-21, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a biphenyl group, a terphenyl group, a naphthyl group, a fluorenyl group, a dibenzofuranyl group, a dibenzothiophenyl group, a carbazolyl group, a pyridinyl group, a pyrimidinyl group, a triazinyl group, a quinolinyl group, an isoquinolinyl group, -Si(Q₅₀₁)(Q₅₀₂)(Q₅₀₃) (wherein Q₅₀₁ to Q₅₀₃ may each independently be selected from hydrogen, a C₁-C₂₀ alkyl group, a C₁-C₂₀ alkoxy group, a C₁-C₂₀ alkylthio group, a phenyl group, a biphenyl group, a terphenyl group, or a naphthyl group), or a combination thereof,
L₅₀₁ to L₅₀₃ may each be as described in connection with L₂₁,
xd1 to xd3 may each independently be 0, 1, or 2, and
xd4 may be 0, 1, 2, or 3, but embodiments are not limited thereto.

In one or more embodiments, the fluorescent dopant may include a compound represented by one or more of Formulae 502-1 to 502-5: 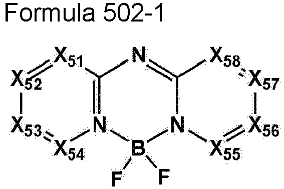 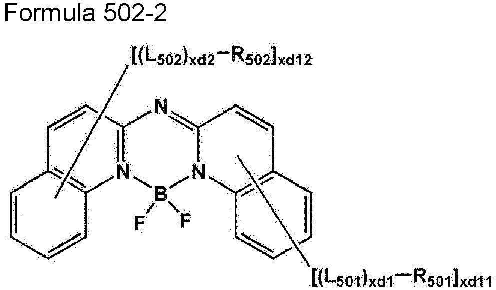 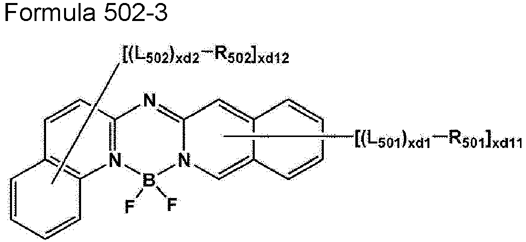 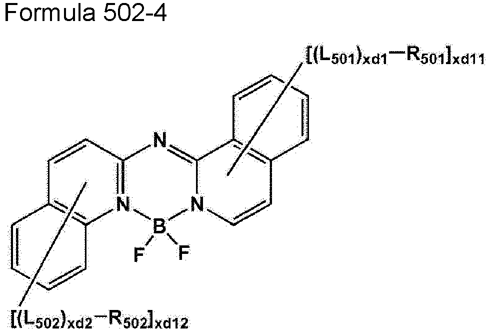 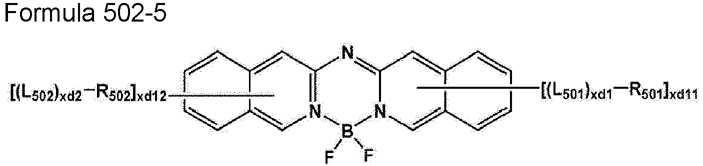
wherein, in Formulae 502-1 to 502-5,
X₅₁ may be N or C-[(L₅₀₁)_{xd1}-R₅₀₁], X₅₂ may be N or C-[(L₅₀₂)_{xd2}-R₅₀₂], X₅₃ may be N or C-[(L₅₀₃)_{xd3}-R₅₀₃], X₅₄ may be N or C-[(L₅₀₄)_{xd4}-R₅₀₄], X₅₅ may be N or C-[(L₅₀₅)_{xd5}-R₅₀₅], X₅₆ may be N or C-[(L₅₀₆)_{xd6}-R₅₀₆], X₅₇ may be N or C-[(L₅₀₇)_{xd7}-R₅₀₇], and X₅₈ may be N or C-[(L₅₀₈)_{xd8}-R₅₀₈],
L₅₀₁ to L₅₀₈ may each be as described in connection with L₅₀₁ in Formula 501,
xd1 to xd8 may each be as described in connection with xd1 in Formula 501,
R₅₀₁ to R₅₀₈ may each independently be:
   hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, or a dibenzothiophenyl group; or
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, or a combination thereof,
   xd11 and xd12 may each independently be 0, 1, 2, 3, 4, or 5,
   two of R₅₀₁ to R₅₀₄ may optionally be linked to each other to form a saturated unsaturated ring, and
   two of R₅₀₅ to R₅₀₈ may optionally be linked to each other to form a saturated or unsaturated ring.

In one or more embodiments, the fluorescent dopant may include a compound represented by one or more of Formula 503-1 or 503-2: 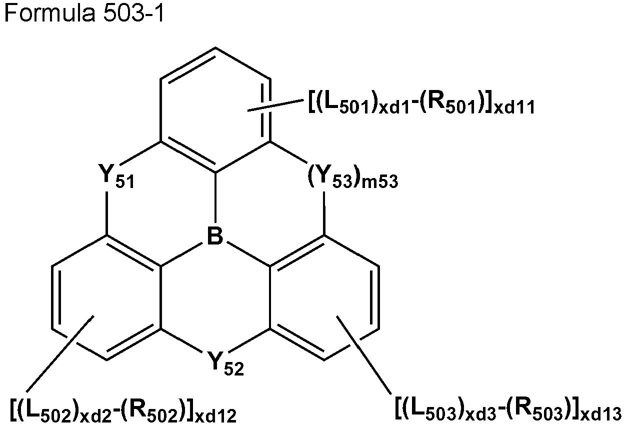 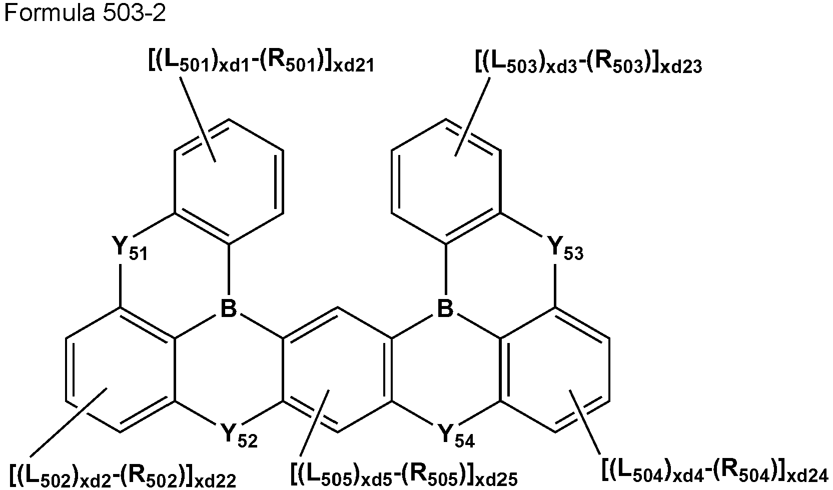
wherein, in Formulae 503-1 and 503-2,
Y₅₁ to Y₅₄ may each independently be a single bond, O, S, N[(L₅₀₆)_{xd6}-R₅₀₆], C[(L₅₀₆)_{xd6}-R₅₀₆][(L₅₀₇)_{xd7}-R₅₀₇], or Si[(L₅₀₆)_{xd6}-R₅₀₆][(L₅₀₇)_{xd7}-R₅₀₇],
m53 may be 0 or 1,
L₅₀₁ to L₅₀₇ may each be as described in connection with L₅₀₁ in Formula 501,
xd1 to xd7 may each be as described in connection with xd1 in Formula 501,
R₅₀₁ to R₅₀₇ may each independently be:
   hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, or a dibenzothiophenyl group; or
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, or a combination thereof,
   xd11 and xd13 may each independently be 0, 1, 2, 3, or 4 when m53 is 0,
   xd11 and xd13 may each independently be 0, 1, 2, or 3 when m53 is 1,
   xd21 and xd23 may each independently be 0, 1, 2, 3, or 4,
   xd12, xd22, and xd24 may each independently be 0, 1, 2, or 3,
   xd25 may be 0, 1, or 2, and
   two of R₅₀₁ to R₅₀₇ may optionally be linked to each other to form a saturated ring or an unsaturated ring.

The fluorescent dopant may include, for example, one of Compounds FD(16) and FD1 to FD17, or a combination thereof:

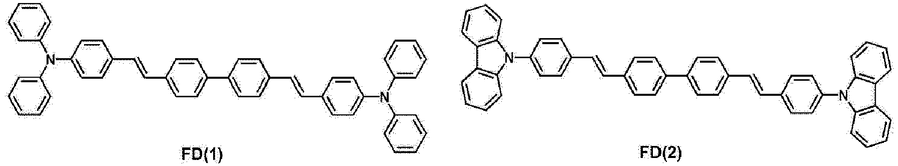

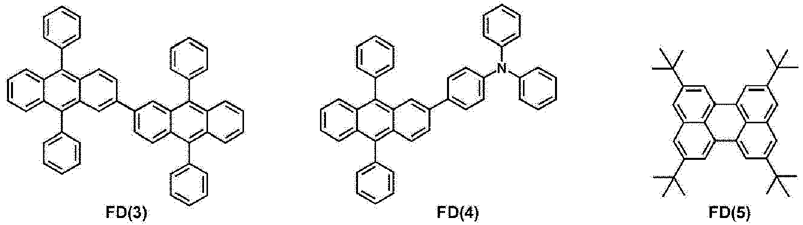

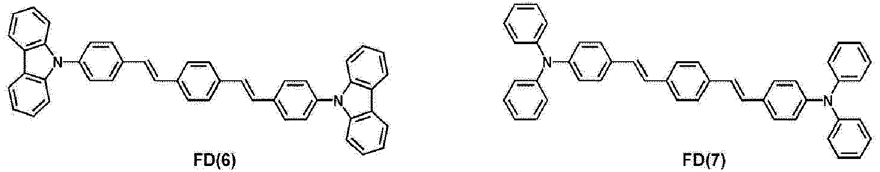

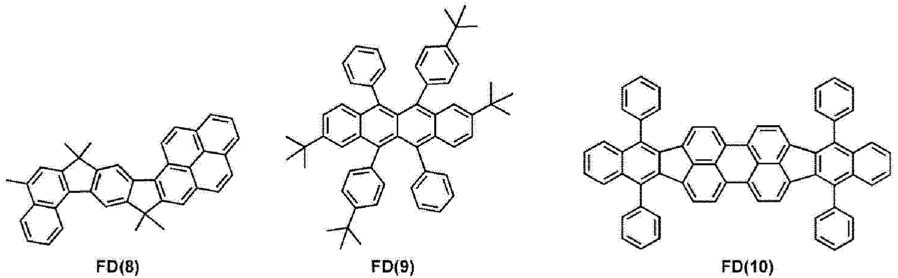

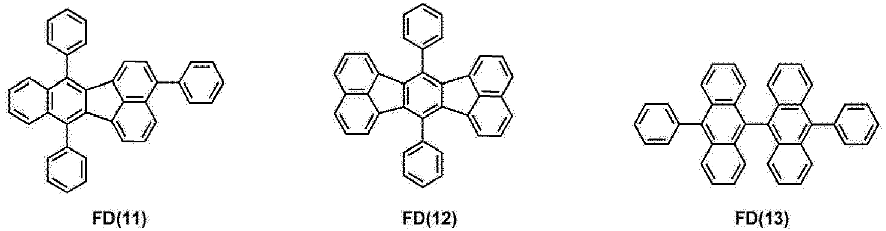

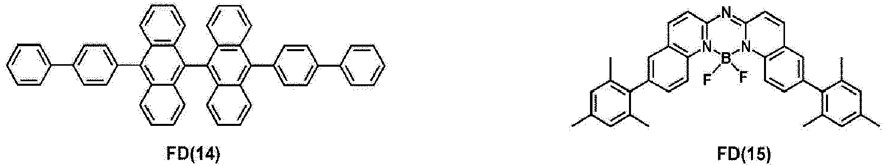

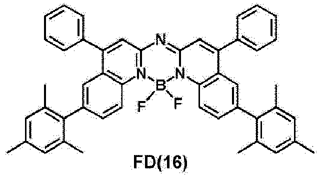

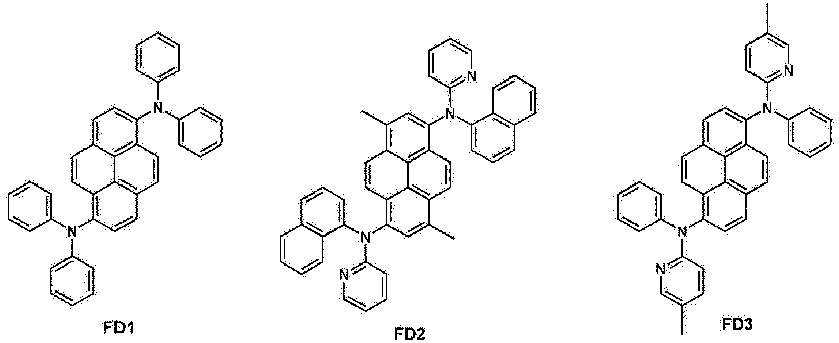

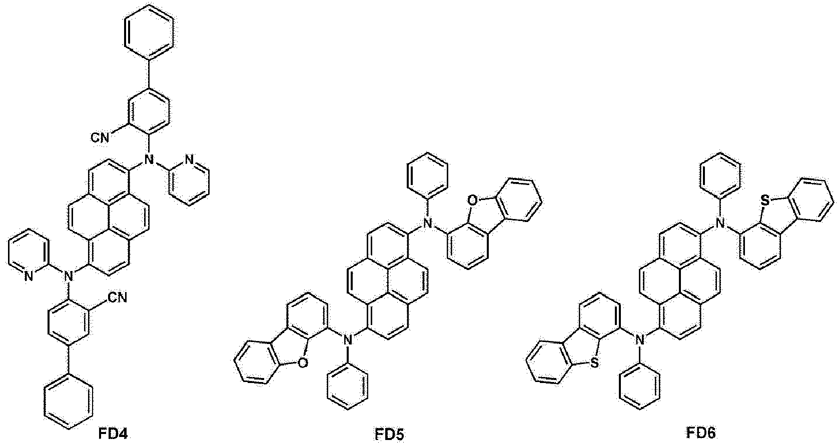

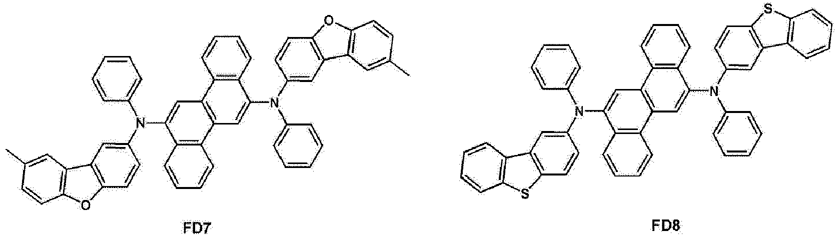

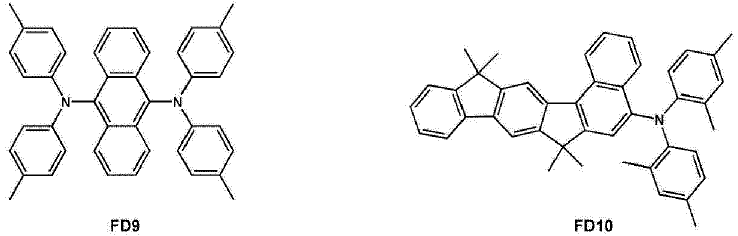

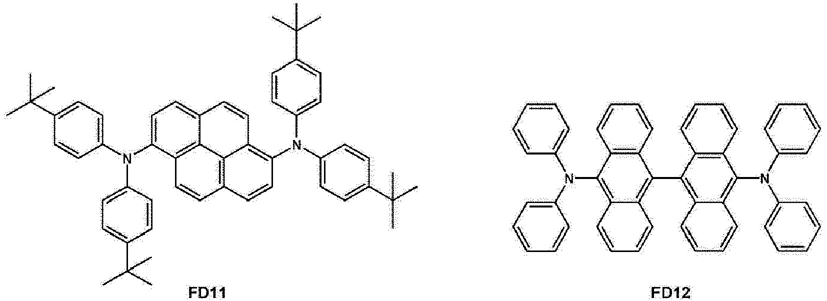

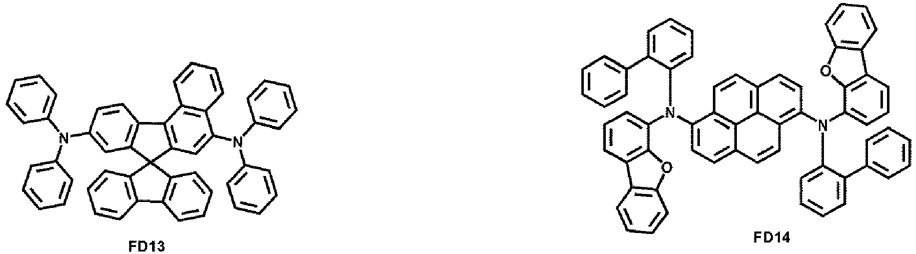

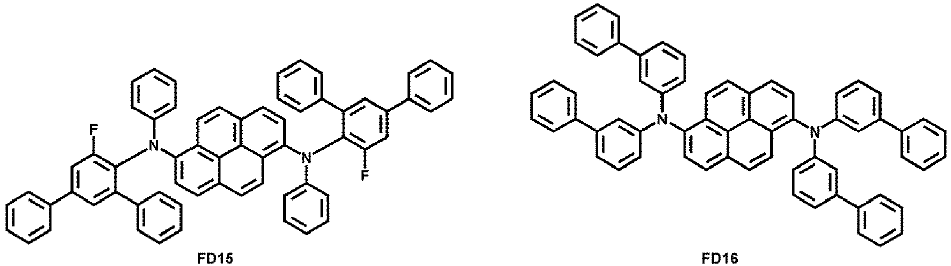

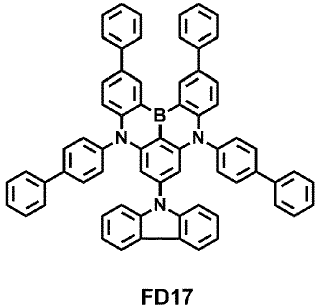

A thickness of the emission layer may be in a range of about 100 Å to about 1,000 Å, for example, about 200 Å to about 600 Å. When the thickness of the emission layer is within these ranges, excellent luminescence characteristics may be obtained without a substantial increase in driving voltage.

Next, the electron transport region 5 is arranged on the emission layer.

The electron transport region may include at least one selected from a hole blocking layer, an electron transport layer and an electron injection layer.

For example, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be as the conditions for forming the hole injection layer.

When the electron transport region includes a hole blocking layer, the hole blocking layer may include, for example, at least one of 2,9-dimethyl-4,7-diphenyl-1,10-phenanthroline (BCP) or 4,7-diphenyl-1,10-phenanthroline (Bphen), but embodiments are not limited thereto:

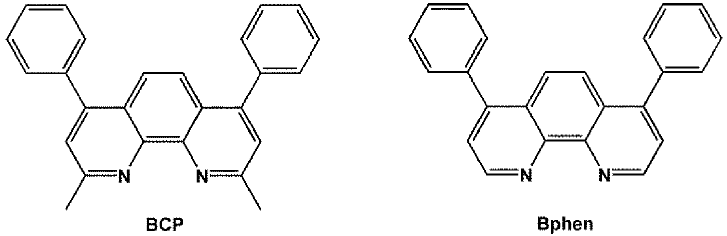

A thickness of the hole blocking layer may be in a range of about 20 Å to about 1,000 Å, for example, about 30 Å to about 300 Å. When the thickness of the hole blocking layer is within these ranges, excellent hole-blocking characteristics may be obtained without a substantial increase in driving voltage.

In one or more embodiments, the electron transport layer may include 2,9-dimethyl-4,7-diphenyl-1,10-phenanthroline (BCP), 4,7-diphenyl-1,10-phenanthroline (Bphen), 1,3,5-tris(N-phenylbenzimidazole-2-yl)benzene (TPBi), tris(8-hydroxyquinolino)aluminum (Alq₃), bis(2-methyl-8-quinolinolato-N1,O8)-(1,1'-biphenyl-4-olato)aluminum (Balq), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), or a combination thereof:

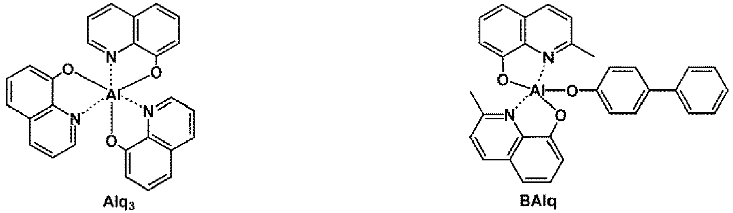

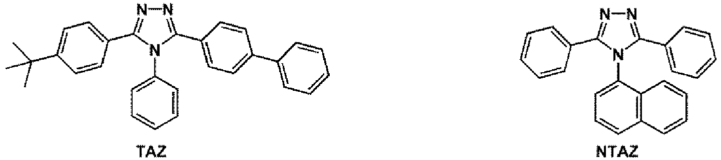

In one or more embodiments, the electron transport layer may include at least one of Compounds ET1 to ET25, but embodiments are not limited thereto:

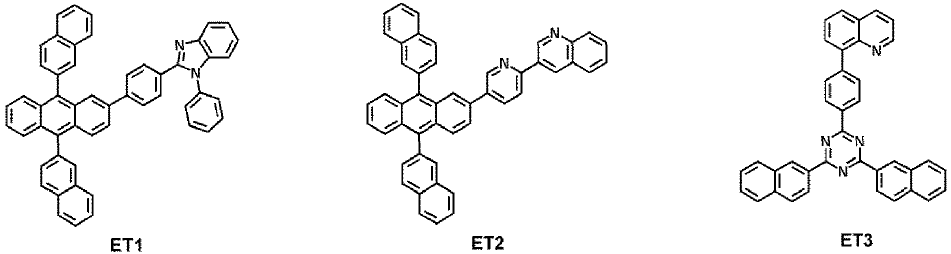

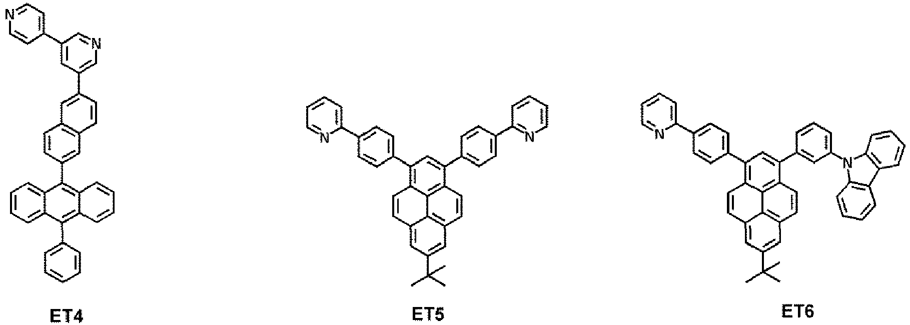

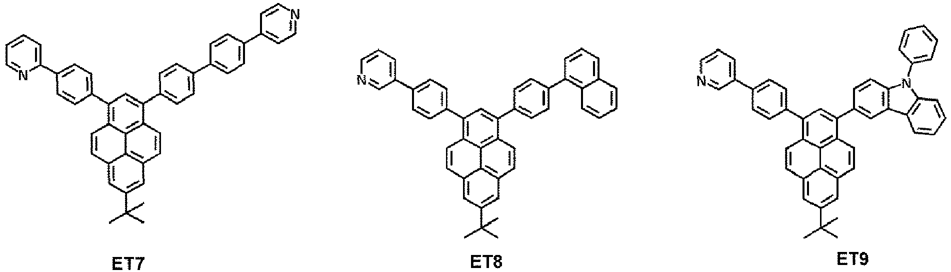

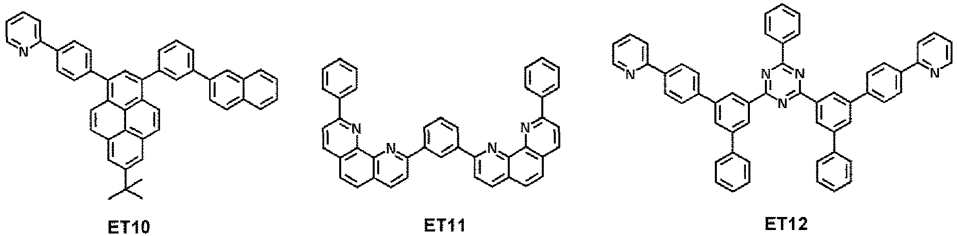

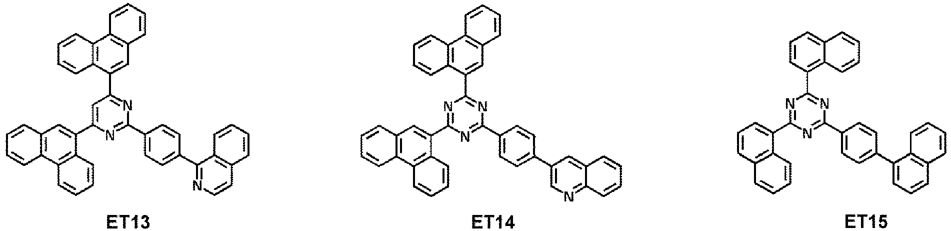

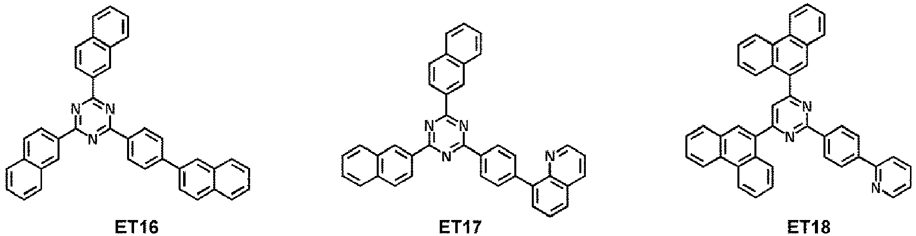

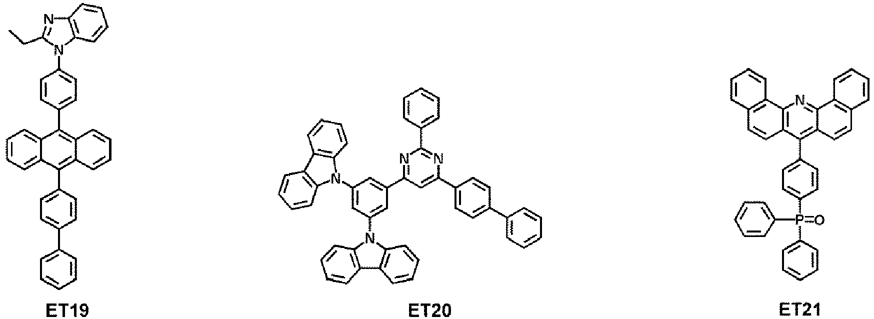

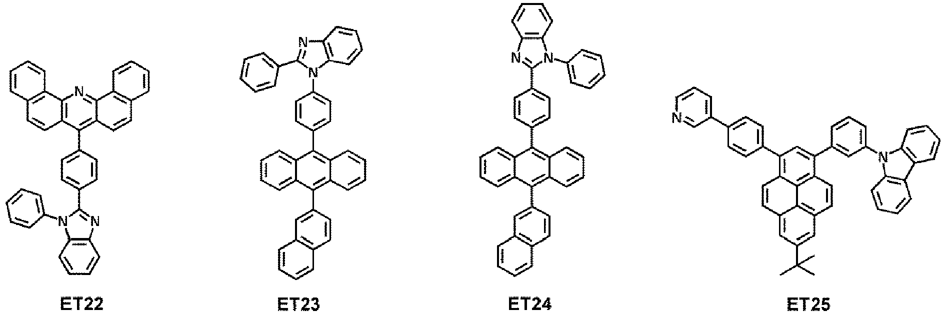

A thickness of the electron transport layer may be in a range of about 100 Å to about 1,000 Å, for example, about 150 Å to about 500 Å. When the thickness of the electron transport layer is within these ranges, satisfactory electron transporting characteristics may be obtained without a substantial increase in driving voltage.

The electron transport layer may include, in addition to the materials described above, a metal-containing material.

The metal-containing material may include a Li complex. The Li complex may include, for example, Compound ET-D1 (lithium quinolate (LiQ)) or ET-D2:

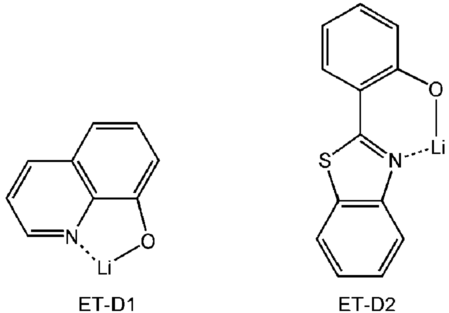

In one or more embodiments, the electron transport region may also include an electron injection layer that promotes the flow of electrons from the second electrode 19 thereinto.

The electron injection layer may include at least one of LiQ, LiF, NaCl, CsF, Li₂O, or BaO.

A thickness of the electron injection layer may be in a range of about 1 Å to about 100 Å, and, for example, about 3 Å to about 90 Å. When the thickness of the electron injection layer is within these ranges, satisfactory electron injection characteristics may be obtained without a substantial increase in driving voltage.

The second electrode 19 is arranged on the organic layer 15. The second electrode 19 may be a cathode. A material for forming the second electrode 19 may be metal, an alloy, an electrically conductive compound, or a combination thereof, which has a relatively low work function. For example, the material for forming the second electrode 19 may be lithium (Li), magnesium (Mg), aluminum (Al), silver (Ag), aluminum-lithium (Al-Li), calcium (Ca), magnesium-indium (Mg-In), or magnesium-silver (Mg-Ag). To manufacture a top-emission type light-emitting device, various modifications are possible, and for example, a transmissive electrode formed using ITO or IZO may be used as the second electrode 19.

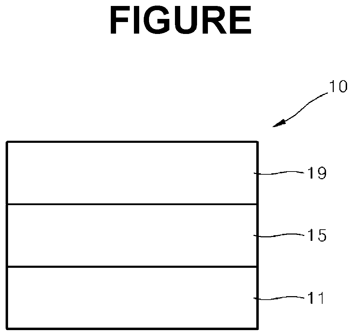

Hereinbefore, the organic light-emitting device has been described with reference to FIG. 1, but embodiments of the present disclosure are not limited thereto.

Another aspect of the present disclosure provides a diagnostic composition including at least one organometallic compound represented by Formula 1.

The organometallic compound represented by Formula 1 provides high luminescence efficiency, and accordingly, the diagnostic composition including the at least one organometallic compound may have high diagnostic efficiency.

The diagnostic composition may be used in various applications including a diagnosis kit, a diagnosis reagent, a biosensor, and a biomarker.

### Definitions of terms

The term "C₁-C₆₀ alkyl group" as used herein refers to a linear or branched saturated aliphatic hydrocarbon monovalent group having 1 to 60 carbon atoms, and examples thereof are a methyl group, an ethyl group, a propyl group, an isobutyl group, a sec-butyl group, a tert-butyl group, a pentyl group, an isoamyl group, a hexyl group, and the like. The term "C₁-C₆₀ alkylene group" as used herein refers to a divalent group having structure as the C₁-C₆₀ alkyl group.

The term "C₁-C₆₀ alkoxy group" as used herein refers to a monovalent group represented by -OA₁₀₁ (wherein A₁₀₁ is the C₁-C₆₀ alkyl group), and examples thereof are a methoxy group, an ethoxy group, an isopropyloxy group, and the like. The term "C₁-C₆₀ alkylthio group" as used herein refers to a monovalent group represented by -SA₁₀₁ (wherein A₁₀₁ is the C₁-C₆₀ alkyl group).

The term "C₂-C₆₀ alkenyl group" as used herein refers to a hydrocarbon group formed by substituting at least one carbon-carbon double bond in the middle or at the terminus of the C₂-C₆₀ alkyl group, and examples thereof are an ethenyl group, a propenyl group, a butenyl group, and the like. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and examples thereof are an ethynyl group, a propynyl group, and the like. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon monocyclic group having 3 to 10 carbon atoms, and examples thereof are a cyclopropyl group, a cyclobutyl group, a cyclopentyl group, a cyclohexyl group, a cycloheptyl group, and the like. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent saturated monocyclic group having at least one heteroatom selected from N, O, P, Si, Se, Ge, and S as a ring-forming atom and 1 to 10 carbon atoms, and examples thereof are a tetrahydrofuranyl group, a tetrahydrothiophenyl group, and the like. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent monocyclic group that has 3 to 10 carbon atoms and at least one carbon-carbon double bond in the ring thereof and no aromaticity, and examples thereof are a cyclopentenyl group, a cyclohexenyl group, a cycloheptenyl group, and the like. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one heteroatom selected from N, O, P, Si, Se, Ge, and S as a ring-forming atom, 1 to 10 carbon atoms, and at least one carbon-carbon double bond in its ring. Examples of the C₁-C₁₀ heterocycloalkenyl group are a 2,3-dihydrofuranyl group, a 2,3-dihydrothiophenyl group, and the like. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Examples of the C₆-C₆₀ aryl group are a phenyl group, a naphthyl group, an anthracenyl group, a phenanthrenyl group, a pyrenyl group, a chrysenyl group, and the like. When the C₆-C₆₀ aryl group and the C₆-C₆₀ arylene group each include two or more rings, the two or more rings may be fused to each other.

The term "C₁-C₆₀ heteroaryl group" as used herein refers to a monovalent group having a carbocyclic aromatic system that has at least one heteroatom selected from N, O, P, Si, Se, Ge, and S as a ring-forming atom, and 1 to 60 carbon atoms. The term "C₁-C₆₀ heteroarylene group" as used herein refers to a divalent group having a carbocyclic aromatic system that has at least one heteroatom selected from N, O, P, Si, Se, Ge, and S as a ring-forming atom, and 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, an isoquinolinyl group, and the like. When the C₆-C₆₀ heteroaryl group and the C₆-C₆₀ heteroarylene group each include two or more rings, the two or more rings may be fused to each other.

The term "C₆-C₆₀ aryloxy group" as used herein refers to -OA₁₀₂ (wherein A₁₀₂ is the C₆-C₆₀ aryl group), and the term "C₆-C₆₀ arylthio group" as used herein refers to - SA₁₀₃ (wherein A₁₀₃ is the C₆-C₆₀ aryl group).

The term "C₁-C₆₀ heteroaryloxy group" as used herein refers to -OA_{102'} (wherein A_{102'} is the C₁-C₆₀ heteroaryl group), and the term "C₁-C₆₀ heteroarylthio group" as used herein refers to -SA_{103'} (wherein A_{103'} is the C₁-C₆₀ heteroaryl group).

The term "C₇-C₆₀ alkyl aryl group" as used herein refers to a C₆-C₃₀ aryl group substituted with a C₁-C₃₀ alkyl group. The term "C₇-C₆₀ aryl alkyl group" as used herein refers to a C₁-C₃₀ alkyl group substituted with a C₆-C₃₀ aryl group.

The term "C₂-C₆₀ alkyl heteroaryl group" as used herein refers to a C₁-C₃₀ heteroaryl group substituted with a C₁-C₃₀ alkyl group. The term "C₂-C₆₀ heteroaryl alkyl group" as used herein refers to a C₁-C₃₀ alkyl group substituted with a C₁-C₃₀ heteroaryl group.

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group are a fluorenyl group and the like. The term "divalent non-aromatic condensed polycyclic group" as used herein refers to a divalent group having the same structure as the monovalent non-aromatic condensed polycyclic group described above.

The term "monovalent non-aromatic condensed heteropolycyclic group" as used herein refers to a monovalent group (for example, having 2 to 60 carbon atoms) having two or more rings condensed with each other, a heteroatom selected from N, O, P, Si, Se, Ge, and S, other than carbon atoms, as a ring-forming atom, and no aromaticity in its entire molecular structure. Examples of the monovalent non-aromatic condensed heteropolycyclic group are a carbazolyl group and the like. The term "divalent non-aromatic condensed heteropolycyclic group" as used herein refers to a divalent group having the same structure as the monovalent non-aromatic condensed heteropolycyclic group described above.

The term "C₅-C₃₀ carbocyclic group" as used herein refers to a saturated or unsaturated cyclic group having, as a ring-forming atom, 5 to 30 carbon atoms only. The C₅-C₃₀ carbocyclic group may be a monocyclic group or a polycyclic group.

The term "C₁-C₃₀ heterocyclic group" as used herein refers to a saturated or unsaturated cyclic group having, as a ring-forming atom, at least one heteroatom selected from N, O, P, Si, Se, Ge, and S other than 1 to 30 carbon atoms. The C₁-C₃₀ heterocyclic group may be a monocyclic group or a polycyclic group.

At least one substituent of each of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may be:
deuterium, -F, -Cl, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁₋₆₀ alkylthio group;
a C₁-C₆₀ alkyl group, a C₂-C₆₀ alkenyl group, a C₂-C₆₀ alkynyl group, a C₁-C₆₀ alkoxy group, or a C₁₋₆₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₆), - Ge(Q₁₃)(Q₁₄)(Q₁₆), -B(Q₁₆)(Q₁₇), -P(Q₁₈)(Q₁₉), or -P(=O)(Q₁₈)(Q₁₉);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), -P(Q₂₈)(Q₂₉), or -P(=O)(Q₂₈)(Q₂₉); or
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(Q₃₈)(Q₃₉), or -P(=O)(Q₃₈)(Q₃₉), and
Q₁ to Q₉, Q₁₁ to Q₁₉, Q₂₁ to Q₂₉, and Q₃₁ to Q₃₉ may each independently be: hydrogen, deuterium, -F, -Cl, -Br, -I, SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each of which is unsubstituted or substituted with at least one of deuterium, a C₁-C₆₀ alkyl group, a C₆-C₆₀ aryl group, or a combination thereof.

For example, Q₁ to Q₉, Q₁₁ to Q₁₉, Q₂₁ to Q₂₉, and Q₃₁ to Q₃₉ as used herein may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or a combination thereof.

The term "room temperature" as used herein refers to a temperature of about 25°C.

The terms "a biphenyl group, a terphenyl group, and a tetraphenyl group" as used herein respectively refer to monovalent groups in which two, three, or four phenyl groups which are linked together via a single bond.

Hereinafter, a compound and an organic light-emitting device according to one or more exemplary embodiments are described in further detail with reference to Synthesis Examples and Examples. However, the compound and the organic light-emitting device are not limited thereto. The wording "B was used instead of A" used in describing Synthesis Examples means that an amount of A used was identical to an amount of B used, in terms of a molar equivalent.

### EXAMPLES

### Synthesis Example 1: Synthesis of Compound 161

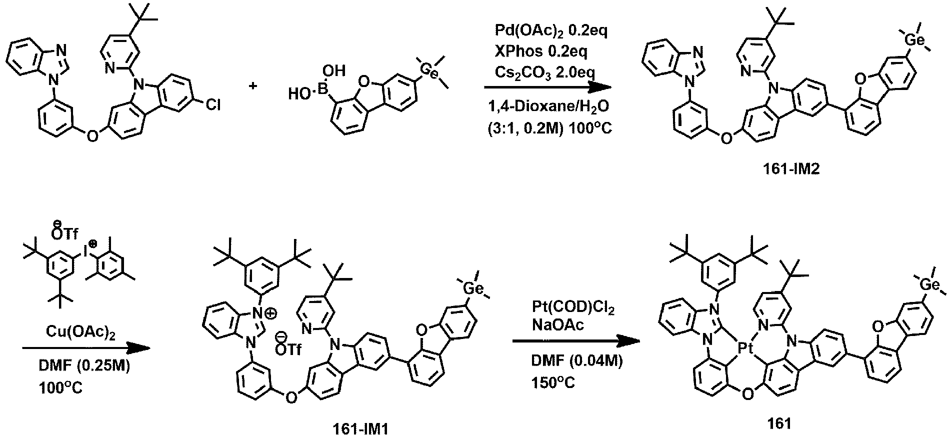

### (1) Synthesis of 2-(3-(1H-benzo[d]imidazol-1-yl)phenoxy)-9-(4-(tert-butyl)pyridin-2-yl)-6-chloro-9H-carbazole

1-(3-bromophenyl)-1H-benzo[d]imidazole (4.0 g, 14.65mmol), 9-(4-(tert-butyl)pyridin-2-yl)-6-chloro-9H-carbazol-2-ol (7.19 g, 20.50 mmol), Cul (0.84 g, 4.39 mmol), Pyridine-2-carboxylic Acid (0.72 g, 5.86 mmol), and Potassium phosphate (9.33 g, 43.94 mmol) were mixed with DMSO (98 mL), and stirred at 100°C for 12 hours. After completion of the reaction, the resultant mixture was allowed to cool to room temperature. An extraction process was performed thereon using saturated ammonium chloride (NH₄Cl) aqueous solution and ethyl acetate (EA), and an organic layer extracted therefrom was dried using anhydrous magnesium sulfate (MgSO₄), filtered, and then concentrated under reduced pressure. The resultant product thus obtained was subjected to silica gel flash column chromatography to obtain 2-(3-(1H-benzo[d]imidazol-1-yl)phenoxy)-9-(4-(tert-butyl)pyridin-2-yl)-6-chloro-9H-carbazole (7.5 g, yield=94%).

### (2) Synthesis of Intermediate 161-IM2

2-(3-(1H-benzo[d]imidazol-1-yl)phenoxy)-9-(4-(tert-butyl)pyridin-2-yl)-6-chloro-9H-carbazole (6.00 grams (g), 11.05 millimoles (mmol)), (7-(trimethylgermyl)dibenzo[b,d]furan-4-yl)boronic acid (4.72 g, 14.36 mmol), palladium (II) acetate (0.50 g, 2.21 mmol), 2-dicyclohexylphosphino-2',4',6'-triisopropylbiphenyl (X-phos) (1.05 g, 2.21 mmol), and cesium carbonate (7.20 g, 22.10 mmol) were mixed with 1,4-dioxane and water (3:1 v/v, 56 mL), and stirred at 100°C for 12 hours. After completion of the reaction, the resultant mixture was allowed to cool to room temperature. An extraction process was performed thereon using saturated ammonium chloride (NH₄Cl) and ethyl acetate (EA), and an organic layer extracted therefrom was dried using anhydrous magnesium sulfate (MgSO₄), filtered, and then concentrated under reduced pressure. The resultant product thus obtained was subjected to silica gel flash column chromatography to obtain Intermediate 161-IM2 (7.45 g, 9.41 mmol, yield=85%).

Liquid chromatography-mass spectrometry (LS-MS) (calculated: 792.25 g/mol, found M+1=793.23 g/mol).

### (3) Synthesis of Intermediate 161-IM1

Intermediate 161-IM2 (4.60 g, 5.81 mmol), (3,5-di-tert-butylphenyl)(mesityl)iodonium trifluoromethanesulfonate (4.08 g, 6.97 mmol), and copper (II) acetate (0.11 g, 0.58 mmol) were mixed with 23 mL of N,N-dimethylformamide (DMF), and stirred at 100°C for 12 hours. After completion of the reaction, the resultant mixture was allowed to cool to room temperature. An extraction process was performed thereon using saturated NH₄Cl and EA, and an organic layer extracted therefrom was dried using anhydrous MgSO₄, filtered, and then concentrated under reduced pressure. The resultant product thus obtained was subjected to silica gel flash column chromatography to obtain Intermediate 161-IM1 (4.49 g, 3.97 mmol, yield=68%).

LC-MS (calculated: 1130.37 g/mol, found M+1 =981.38 g/mol).

### (4) Synthesis of Compound 161

Intermediate 161-IM1 (4.49 g, 3.97 mmol), (1,5-cyclooctadiene)platinum(II) dichloride (Pt(COD)Cl₂) (1.64 g, 4.37 mmol), and sodium acetate (0.98 g, 11.92 mmol) were mixed with 99 mL of DMF, and stirred at 150°C for 16 hours. After completion of the reaction, the resultant mixture was allowed to cool to room temperature. An extraction process was performed thereon using saturated NH₄Cl and dichloromethane (MC), and an organic layer extracted therefrom was dried using anhydrous MgSO₄, filtered, and then concentrated under reduced pressure. The resultant product thus obtained was subjected to silica gel flash column chromatography to obtain Compound 161 (1.51 g, 1.28 mmol, yield=32%).

LC-MS (calculated: 1172.36 g/mol, found M+1=1173.32 g/mol).

### Synthesis Example 2: Synthesis of Compound 130

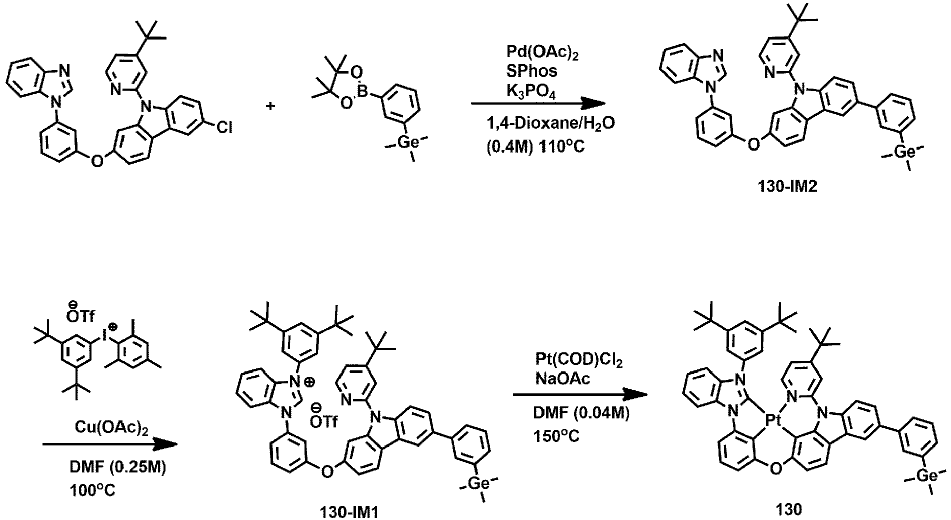

### (1) Synthesis of Intermediate 130-IM2

2-(3-(1H-benzo[d]imidazol-1-yl)phenoxy)-9-(4-(tert-butyl)pyridin-2-yl)-6-chloro-9H-carbazole (5.00 g, 9.21 mmol), trimethyl(3-(4,4,5,5-tetramethyl-1,3,2-dioxaborolan-2-yl)phenyl)germane (4.43 g, 13.81 mmol), palladium (II) acetate (0.70 g, 3.68 mmol), 2-dicyclohexylphosphino-2',6'-dimethoxybiphenyl (S-phos) (0.91 g, 7.37 mmol), and potassium phosphate tribasic (5.86 g, 27.62 mmol) were mixed with 1,4-dioxane and DI water (4:1 v/v, 100 mL), and stirred at 110°C for 20 hours. After completion of the reaction, the resultant mixture was allowed to cool to room temperature. An extraction process was performed thereon using saturated NH₄Cl and EA, and an organic layer extracted therefrom was dried using anhydrous MgSO₄, filtered, and then concentrated under reduced pressure. The resultant product thus obtained was subjected to silica gel flash column chromatography to obtain Intermediate 130-IM2 (3.72 g, 5.30 mmol, yield=58%).

LC-MS (calculated: 702.24 g/mol, found M+1=703.23 g/mol).

### (2) Synthesis of Intermediate 130-IM1

Intermediate 130-IM2 (3.72 g, 5.30 mmol), (3,5-di-tert-butylphenyl)(mesityl)iodonium trifluoromethanesulfonate (4.65 g, 7.95 mmol), and copper (II) acetate (0.10 g, 0.53 mmol) were mixed with 21 mL of DMF, and stirred at 100°C for 3 hours. After completion of the reaction, the resultant mixture was allowed to cool to room temperature. An extraction process was performed thereon using saturated NH₄Cl and EA, and an organic layer extracted therefrom was dried using anhydrous MgSO₄, filtered, and then concentrated under reduced pressure. The resultant product thus obtained was subjected to silica gel flash column chromatography to obtain Intermediate 130-IM1 (3.53 g, 3.39 mmol, yield=64%).

LC-MS (calculated: 1040.36 g/mol, found M+1 =891.38 g/mol).

### (3) Synthesis of Compound 130

Intermediate 130-IM1 (3.53 g, 3.39 mmol), Pt(COD)Cl₂ (1.40 g, 3.73 mmol), and sodium acetate (0.84 g, 10.18 mmol) were mixed with 85 mL of DMF, and stirred at 150°C for 18 hours. After completion of the reaction, the resultant mixture was cooled to room temperature. An extraction process was performed thereon using saturated NH₄Cl and MC, and an organic layer extracted therefrom was dried using anhydrous MgSO₄, filtered, and then concentrated under reduced pressure. The resultant product thus obtained was subjected to silica gel flash column chromatography to obtain Compound 130 (1.22 g, 1.12 mmol, yield=33%).

LC-MS (calculated: 1083.35 g/mol, found M=1083.32 g/mol).

### Evaluation Example 1: Evaluation of photoluminescence (PL) spectrum of solution

A sample was prepared by diluting Compound 161 in toluene at a concentration of 1 × 10⁻⁴ M. A PL spectrum of the sample was measured at room temperature (25°C) by using an ISC PC1 spectrofluorometer equipped with a Xenon lamp. Then, a similar process was repeated for each of Compound 130 and Comparative Compound C1, and a maximum PL emission wavelength (λₘₐₓ, nm), full width at half maximum (FWHM, nm), and second peak intensity (arbitrary units, AU) of each compound are shown in Table 2.

**Table 2**

| Compound No. | λₘₐₓ (nm) | FWHM (nm) | Second peak intensity (AU) |
|---|---|---|---|
| 161 | 460 | 30 | 0.393 |
| 130 | 461 | 29 | 0.393 |
| C1 | 460 | 32 | 0.419 |

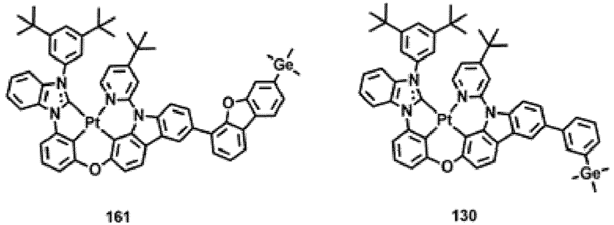

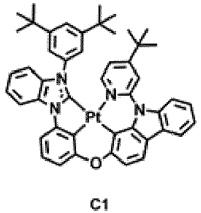

As shown in Table 2, it was observed that Compounds 130 and 161 according to the exemplary embodiments showed PL spectra having FWHM that was less than or equal to the FWHM in PL spectra of Comparative Compound C1, and Compounds 130 and 161 showed a decrease in the second peak intensity. Accordingly, it was confirmed that the exemplary compounds exhibiting a maximum emission wavelength in a blue light wavelength region had optical properties suitable for emission of deep blue light.

### Example 1

A glass substrate with a 500 Å-thick indium tin oxide (ITO) electrode (first electrode, anode) formed thereon was cleaned by ultrasonication using DI water. After washing with DI water, ultrasonication was performed thereon using isopropyl alcohol, acetone, and methanol in this stated order, and then, the resultant glass substrate was dried and transferred to a plasma cleaner. The glass substrate was cleaned using oxygen plasma for 5 minutes, and then transferred to a vacuum laminator.

Compound HT3 was vacuum-deposited on the ITO electrode surface of the glass substrate to form a first hole injection layer having a thickness of 3,500 Å, Compound HT-D1 was vacuum-deposited on the first hole injection layer to form a second hole injection layer having a thickness of 300 Å, and TAPC was vacuum-deposited on the second hole injection layer to form an electron blocking layer having a thickness of 100 Å, thereby forming a hole transport region.

Compound H52 as a host and Compound 161 as an emitter were co-deposited at an emitter concentration of 13 wt% on the hole transport region to form an emission layer having a thickness of 300 Å.

Compound ET3 was vacuum-deposited on the emission layer to form an electron transport layer having a thickness of 250 Å, ET-D1 (LiQ) was deposited on the electron transport layer to form an electron injection layer having a thickness of 5 Å, and an Al second electrode (cathode) having a thickness of 1,000 Å was formed on the electron injection layer, thereby completing the manufacture of an organic light-emitting device.

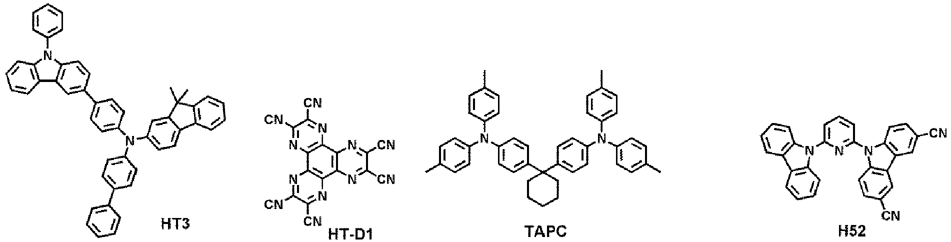

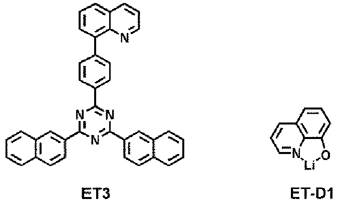

### Example 2 and Comparative Example 1

Organic light-emitting devices were manufactured in a similar manner as in Example 1, except that, in forming an emission layer, for use as an emitter, corresponding compounds shown in Table 3 were used instead of Compound 161.

### Evaluation Example 2: Device evaluation

For each of the organic light-emitting devices manufactured according to Examples 1 and 2 and Comparative Example 1, a maximum emission wavelength (λₘₐₓ, nm), FWHM (nm), CIE color y-coordinate (CIEy), and external quantum efficiency (EQE, %) were evaluated, and results are shown in Table 3. Details for measuring the maximum emission wavelength and the EQE were as follows.

### (1) Measurement of maximum emission wavelength

Regarding the organic light-emitting devices manufactured herein, the maximum emission wavelength results were obtained from electroluminescence (EL) spectra at luminance of 1,000 candela per square meter (cd/m² or nits) by using a luminance meter (Minolta Cs-1000A).

### (2) Measurement of EQE

The EQE results were obtained at luminance of 1,000 cd/m² by using a current-voltmeter (Keithley 2400) and a luminance meter (Minolta Cs-1000A).

**Table 3**

| | Dopant in emission layer | λₘₐₓ (nm) | FWHM (nm) | CIEy | EQE (%) |
|---|---|---|---|---|---|
| Example 1 | 161 | 463 | 28.5 | 0.175 | 18.4 |
| Example 2 | 130 | 463 | 23.8 | 0.166 | 18.6 |
| Comparative Example 1 | C1 | 462 | 34.9 | 0.182 | 17.7 |

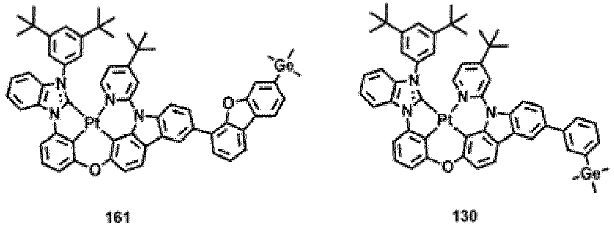

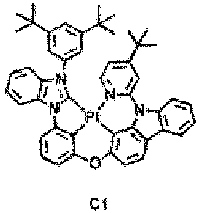

Referring to Table 3, the organic light-emitting devices of Examples 1 and 2 had narrow FWHM and small ClEy and improved EQE, as compared to the organic light-emitting device of Comparative Example 1 using a compound not including a Ge-containing group as an emitter. Accordingly, it was confirmed that the compound of the present disclosure had optical properties suitable for emission of deep blue light.

### Example 3

An organic light-emitting device was manufactured in a similar manner as in Example 1, except that, in forming an emission layer, 1.5 wt% of FD17 was used as an emitter and 10 wt% of Compound 161 was used as a sensitizer.

### Example 4

An organic light-emitting device was manufactured in a similar manner as in Example 1, except that, in forming an emission layer, 1.5 wt% of FD17 was used as an emitter and 10 wt% of Compound 130 was used as a sensitizer.

### Comparative Example 2

An organic light-emitting device was manufactured in a similar manner as in Example 1, except that, in forming an emission layer, 1.5 wt% of FD17 was used as an emitter and 10 wt% of Compound C1 was used as a sensitizer.

### Evaluation Example 3: Device evaluation

For each of the organic light-emitting devices manufactured according to Examples 3 and 4 and Comparative Example 2, a maximum luminescence wavelength (λₘₐₓ, nm), FWHM (nm), and EQE (%) were evaluated, and results are shown in Table 4.

**Table 4**

| | Dopants in emission layer | λₘₐₓ (nm) | FWHM (nm) | EQE(%) |
|---|---|---|---|---|
| Example 3 | 161 FD17 | 463 | 0.133 | 20.477 |
| Example 4 | 130 FD17 | 462 | 0.129 | 20.812 |
| Comparative Example 2 | C1 FD17 | 462 | 0.135 | 20.253 |

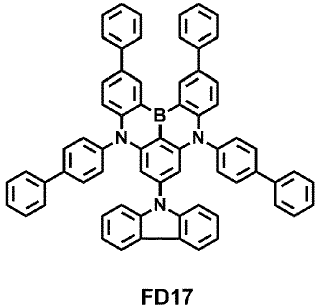

Referring to Table 4, the organic light-emitting devices of Examples 3 and 4 using the organometallic compound according to one or more embodiments as a sensitizer in the emission layer had excellent ClEy color coordinates and slightly increased EQE, as compared to the organic light-emitting device of Comparative Example 2. Accordingly, it was found that, when the organometallic compound according one or more embodiments was applied to the emission layer, the energy transfer to a fluorescent dopant occurred smoothly so that the EQE could be improved.

As described above, according to the one or more embodiments, an organometallic compound represented by Formula 1 exhibits an emission spectrum having a narrow full width at half maximum and a small second peak intensity. Thus, when applied to an organic light-emitting device, emission of deep blue may be implemented by improving color purity.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An organometallic compound, represented by Formula 1: 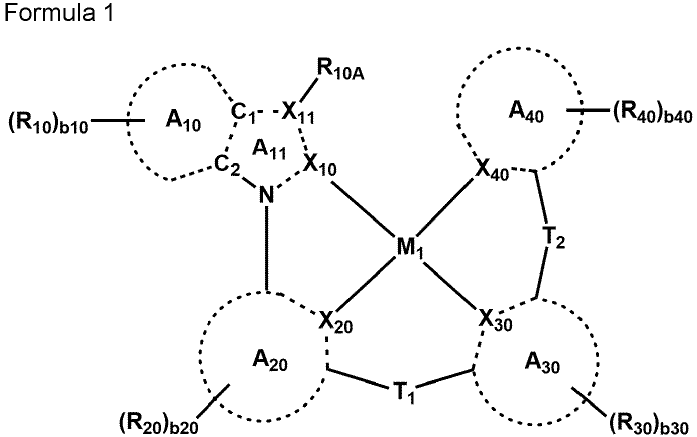 wherein, in Formula 1,
M₁ is a transition metal,
X₁₀, X₁₁, X₂₀, X₃₀, and X₄₀ are each independently C or N, provided that one of X₁₀ and X₁₁ is N, and the other of X₁₀ and X₁₁ is C,
ring A₁₀ is present or absent,
when ring A₁₀ is present, ring A₁₀ is a C₅-C₃₀ carbocyclic group or a C₁-C₃₀ heterocyclic group, wherein each of C₁ and C₂ is C,
when ring A₁₀ is not present, C₁ is C(R₁₁) and C₂ is C(R₁₂),
ring A₁₁ is a pyrazole ring or an imidazole ring,
ring A₂₀, ring A₃₀, and ring A₄₀ are each independently a C₅-C₃₀ carbocyclic group or a C₁-C₃₀ heterocyclic group,
T₁ and T₂ are each independently a single bond, *-N(R₅₁)-*', *-B(R₅₁)-*', *-P(R₅₁)-*', *-C(R₆₁)(R₆₂)-*', *-Si(R₅₁)(R₅₂)-*', *-Ge(R₅₁)(R₅₂)-*', *-S-*', *-Se-*', *-O-*', *-C(=O)-*', *-S(=O)-*', *-S(=O)₂-*', *-C(R₆₁)=C(R₆₂)-*', *-C(=S)-*', or *-C≡C-*',
R₁₀ to R₁₂, R_{10A}, R₂₀, R₃₀, R₄₀, R₅₁, and R₅₂ are each independently a group represented by Formula 2, hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), -P(Q₈)(Q₉), or -P(=O)(Q₈)(Q₉),
two or more of a plurality of R₁₀(s) are optionally linked together to form a substituted or unsubstituted C₅-C₃₀ carbocyclic group or a substituted or unsubstituted C₁-C₃₀ heterocyclic group,
two or more of a plurality of R₂₀(s) are optionally linked together to form a substituted or unsubstituted C₅-C₃₀ carbocyclic group or a substituted or unsubstituted C₁-C₃₀ heterocyclic group,
two or more of a plurality of R₃₀(s) are optionally linked together to form a substituted or unsubstituted C₅-C₃₀ carbocyclic group or a substituted or unsubstituted C₁-C₃₀ heterocyclic group,
two or more of a plurality of R₄₀(s) are optionally linked together to form a substituted or unsubstituted C₅-C₃₀ carbocyclic group or a substituted or unsubstituted C₁-C₃₀ heterocyclic group,
neighboring two or more of R₁₀, R_{10A}, R₂₀, R₃₀, R₄₀, R₅₁, and R₅₂ are optionally linked together to form a substituted or unsubstituted C₅-C₃₀ carbocyclic group or a substituted or unsubstituted C₁-C₃₀ heterocyclic group,
b10, b20, b30, and b40 are each independently an integer from 1 to 10,
at least one of R₁₀, R₁₁, R₁₂, R₂₀, R₃₀, or R₄₀ is a group represented by Formula 2, 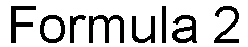 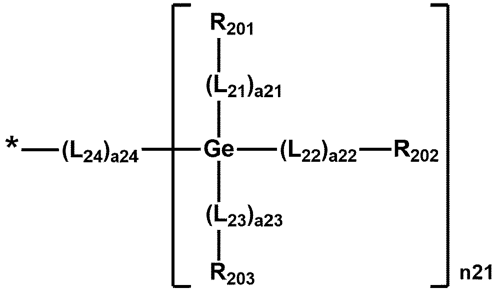 wherein, in Formula 2,
L₂₁ to L₂₄ are each independently a substituted or unsubstituted C₅-C₆₀ carbocyclic group or a substituted or unsubstituted C₁-C₆₀ heterocyclic group,
a21 to a24 are each independently an integer from 0 to 3,
R₂₀₁ to R₂₀₃ are each independently a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group,
n21 is an integer from 1 to 5,
at least one substituent of the substituted C₅-C₆₀ carbocyclic group, the substituted C₁-C₆₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
deuterium, -F, -Cl, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each unsubstituted or substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₆), -B(Q₁₆)(Q₁₇), -P(Q₁₈)(Q₁₉), -P(=O)(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), - Si(Q23)(Q24)(Q25), -B(Q₂₆)(Q₂₇), -P(Q₂₈)(Q₂₉), -P(=O)(Q₂₈)(Q₂₉), or a combination thereof;
-N(Q₃₁)(Q₃₂), -Si(Q₃₃)(Q₃₄)(Q₃₅), -B(Q₃₆)(Q₃₇), -P(Q₃₈)(Q₃₉), or -P(=O)(Q₃₈)(Q₃₉); or
a combination thereof,
Q₁ to Q₉, Q₁₁ to Q₁₉, Q₂₁ to Q₂₉, and Q₃₁ to Q₃₉ are each independently hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each of which is unsubstituted or substituted with at least one of deuterium, a C₁-C₆₀ alkyl group, a C₆-C₆₀ aryl group, or a combination thereof, and
* and *' each indicate a binding site to a neighboring atom.

2. The organometallic compound of claim 1, wherein a moiety represented by: 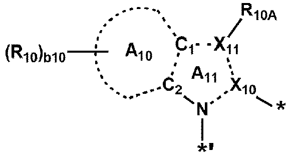 in Formula 1 is represented by one of Formulae A10(1) to A10(4): 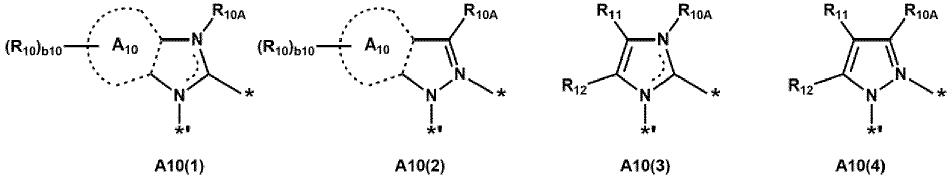
wherein, in Formulae A10(1) to A10(4),
ring A₁₀ is a C₅-C₃₀ carbocyclic group or a C₁-C₃₀ heterocyclic group,
R_{10A}, R₁₀ to R₁₂, and b10 are as defined in claim 1,
two or more of a plurality of R₁₀(s) are optionally linked together to form a substituted or unsubstituted C₅-C₃₀ carbocyclic group or a substituted or unsubstituted C₁-C₃₀ heterocyclic group,
neighboring two or more of R₁₀ and R₁₀ₐ are optionally linked together to form a substituted or unsubstituted C₅-C₃₀ carbocyclic group or a substituted or unsubstituted C₁-C₃₀ heterocyclic group,
* indicates a binding site to M₁, and
*' indicates a binding site to ring A₂₀.

3. The organometallic compound of claims 1 or 2, wherein a moiety represented by: 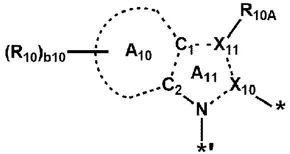 in Formula 1 is represented by Formula A10-1, A10-2, A10(3), or A10(4): 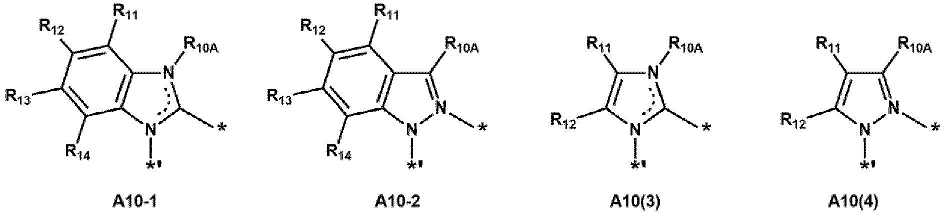
wherein, in Formula A10-1, A10-2, A10(3), and A10(4),
R_{10A}, R₁₁, and R₁₂ are as defined in claim 1,
R₁₃ and R₁₄ are each as defined in connection with R₁₀ in claim 1,
two or more of R₁₁ to R₁₄, and R_{10A} are optionally linked together to form a substituted or unsubstituted C₅-C₃₀ carbocyclic group or a substituted or unsubstituted C₁-C₃₀ heterocyclic group,
* indicates a binding site to M₁ in Formula 1, and
*' indicates a binding site to ring A₂₀ in Formula 1.

4. The organometallic compound of any of claims 1-3, wherein ring A₂₀ in Formula 1 is represented by one of Formulae A20(1) to A20(15): 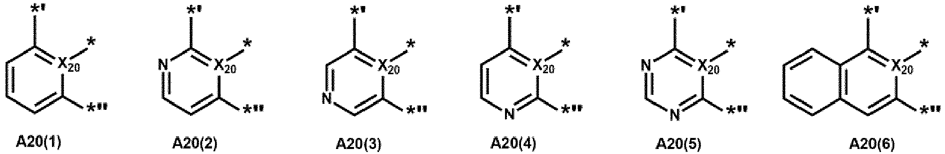 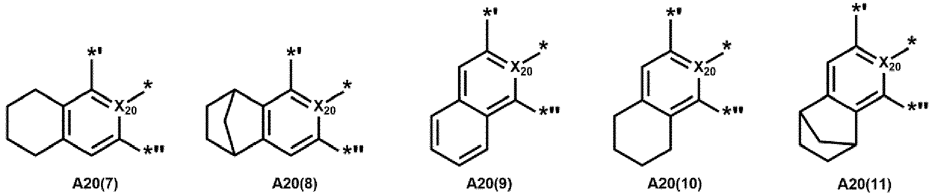 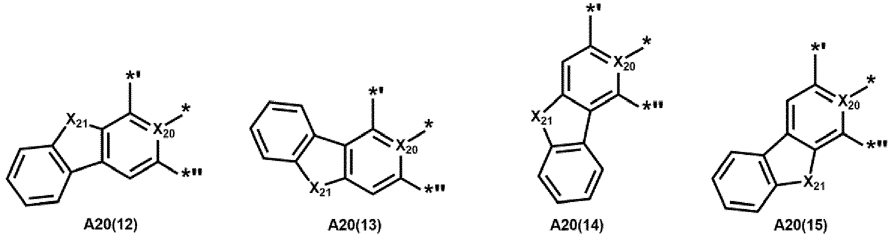
wherein, in Formulae A20(1) to A20(15),
X₂₀ is C or N,
X₂₁ is O, S, N(R₂₆), C(R₂₆)(R₂₇), or Si(R₂₆)(R₂₇), wherein R₂₆ and R₂₇ are as defined in connection with R₂₀ in claim 1,
* indicates a binding site to M₁ in Formula 1,
*' indicates a binding site to N in Formula 1, and
*" indicates a binding site to T₁ in Formula 1; and/or
wherein ring A₃₀ in Formula 1 is represented by one of Formulae A30(1) to A30(12): 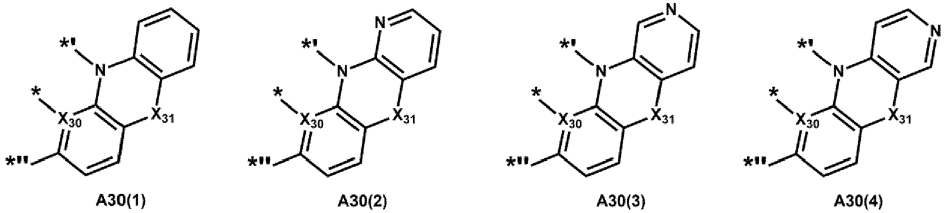 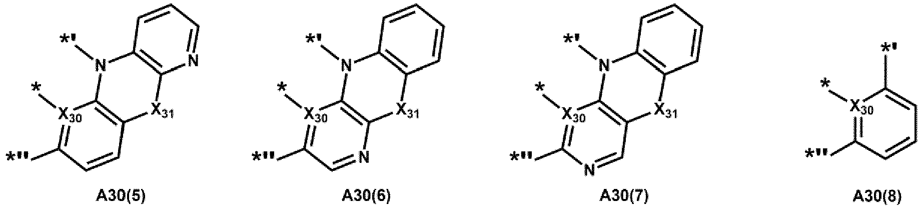 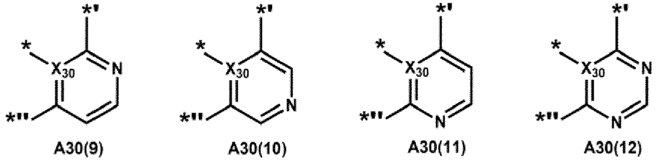
wherein, in Formulae A30(1) to A30(12),
X₃₀ is C or N,
X₃₁ is a single bond, O, S, N(R₃₇), C(R₃₇)(R₃₈), or Si(R₃₇)(R₃₈), wherein R₃₇ and R₃₈ are each as defined in connection with R₃₀ in claim 1,
* indicates a binding site to M₁ in Formula 1,
*' indicates a binding site to T₂ in Formula 1, and
*" indicates a binding site to T₁ in Formula 1.

5. The organometallic compound of any of claims 1-4, wherein ring A₄₀ in Formula 1 is represented by one of Formulae A40(1) to A40(34): 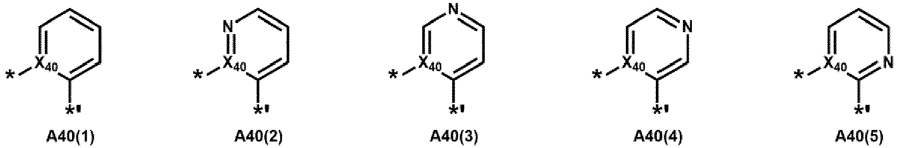 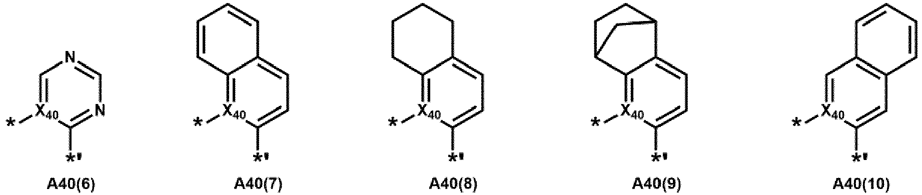 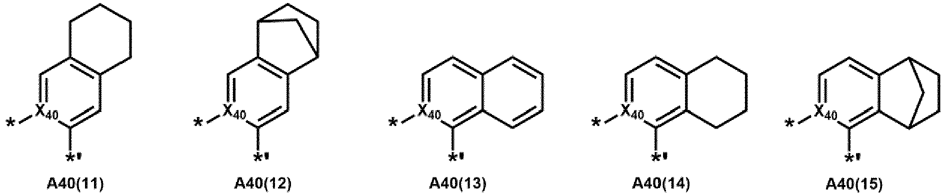 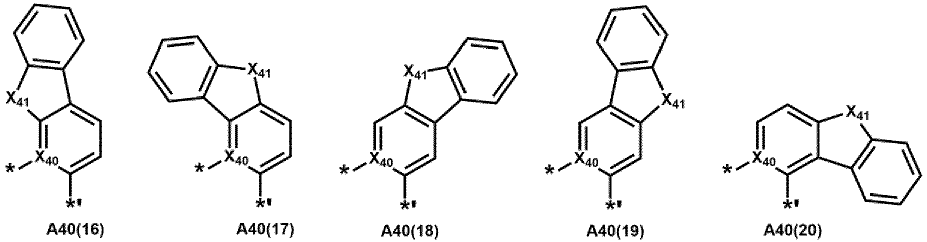 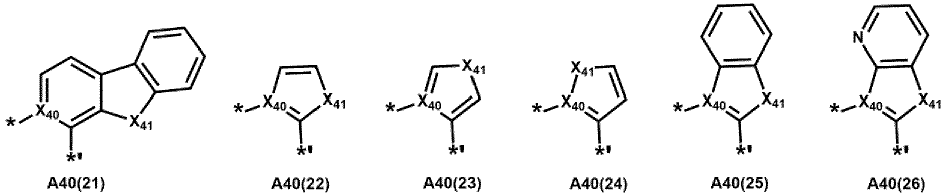 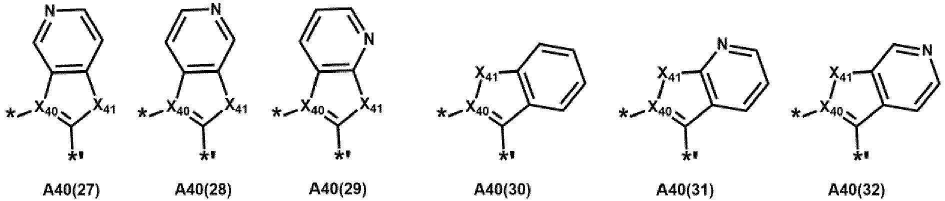 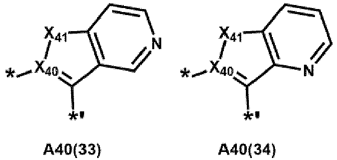
wherein, in Formulae A40(1) to A40(34),
X₄₀ is C or N,
X₄₁ is a single bond, O, S, N(R₄₇), C(R₄₇)(R₄₈), or Si(R₄₇)(R₄₈), wherein R₄₇ and R₄₈ are each as defined in connection with R₄₀ in claim 1,
* indicates a binding site to M₁ in Formula 1, and
*' indicates a binding site to T₂ in Formula 1; and/or
wherein L₂₁ to L₂₄ in Formula 2 are each independently a benzene group, a naphthalene group, an anthracene group, a phenanthrene group, a triphenylene group, a pyrene group, a chrysene group, a cyclopentadiene group, a 1,2,3,4-tetrahydronaphthalene group, a pyrrole group, a thiophene group, a furan group, an indole group, an indene group, a benzothiophene group, a benzofuran group, a carbazole group, a fluorene group, a dibenzofuran group, or a dibenzothiophene group, each unsubstituted or substituted with at least one of deuterium, -F, -Cl, -Br, -I, -CD₃, -CD₂H, - CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a furanyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a benzocarbazolyl group, an imidazopyridinyl group, an imidazopyrimidinyl group, an azacarbazolyl group, an azadibenzofuranyl group, an azadibenzothiophenyl group, -Si(Q₃₃)(Q₃₄)(Q₃₅), or a combination thereof, and
Q₃₃ to Q₃₅ are each independently a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, a C₁-C₁₀ alkyl group, a phenyl group, or a combination thereof.

6. The organometallic compound of any of claims 1-5, wherein a21 to a24 in Formula 2 are each independently 0 or 1; and/or
wherein R₂₀₁ to R₂₀₃ in Formula 2 are each independently:
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with at least one of deuterium, -F, -Cl, -Br, -I, -CD₃, - CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof; or
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, or a pyrimidinyl group, each unsubstituted or substituted with at least one of deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof.

7. The organometallic compound of any of claims 1-6, wherein a group represented by Formula 2 is represented by Formula 2(1): 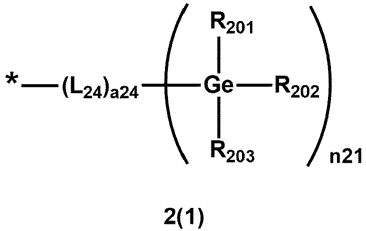 wherein, in Formula 2(1),
L₂₄, R₂₀₁ to R₂₀₃, and n21 are as defined in claim 1,
a24 is 0 or 1, and
* indicates a binding site to a neighboring atom.

8. The organometallic compound of any of claims 1-7, wherein
each group represented by Formula 2 is independently a group represented by one of Formulae 2-1 to 2-4: 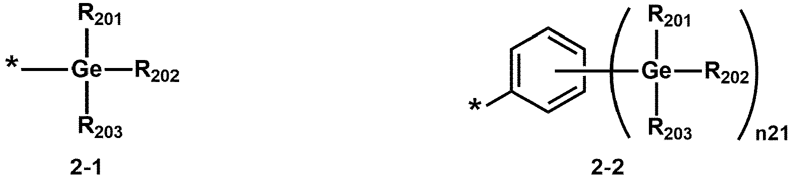 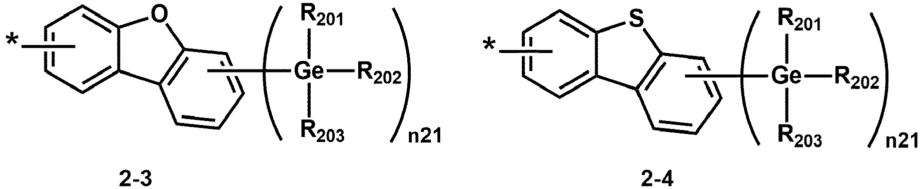
wherein, in Formulae 2-1 to 2-4,
R₂₀₁ to R₂₀₃ and n21 are as defined in claim 1, and
* indicates a binding site to a neighboring atom.

9. The organometallic compound of any of claims 1-8, wherein each group represented by Formula 2 is independently groups represented by one of Formulae 2-101 to 2-134: 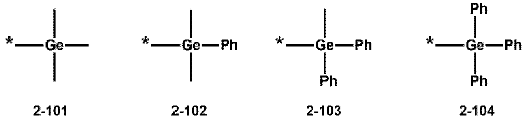 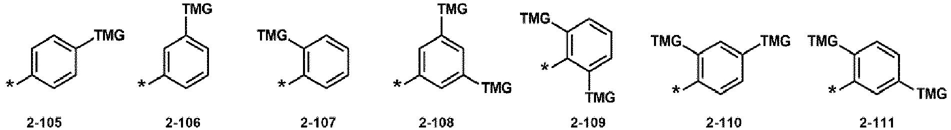 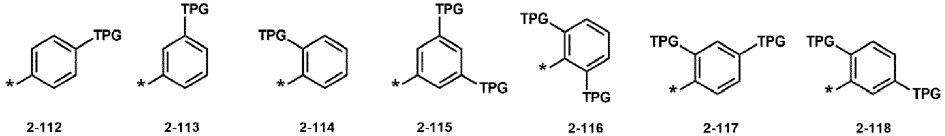 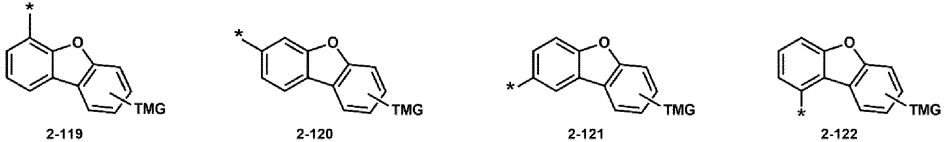 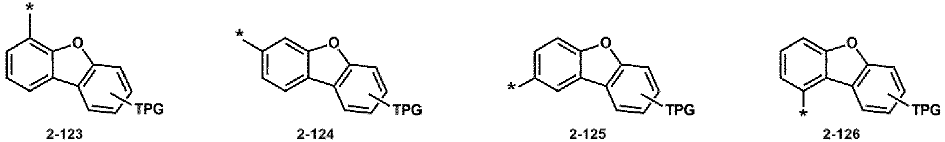 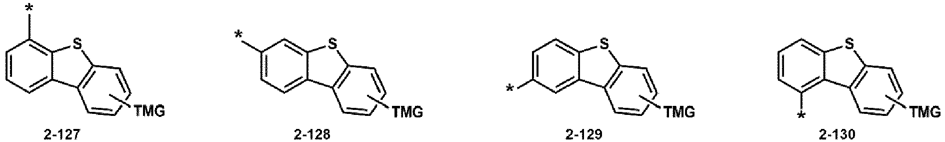 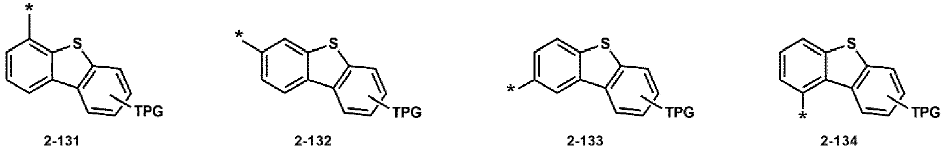 wherein, in Formulae 2-101 to 2-134,
"TMG" is a trimethyl-germyl group,
"TPG" is a triphenyl-germyl group, and
* indicates a binding site to a neighboring atom.

10. The organometallic compound of any of claims 1-9, wherein the organometallic compound is represented by one or more of Formulae 1A to 1D: 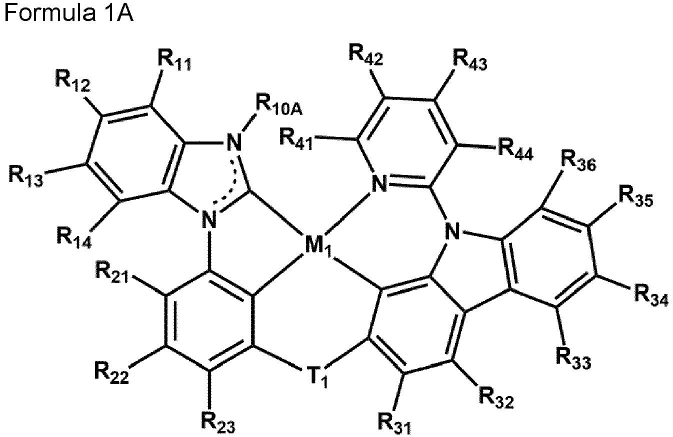 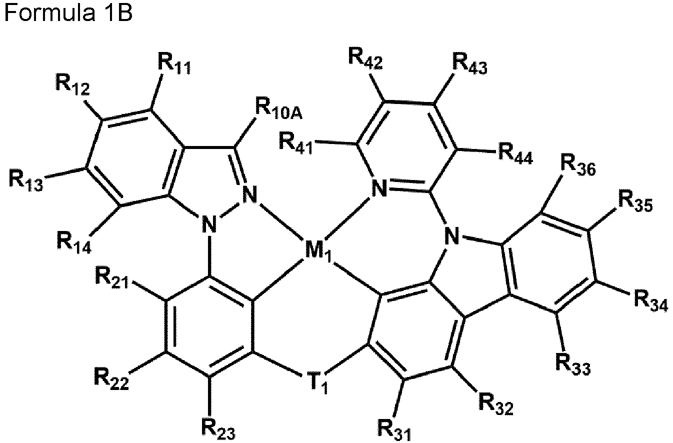 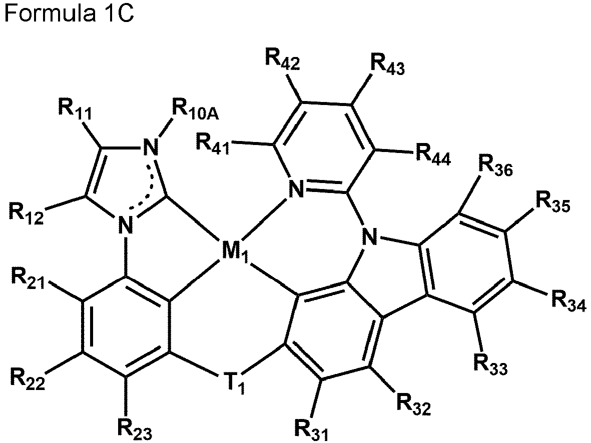 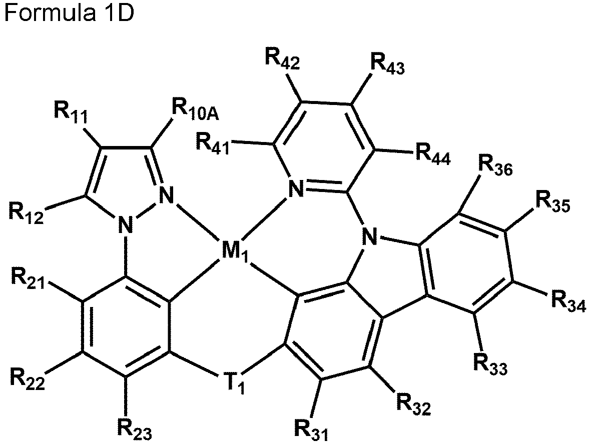 wherein, in Formulae 1A to 1D,
M₁, T₁, R_{10A}, R₁₁, and R₁₂ are as defined in claim 1,
R₁₃ and R₁₄ are each as defined in connection with R₁₀ in claim 1,
R₂₁ to R₂₃ are each as defined in connection with R₂₀ in claim 1,
R₃₁ to R₃₆ are each as defined in connection with R₃₀ in claim 1,
R₄₁ to R₄₄ are each as defined in connection with R₄₀ in claim 1, and
at least one of R₁₁ to R₁₄, R₂₁ to R₂₃, R₃₁ to R₃₆, and R₄₁ to R₄₄ in Formulae 1A and 1B is a group represented by Formula 2, and
at least one of R₁₁, R₁₂, R₂₁ to R₂₃, R₃₁ to R₃₆, and R₄₁ to R₄₄ in Formulae 1C and 1D is a group represented by Formula 2.

11. The organometallic compound of claim 1, wherein the organometallic compound is one or more of Compounds 1 to 218: 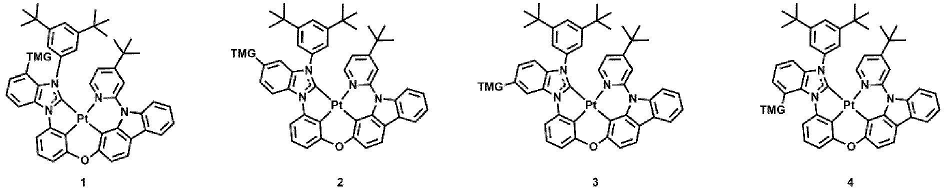 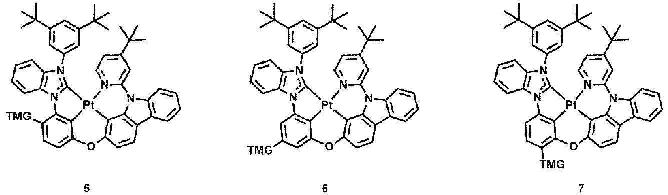 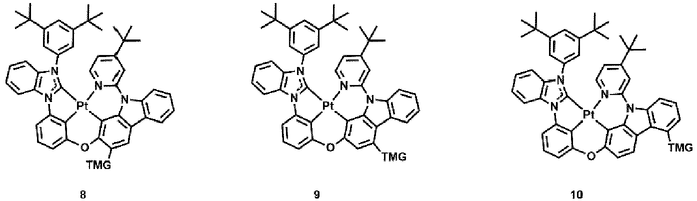 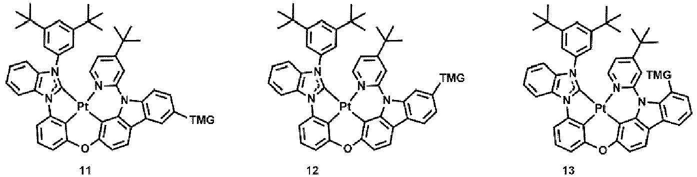 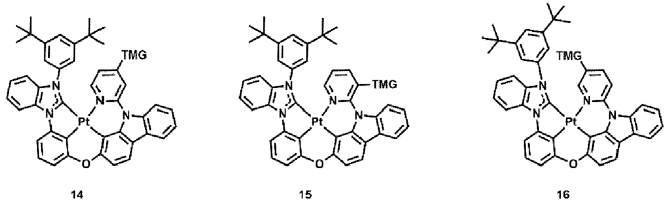 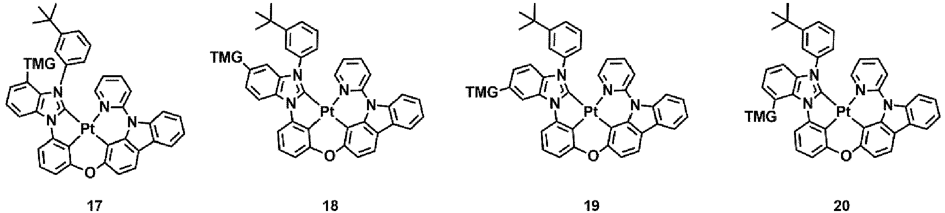 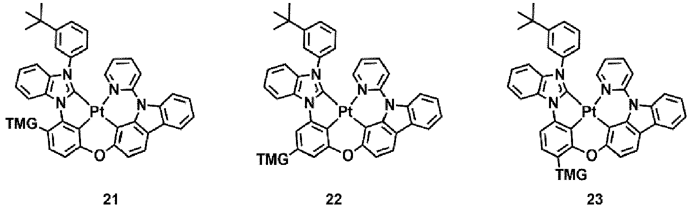 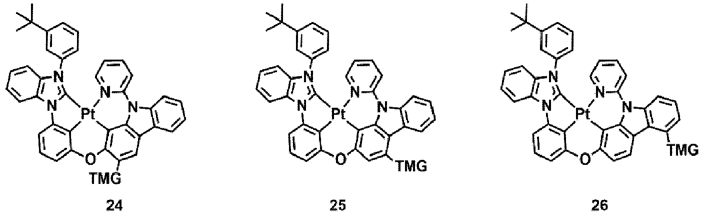 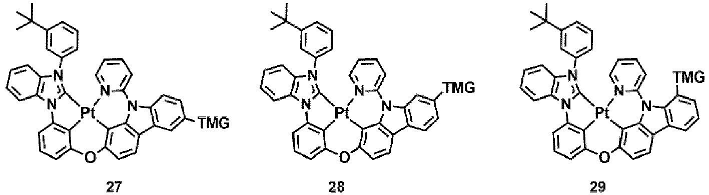 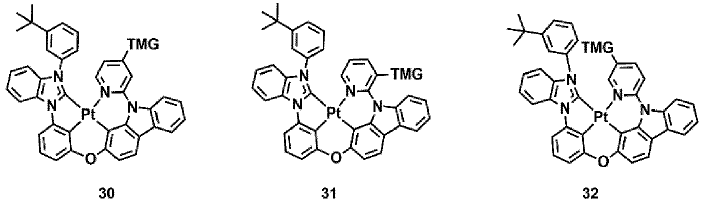 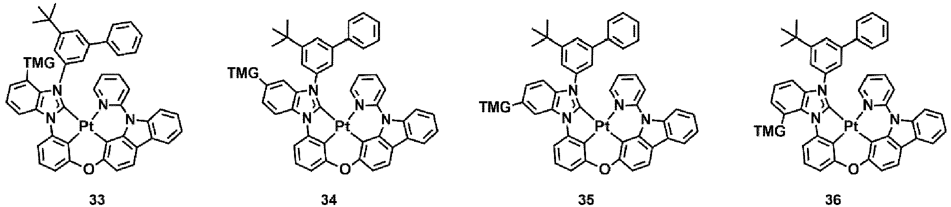 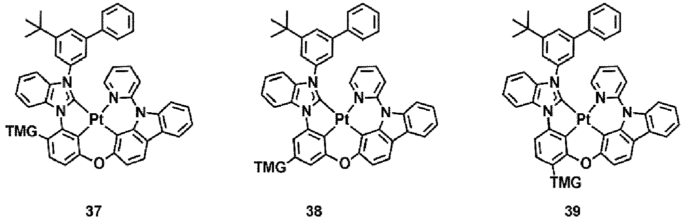 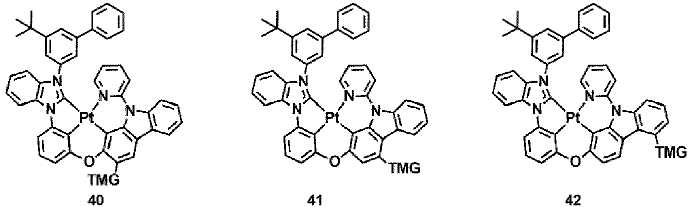 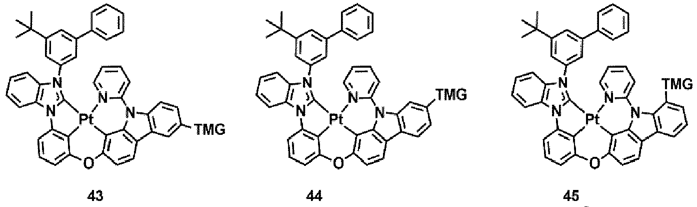 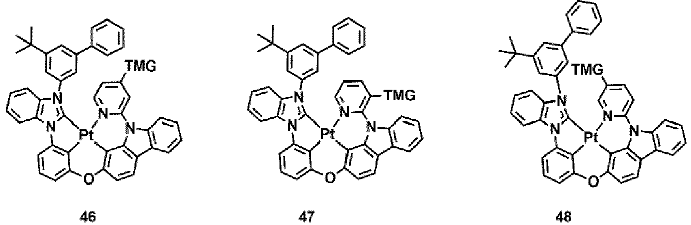 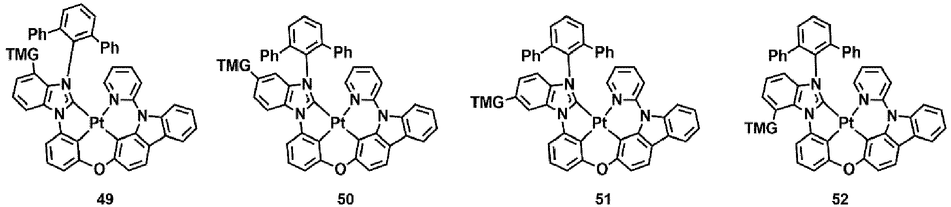 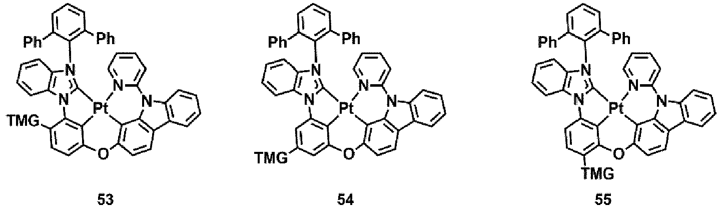 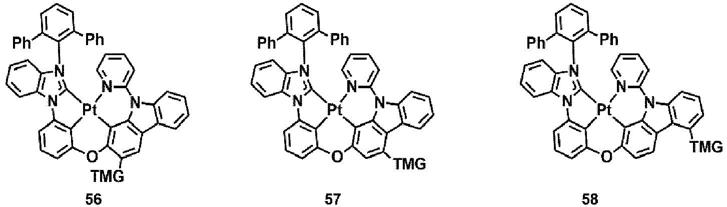 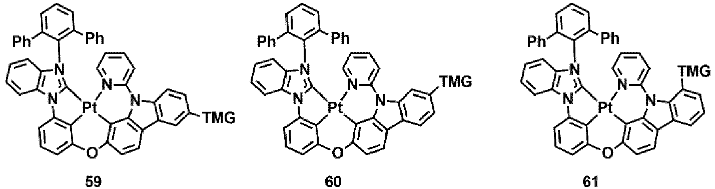 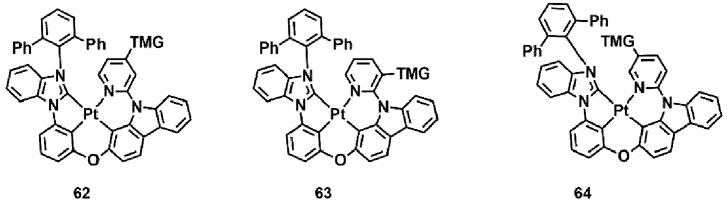 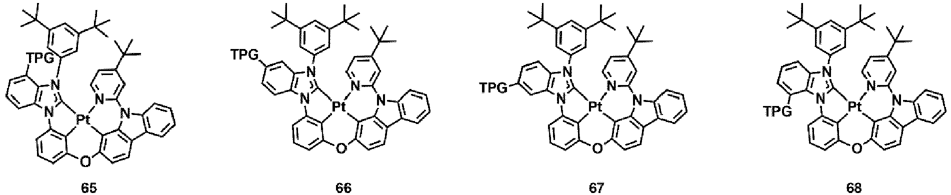 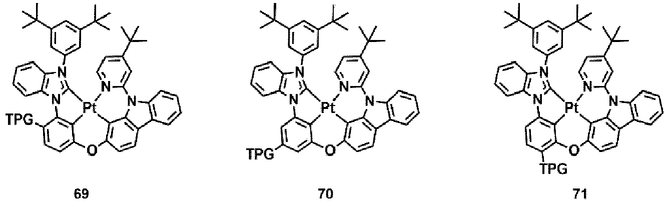 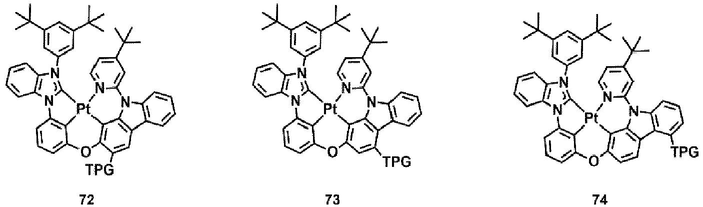 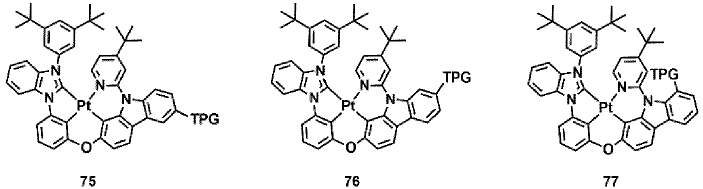 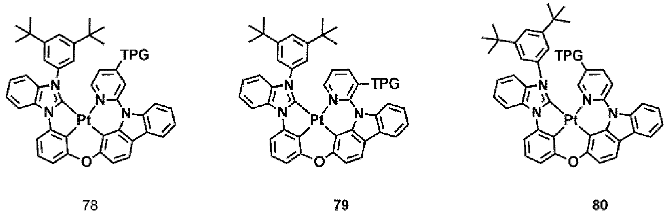 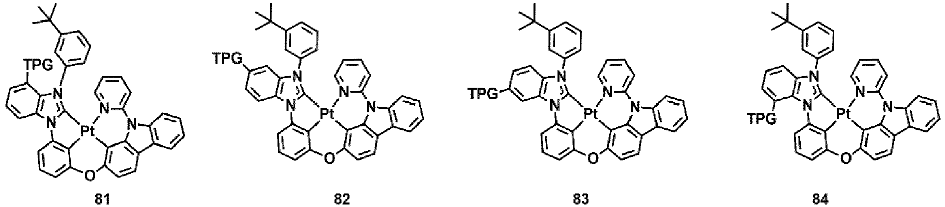 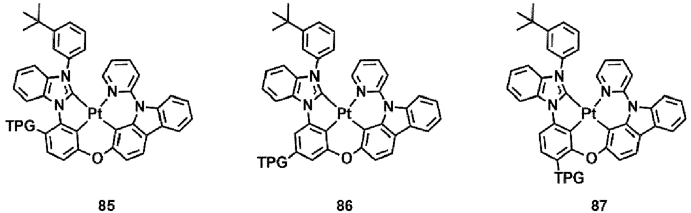 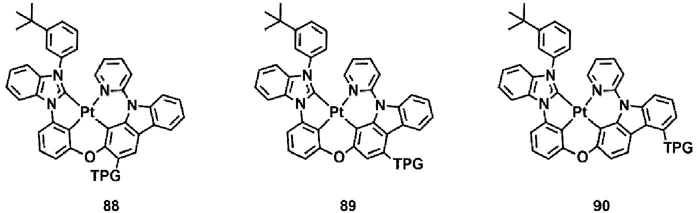 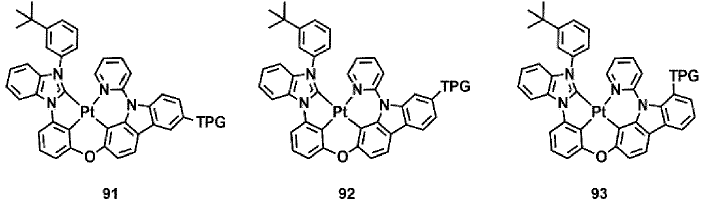 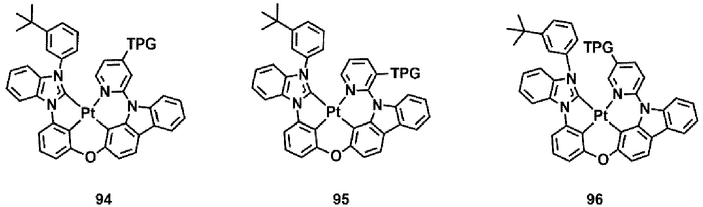 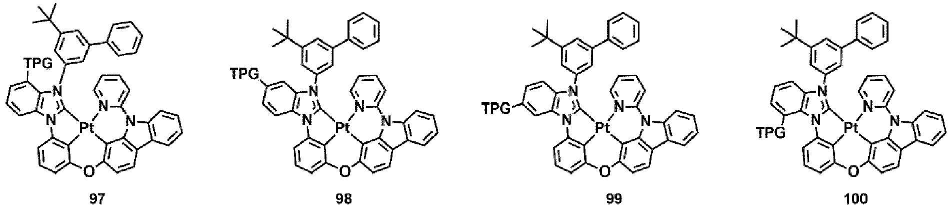 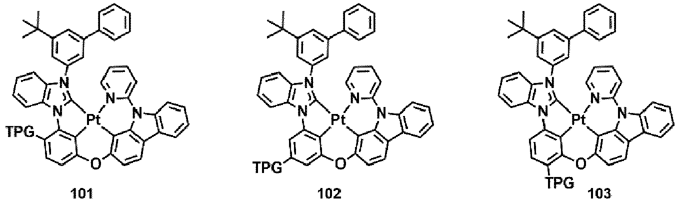 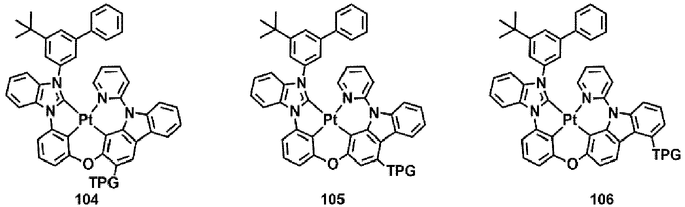 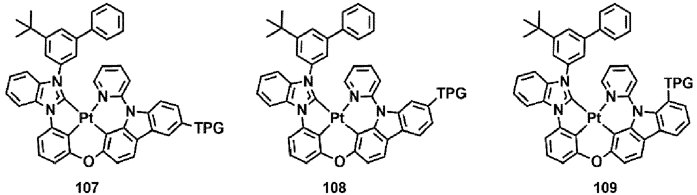 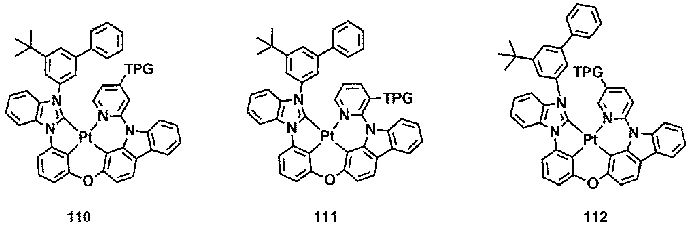 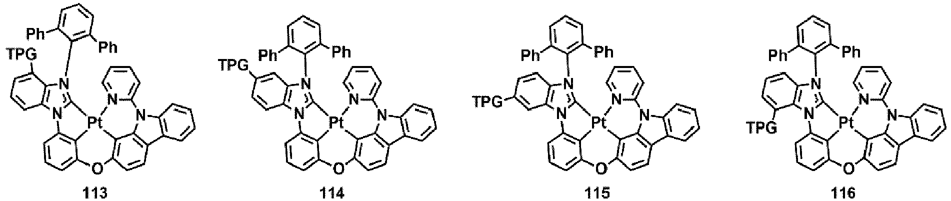 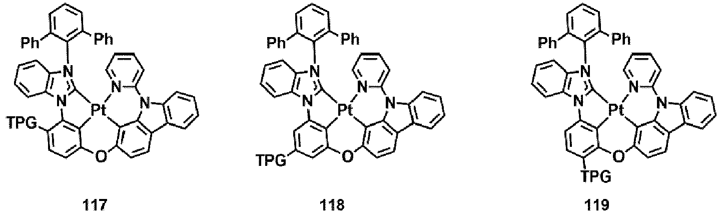 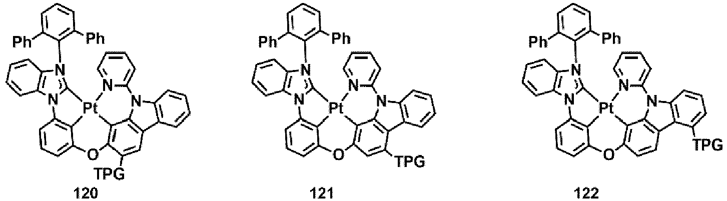 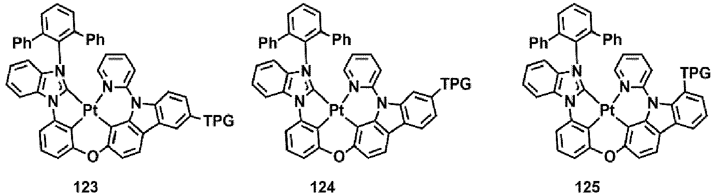 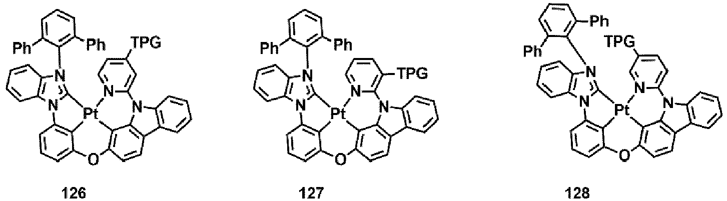 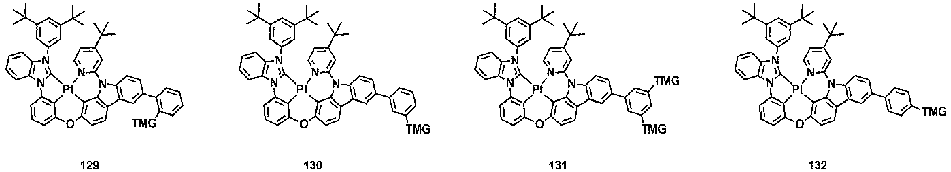 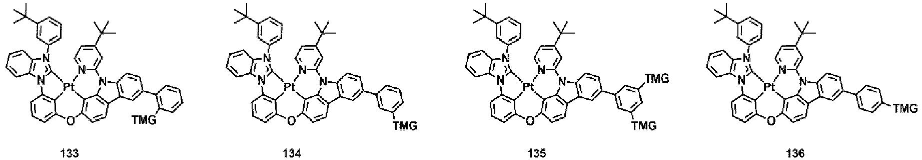 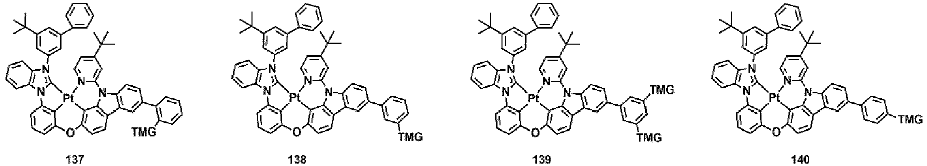 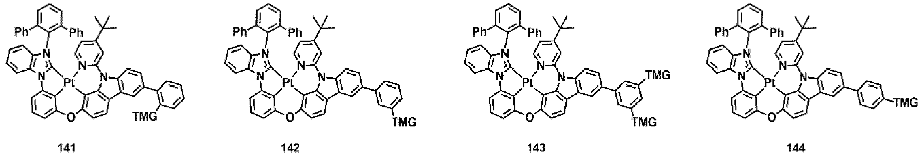 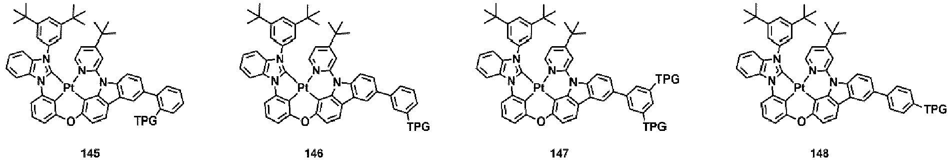 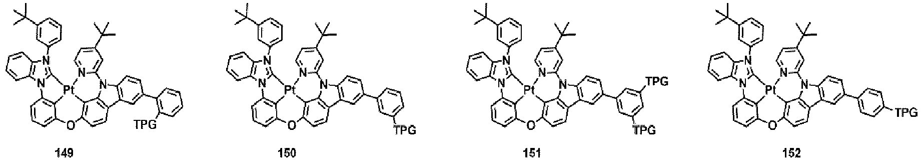 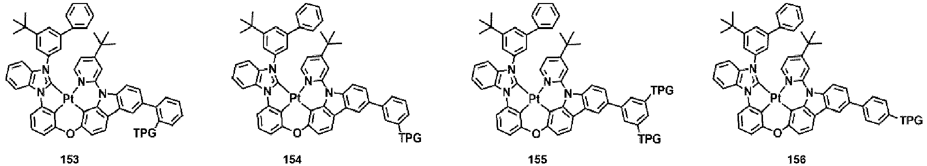 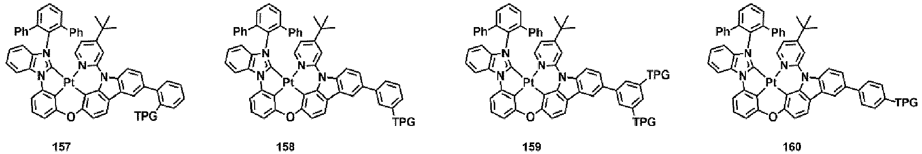 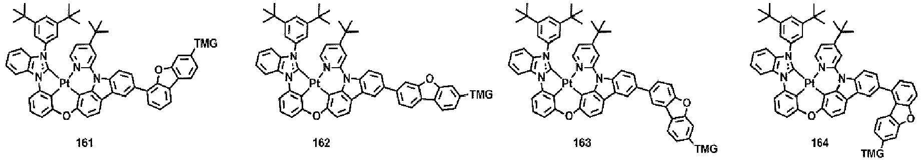 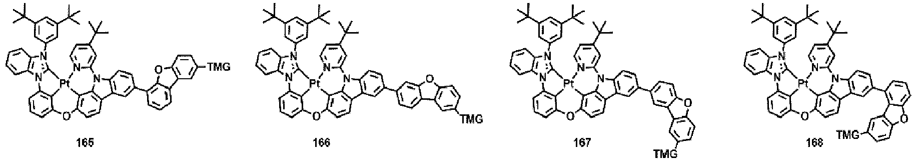 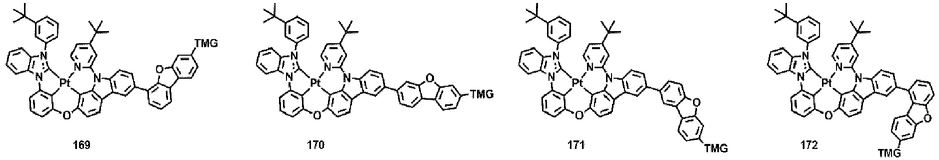 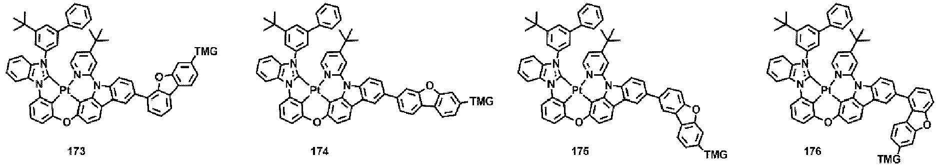 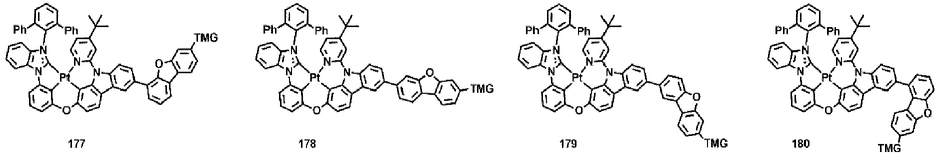 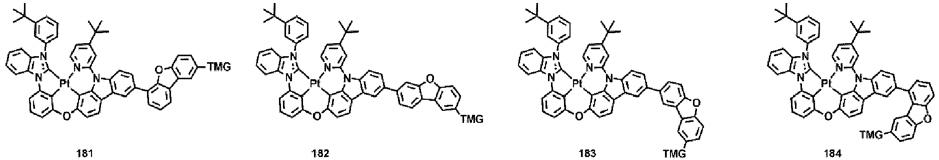 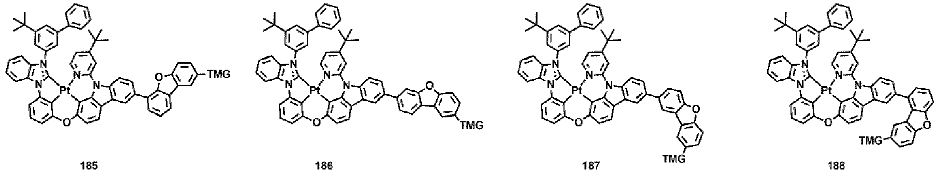 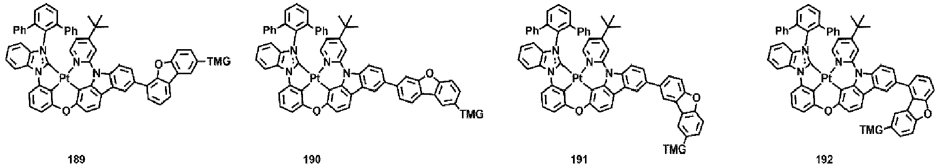 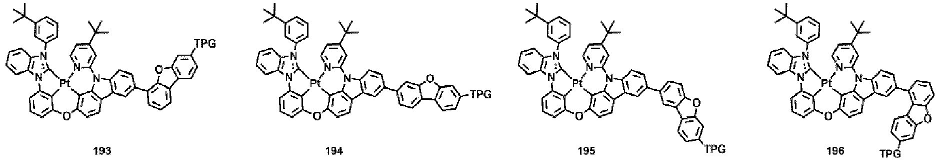 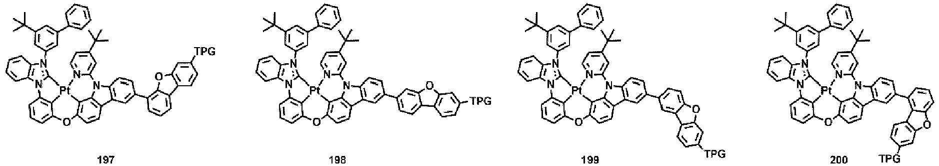 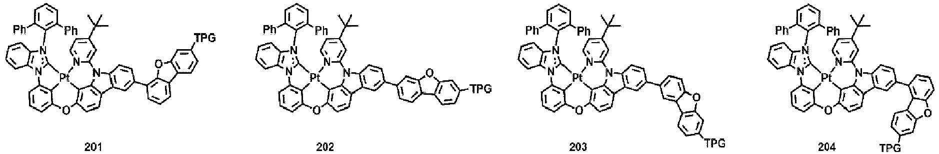 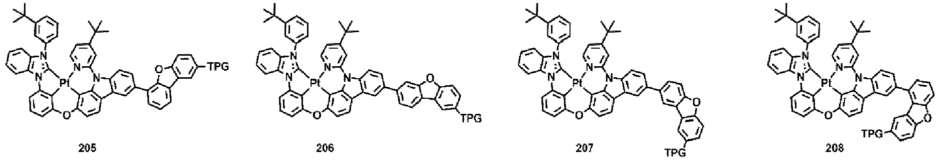 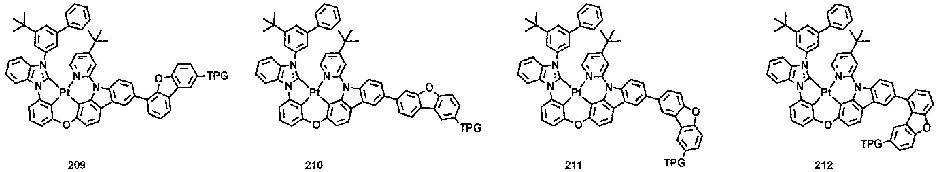 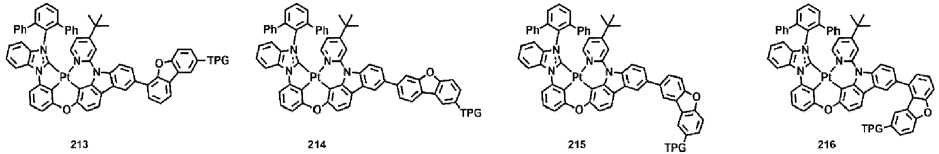 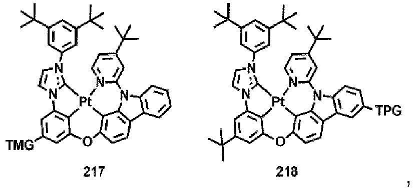 wherein "TMG" is a trimethyl-germyl group, and "TPG" is a triphenyl-germyl group.

12. An organic light-emitting device, comprising:
a first electrode;
a second electrode; and
an organic layer arranged between the first electrode and the second electrode,
wherein the organic layer comprises an emission layer, and
wherein the organic layer further comprises at least one organometallic compound of any of claims 1-11.

13. The organic light-emitting device of claim 12, wherein the emission layer comprises the at least one organometallic compound.

14. The organic light-emitting device of claim 13, wherein the emission layer further comprises a host, and an amount of the host in the emission layer is greater than an amount of the at least one organometallic compound in the emission layer; and/or
wherein the emission layer emits blue light having a maximum emission wavelength in a range of 410 nanometers to 490 nanometers; and/or
wherein at least 80% of total luminescence emission from the emission layer is derived from the at least one organometallic compound.

15. The organic light-emitting device of any of claims 12-14, wherein
the first electrode is an anode,
the second electrode is a cathode,
the organic layer further comprises a hole transport region arranged between the first electrode and the emission layer, and an electron transport region arranged between the emission layer and the second electrode,
the hole transport region comprises a hole injection layer, a hole transport layer, an electron blocking layer, a buffer layer, or a combination thereof, and
the electron transport region comprises a hole blocking layer, an electron transport layer, an electron injection layer, or a combination thereof.

## Patentansprüche

1. Organometallische Verbindung, dargestellt durch Formel 1: 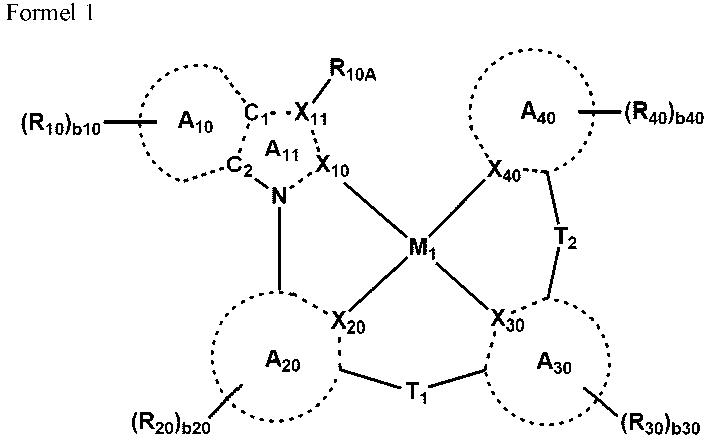 wobei in Formel 1
M₁ ein Übergangsmetall ist,
X₁₀, X₁₁, X₂₀, X₃₀ und X₄₀ jeweils unabhängig C oder N sind, vorausgesetzt, dass eines von X₁₀ und X₁₁ N ist und das andere von X₁₀ und Xu C ist,
Ring A₁₀ vorhanden ist oder fehlt,
wenn Ring A₁₀ vorhanden ist, Ring A₁₀ eine carbocyclische C₅-C₃₀-Gruppe oder eine heterocyclische C₁-C₃₀-Gruppe ist, wobei jedes von C₁ und C₂ C ist,
wenn Ring A₁₀ nicht vorhanden ist, C₁ C(Rn) ist und C₂ C(R₁₂) ist,
Ring An ein Pyrazolring oder ein Imidazolring ist,
Ring A₂₀, Ring A₃₀ und Ring A₄₀ jeweils unabhängig eine carbocyclische C₅-C₅₀-Gruppe oder eine heterocyclische C₁-C₃₀-Gruppe sind,
T₁ und T₂ jeweils unabhängig eine Einfachbindung, *-N(Rsi)-*', *-B(Rsi)-*', *-P(R₅₁)-*', *-C(R₅₁)(R₅₂)-*', *-Si(R₅₁)(R₅₂)-*', *-Ge(R₅₁)(R₅₂)-*', *-S-*', *-Se-*', *-O-*', *-C(=O)-*', *-S(=O)-*', *-S(=O)₂-*', *-C(R₅₁)=C(R₅₂)-*', *-C(=S)-*' oder *-C≡C-*' sind,
R₁₀ bis R₁₂, R_{10A}, R₂₀, R₃₀, R₄₀, R₅₁ und R₅₂ jeweils unabhängig eine durch Formel 2 dargestellte Gruppe, Wasserstoff, Deuterium, -F, -Cl, -Br, -I, -SF₅, eine Hydroxylgruppe, eine Cyanogruppe, eine Nitrogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Alkylheteroarylgruppe, eine substituierte oder unsubstituierte C₂-C₆₀-Heteroarylalkylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte monovalente nicht aromatische kondensierte polycyclische Gruppe, eine substituierte oder unsubstituierte monovalente nicht aromatische kondensierte heteropolycyclische Gruppe, -N(Q₁)(Q₂), -Si(Q₃)(Q₄)(Q₅), -B(Q₆)(Q₇), -P(Q₈)(Q₉) oder - P(=O)(Q₈)(Q₉) sind,
zwei oder mehr einer Vielzahl von R₁₀(s) optional miteinander verbunden sind, um eine substituierte oder unsubstituierte carbocyclische C₅-C₃₀-Gruppe oder eine substituierte oder unsubstituierte heterocyclische C₁-C₃₀-Gruppe zu bilden,
zwei oder mehr einer Vielzahl von R₂₀(s) optional miteinander verbunden sind, um eine substituierte oder unsubstituierte carbocyclische C₅-C₃₀-Gruppe oder eine substituierte oder unsubstituierte heterocyclische C₁-C₃₀-Gruppe zu bilden,
zwei oder mehr einer Vielzahl von R₃₀(s) optional miteinander verbunden sind, um eine substituierte oder unsubstituierte carbocyclische C₅-C₃₀-Gruppe oder eine substituierte oder unsubstituierte heterocyclische C₁-C₃₀-Gruppe zu bilden,
zwei oder mehr einer Vielzahl von R₄₀(s) optional miteinander verbunden sind, um eine substituierte oder unsubstituierte carbocyclische C₅-C₃₀-Gruppe oder eine substituierte oder unsubstituierte heterocyclische C₁-C₃₀-Gruppe zu bilden,
benachbarte zwei oder mehr von R₁₀, R_{10A}, R₂₀, R₃₀, R₄₀, R₅₁ und R₅₂ optional miteinander verbunden sind, um eine substituierte oder unsubstituierte carbocyclische C₅-C₃₀-Gruppe oder eine substituierte oder unsubstituierte heterocyclische C₁-C₃₀-Gruppe zu bilden,
b10, b20, b30 und b40 jeweils unabhängig eine ganze Zahl von 1 bis 10 sind,
mindestens eines von R₁₀, R₁₁, R₁₂, R₂₀, R₃₀ oder R₄₀ eine durch Formel 2 dargestellte Gruppe ist, 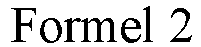 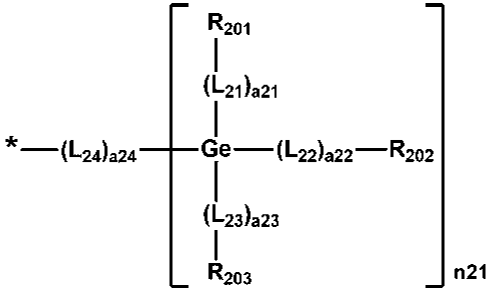 wobei in Formel 2
L₂₁ bis L₂₄ jeweils unabhängig eine substituierte oder unsubstituierte carbocyclische C₅-C₆₀-Gruppe oder eine substituierte oder unsubstituierte heterocyclische C₁-C₆₀-Gruppe sind,
a21 bis a24 jeweils unabhängig eine ganze Zahl von 0 bis 3 sind,
R₂₀₁ bis R₂₀₃ jeweils unabhängig eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Heteroarylalkylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte monovalente nicht aromatische kondensierte polycyclische Gruppe oder eine substituierte oder unsubstituierte monovalente nicht aromatische kondensierte heteropolycyclische Gruppe sind,
n21 eine ganze Zahl von 1 bis 5 ist,
mindestens ein Substituent der substituierten carbocyclischen C₅-C₆₀-Gruppe, der substituierten heterocyclischen C₁-C₆₀-Gruppe, der substituierten C₁-C₆₀-Alkylgruppe, der substituierten C₂-C₆₀-Alkenylgruppe, der substituierten C₂-C₆₀-Alkinylgruppe, der substituierten C₁-C₆₀-Alkoxygruppe, der substituierten C₁-C₆₀-Alkylthiogruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₇-C₆₀-Alkylarylgruppe, der substituierten C₇-C₆₀-Arylalkylgruppe, der substituierten C₆-C₆₀-Aryloxygruppe, der substituierten C₆-C₆₀-Arylthiogruppe, der substituierten C₁-C₆₀-Heteroarylgruppe, der substituierten C₂-C₆₀-Alkylheteroarylgruppe, der substituierten C₂-C₆₀-Heteroarylalkylgruppe, der substituierten C₁-C₆₀-Heteroaryloxygruppe, der substituierten C₁-C₆₀-Heteroarylthiogruppe, der substituierten monovalenten nicht aromatischen kondensierten polycyclischen Gruppe und der substituierten monovalenten nicht aromatischen kondensierten heteropolycyclischen Gruppe Folgendes ist:
Deuterium, -F, -Cl, -Br, -I, -SF₅, -CD₃, -CD₂H, -CDH₂, -CF₃, -CF₂H, -CFH₂, eine Hydroxylgruppe, eine Cyanogruppe, eine Nitrogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe;
eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe, jeweils unsubstituiert oder substituiert mit mindestens einem von Deuterium, -F, -Cl, -Br, -I, -SF₅, -CD₃, -CD₂H, -CDH₂, -CF₃, -CF₂H, - CFH₂, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer C₁-C₆₀-Heteroaryloxygruppe, einer C₁-C₆₀-Heteroarylthiogruppe, einer monovalenten nicht aromatischen kondensierten polycyclischen Gruppe, einer monovalenten nicht aromatischen kondensierten heteropolycyclischen Gruppe, -N(Q₁₁)(Q₁₂), -Si(Q₁₃)(Q₁₄)(Q₁₅), -B(Q₁₆)(Q₁₇), -P(Q₁₈)(Q₁₉), - P(=O)(Q₁₈)(Q₁₉) oder einer Kombination davon;
eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₇-C₆₀-Alkylarylgruppe, eine C₆-C₆₀-Aryloxygruppe, eine C₆-C₆₀-Arylthiogruppe, eine C₁-C₆₀-Heteroarylgruppe, eine C₂-C₆₀-Alkylheteroarylgruppe, eine C₁-C₆₀-Heteroaryloxygruppe, eine C₁-C₆₀-Heteroarylthiogruppe, eine monovalente nicht aromatische kondensierte polycyclische Gruppe oder eine monovalente nicht aromatische kondensierte heteropolycyclische Gruppe, jeweils unsubstituiert oder substituiert mit mindestens einem von Deuterium, -F, -Cl, -Br, -I, -SF₅, -CD₃, -CD₂H, -CDH₂, -CF₃, -CF₂H, -CFH₂, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₁-C₆₀-Alkylthiogruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₇-C₆₀-Arylalkylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer C₂-C₆₀-Heteroarylalkylgruppe, einer C₁-C₆₀-Heteroaryloxygruppe, einer C₁-C₆₀-Heteroarylthiogruppe, einer monovalenten nicht aromatischen kondensierten polycyclischen Gruppe, einer monovalenten nicht aromatischen kondensierten heteropolycyclischen Gruppe, - N(Q₂₁)(Q₂₂), -Si(Q₂₃)(Q₂₄)(Q₂₅), -B(Q₂₆)(Q₂₇), -P(Q₂₈)(Q₂₉), -P(=O)(Q₂₈)(Q₂₉) oder einer Kombination davon;
-N(Q₃₁)(Q₃₂), -Si(Q₃₃)(Q₃₄)(Q₃₅), -B(Q₃₆)(Q₃₇), -P(Q₃₈)(Q₃₉) oder -P(=O)(Q₃₈)(Q₃₉); oder
eine Kombination davon,
Q₁ bis Q₉, Q₁₁ bis Q₁₉, Q₂₁ bis Q₂₉ und Q₃₁ bis Q₃₉ jeweils unabhängig Wasserstoff, Deuterium, -F, -Cl, -Br, -I, -SF₅, eine Hydroxylgruppe, eine Cyanogruppe, eine Nitrogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine C₁-C₆₀-Alkylgruppe, eine C₂-C₆₀-Alkenylgruppe, eine C₂-C₆₀-Alkinylgruppe, eine C₁-C₆₀-Alkoxygruppe, eine C₁-C₆₀-Alkylthiogruppe, eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₇-C₆₀-Alkylarylgruppe, eine C₇-C₆₀-Arylalkylgruppe, eine C₆-C₆₀-Aryloxygruppe, eine C₆-C₆₀-Arylthiogruppe, eine C₁-C₆₀-Heteroarylgruppe, eine C₂-C₆₀-Alkylheteroarylgruppe, eine C₂-C₆₀-Heteroarylalkylgruppe, eine C₁-C₆₀-Heteroaryloxygruppe, eine C₁-C₆₀-Heteroarylthiogruppe, eine monovalente nicht aromatische kondensierte polycyclische Gruppe oder eine monovalente nicht aromatische kondensierte heteropolycyclische Gruppe sind, wobei jedes davon unsubstituiert oder substituiert mit mindestens einem von Deuterium, einer C₁-C₆₀-Alkylgruppe, einer C₆-C₆₀-Arylgruppe oder einer Kombination davon ist, und
* und *' jeweils eine Bindungsstelle zu einem benachbarten Atom angeben.

2. Organometallische Verbindung nach Anspruch 1, wobei ein durch Folgendes dargestellter Anteil: 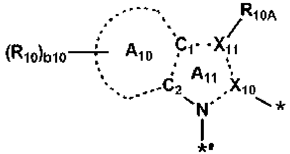
in Formel 1 durch eine von Formel A10(1) bis A10(4) dargestellt ist: 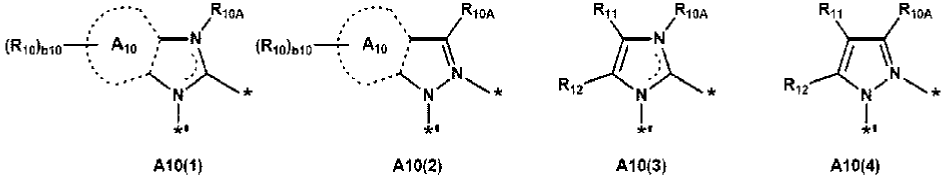
wobei in Formel A10(1) bis A10(4)
Ring A₁₀ eine carbocyclische C₅-C₃₀-Gruppe oder eine heterocyclische C₁-C₃₀-Gruppe ist,
R_{10A}, R₁₀ bis R₁₂ und b10 wie in Anspruch 1 definiert sind,
zwei oder mehr einer Vielzahl von R₁₀(s) optional miteinander verbunden sind, um eine substituierte oder unsubstituierte carbocyclische C₅-C₃₀-Gruppe oder eine substituierte oder unsubstituierte heterocyclische C₁-C₃₀-Gruppe zu bilden,
benachbarte zwei oder mehr von R₁₀ und R₁₀ₐ optional miteinander verbunden sind, um eine substituierte oder unsubstituierte carbocyclische C₅-C₃₀-Gruppe oder eine substituierte oder unsubstituierte heterocyclische C₁-C₃₀-Gruppe zu bilden,
* eine Bindungsstelle zu M₁ angibt und
*' eine Bindungsstelle zu Ring A₂₀ angibt.

3. Organometallische Verbindung nach Anspruch 1 oder 2, wobei ein durch Folgendes dargestellter Anteil: 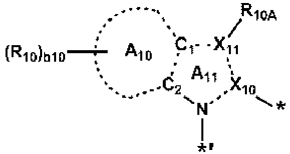
in Formel 1 durch Formel A10-1, A10-2, A10(3) oder A10(4) dargestellt ist: 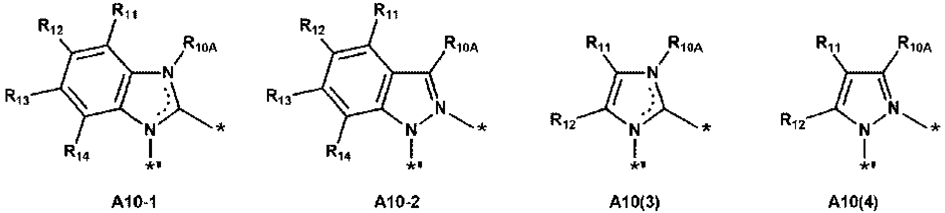
wobei in Formel A10-1, A10-2, A10(3) und A10(4)
R_{10A}, R₁₁ und R₁₂ wie in Anspruch 1 definiert sind,
R₁₃ und R₁₄ jeweils wie in Verbindung mit R₁₀ in Anspruch 1 definiert sind,
zwei oder mehr von R₁₁ bis R₁₄ und R_{10A} optional miteinander verbunden sind, um eine substituierte oder unsubstituierte carbocyclische C₅-C₃₀-Gruppe oder eine substituierte oder unsubstituierte heterocyclische C₁-C₃₀-Gruppe zu bilden,
* eine Bindungsstelle zu M₁ in Formel 1 angibt und
*' eine Bindungsstelle zu Ring A₂₀ in Formel 1 angibt.

4. Organometallische Verbindung nach einem der Ansprüche 1-3, wobei Ring A₂₀ in Formel 1 durch eine von Formel A20(1) bis A20(15) dargestellt ist: 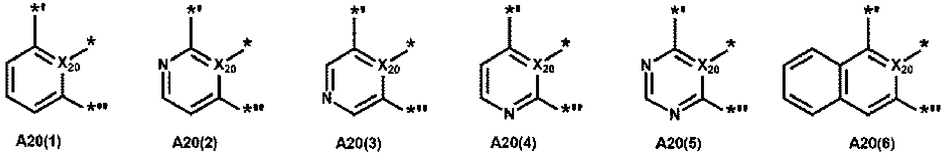 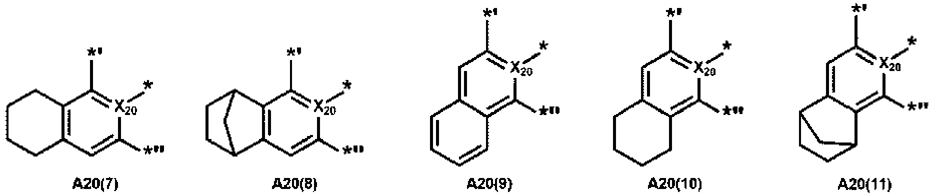 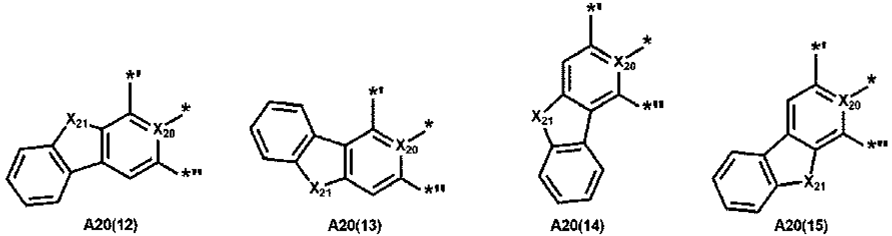
wobei in Formel A20(1) bis A20(15)
X₂₀ C oder N ist,
X₂₁ O, S, N(R₂₆), C(R₂₆)(R₂₇) oder Si(R₂₆)(R₂₇) ist, wobei R₂₆ und R₂₇ wie in Verbindung mit R₂₀ in Anspruch 1 definiert sind,
* eine Bindungsstelle zu M₁ in Formel 1 angibt,
*' eine Bindungsstelle zu N in Formel 1 angibt und
*" eine Bindungsstelle zu T₁ in Formel 1 angibt; und/oder
wobei Ring A₃₀ in Formel 1 durch eine von Formel A30(1) bis A30(12) dargestellt ist: 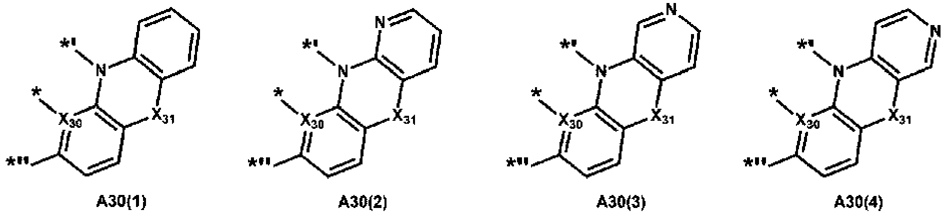 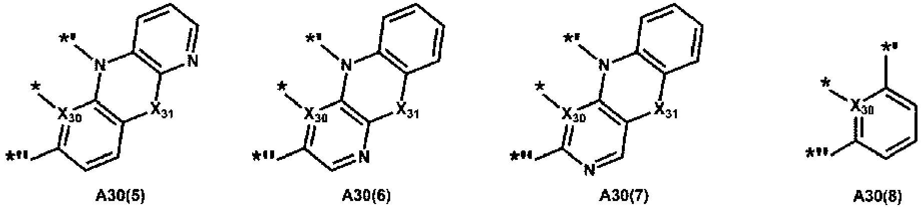 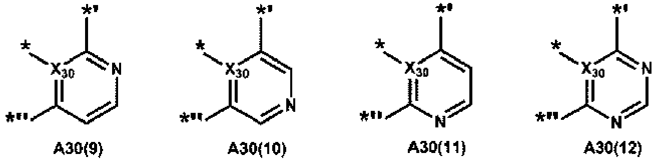
wobei in Formel A30(1) bis A30(12)
X₃₀ C oder N ist,
X₃₁ eine Einfachbindung, O, S, N(R₃₇), C(R₃₇)(R₃₈) oder Si(R₃₇)(R₃₈) ist, wobei R₃₇ und R₃₈ jeweils wie in Verbindung mit R₃₀ in Anspruch 1 definiert sind,
* eine Bindungsstelle zu M₁ in Formel 1 angibt,
*' eine Bindungsstelle zu T₂ in Formel 1 angibt und
*" eine Bindungsstelle zu T₁ in Formel 1 angibt.

5. Organometallische Verbindung nach einem der Ansprüche 1-4, wobei Ring A₄₀ in Formel 1 durch eine von Formel A40(1) bis A40(34) dargestellt ist: 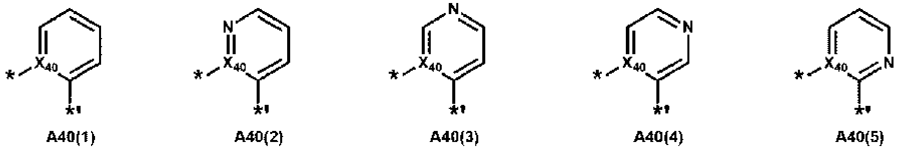 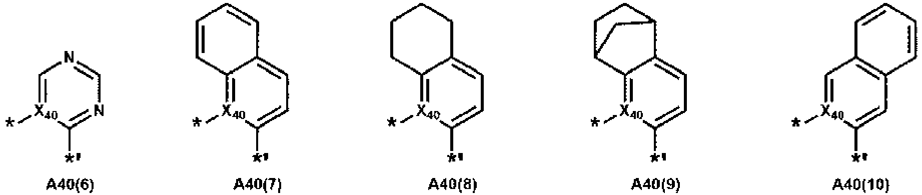 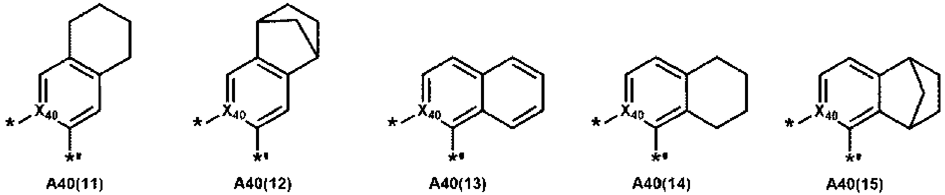 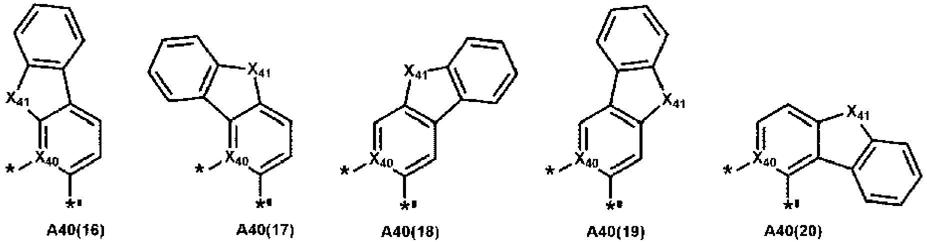 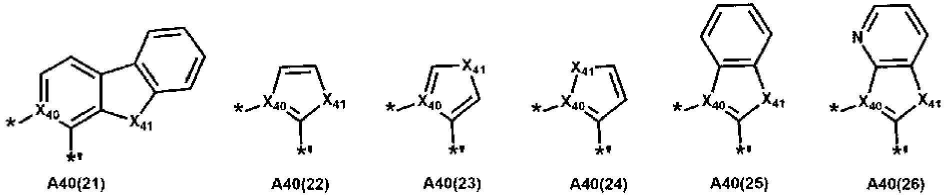 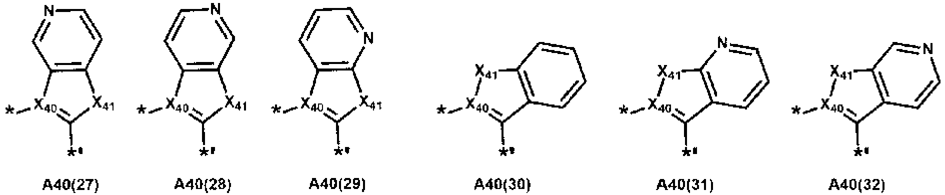 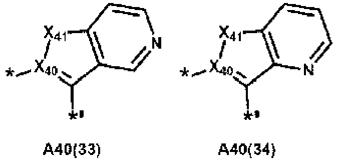
wobei in Formel A40(1) bis A40(34)
X₄₀ C oder N ist,
X₄₁ eine Einfachbindung, O, S, N(R₄₇), C(R₄₇)(R₄₈) oder Si(R₄₇)(R₄₈) ist, wobei R₄₇ und R₄₈ jeweils wie in Verbindung mit R₄₀ in Anspruch 1 definiert sind,
* eine Bindungsstelle zu M₁ in Formel 1 angibt und
*' eine Bindungsstelle zu T₂ in Formel 1 angibt; und/oder
wobei L₂₁ bis L₂₄ in Formel 2 jeweils unabhängig eine Benzolgruppe, eine Naphthalingruppe, eine Anthracengruppe, eine Phenanthrengruppe, eine Triphenylengruppe, eine Pyrengruppe, eine Chrysengruppe, eine Cyclopentadiengruppe, eine 1,2,3,4-Tetrahydronaphthalingruppe, eine Pyrrolgruppe, eine Thiophengruppe, eine Furangruppe, eine Indolgruppe, eine Indengruppe, eine Benzothiophengruppe, eine Benzofurangruppe, eine Carbazolgruppe, eine Fluorengruppe, eine Dibenzofurangruppe oder eine Dibenzothiophengruppe sind, jeweils unsubstituiert oder substituiert mit mindestens einem von Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₂₀-Alkylgruppe, einer C₁-C₂₀-Alkoxygruppe, einer C₁-C₂₀-Alkylthiogruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Biphenylgruppe, einer Terphenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Furanylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Imidazopyridinylgruppe, einer Imidazopyrimidinylgruppe, einer Azacarbazolylgruppe, einer Azadibenzofuranylgruppe, einer Azadibenzothiophenylgruppe, -Si(Q₃₃)(Q₃₄)(Q₃₅) oder einer Kombination davon, und
Q₃₃ bis Q₃₅ jeweils unabhängig eine Methylgruppe, eine Ethylgruppe, eine n-Propylgruppe, eine Isopropylgruppe, eine n-Butylgruppe, eine sec-Butylgruppe, eine Isobutylgruppe, eine tert-Butylgruppe, eine n-Pentylgruppe, eine tert-Pentylgruppe, eine Neopentylgruppe, eine Isopentylgruppe, eine sec-Pentylgruppe, eine 3-Pentylgruppe, eine sec-Isopentylgruppe, eine Phenylgruppe, eine Biphenylgruppe oder eine Naphthylgruppe sind, jeweils unsubstituiert oder substituiert mit mindestens einem von Deuterium, -F, einer C₁-C₁₀-Alkylgruppe, einer Phenylgruppe oder einer Kombination davon.

6. Organometallische Verbindung nach einem der Ansprüche 1-5, wobei a21 bis a24 in Formel 2 jeweils unabhängig 0 oder 1 sind; und/oder
wobei R₂₀₁ bis R₂₀₃ in Formel 2 jeweils unabhängig Folgendes sind:
eine Methylgruppe, eine Ethylgruppe, eine n-Propylgruppe, eine Isopropylgruppe, eine n-Butylgruppe, eine Isobutylgruppe, eine sec-Butylgruppe, eine tert-Butylgruppe, eine n-Pentylgruppe, eine Isopentylgruppe, eine sec-Pentylgruppe, eine tert-Pentylgruppe, eine n-Hexylgruppe, eine Isohexylgruppe, eine sec-Hexylgruppe, eine tert-Hexylgruppe, eine n-Heptylgruppe, eine Isoheptylgruppe, eine sec-Heptylgruppe, eine tert-Heptylgruppe, eine n-Octylgruppe, eine Isooctylgruppe, eine sec-Octylgruppe, eine tert-Octylgruppe, eine n-Nonylgruppe, eine Isononylgruppe, eine sec-Nonylgruppe, eine tert-Nonylgruppe, eine n-Decylgruppe, eine Isodecylgruppe, eine sec-Decylgruppe oder eine tert-Decylgruppe, jeweils unsubstituiert oder substituiert mit mindestens einem von Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₂₀-Alkoxygruppe, einer C₁-C₂₀-Alkylthiogruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe, einer Pyrimidinylgruppe oder einer Kombination davon; oder
eine Cyclopentylgruppe, eine Cyclohexylgruppe, eine Cycloheptylgruppe, eine Cyclooctylgruppe, eine Adamantanylgruppe, eine Norbornanylgruppe, eine Norbornenylgruppe, eine Cyclopentenylgruppe, eine Cyclohexenylgruppe, eine Cycloheptenylgruppe, eine Phenylgruppe, eine Naphthylgruppe, eine Pyridinylgruppe oder eine Pyrimidinylgruppe, jeweils unsubstituiert oder substituiert mit mindestens einem von Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₂₀-Alkoxygruppe, einer C₁-C₂₀-Alkylthiogruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe, einer Pyrimidinylgruppe oder einer Kombination davon.

7. Organometallische Verbindung nach einem der Ansprüche 1-6, wobei eine durch Formel 2 dargestellte Gruppe durch Formel 2(1) dargestellt ist: 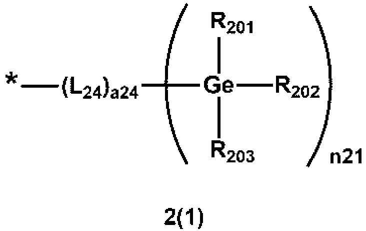 wobei in Formel 2(1)
L₂₄, R₂₀₁ bis R₂₀₃ und n21 wie in Anspruch 1 definiert sind,
a24 0 oder 1 ist und
* eine Bindungsstelle zu einem benachbarten Atom angibt.

8. Organometallische Verbindung nach einem der Ansprüche 1-7, wobei
jede durch Formel 2 dargestellte Gruppe unabhängig eine durch eine von Formel 2-1 bis 2-4 dargestellte Gruppe ist: 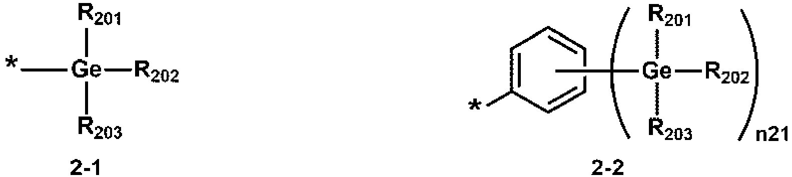 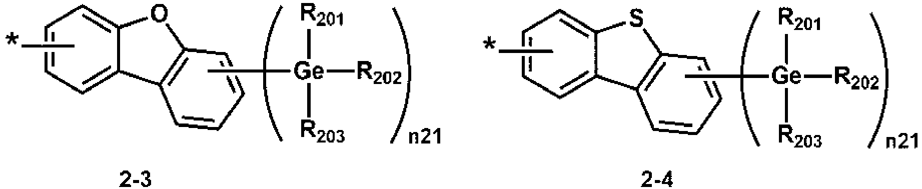
wobei in Formel 2-1 bis 2-4
R₂₀₁ bis R₂₀₃ und n21 wie in Anspruch 1 definiert sind und
* eine Bindungsstelle zu einem benachbarten Atom angibt.

9. Organometallische Verbindung nach einem der Ansprüche 1-8, wobei jede durch Formel 2 dargestellte Gruppe unabhängig durch eine von Formel 2-101 bis 2-134 dargestellte Gruppen sind: 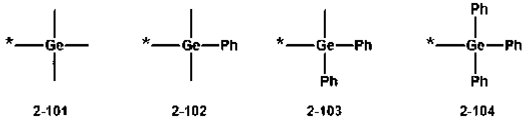 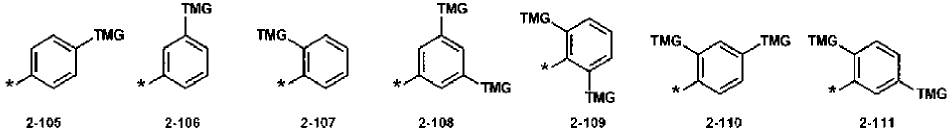 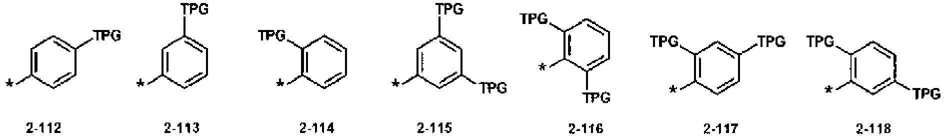 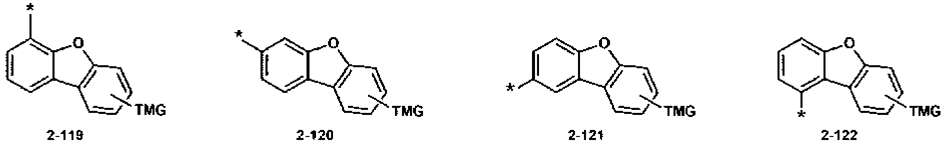 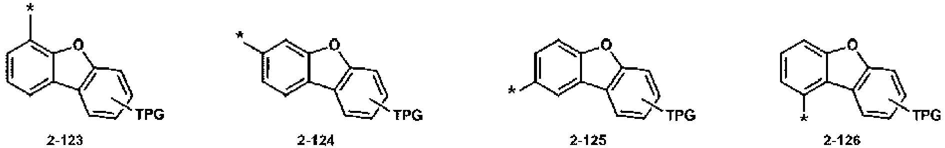 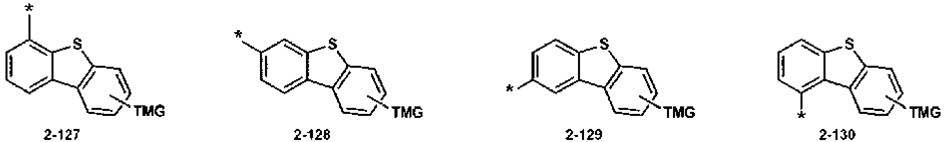 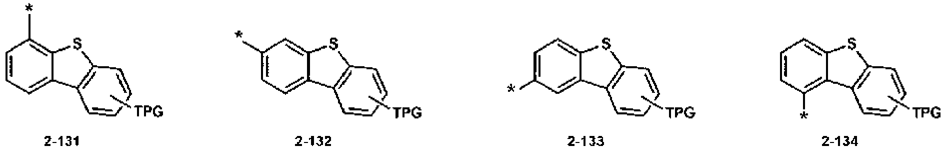
wobei in Formel 2-101 bis 2-134
"TMG" eine Trimethylgermylgruppe ist,
"TPG" eine Triphenylgermylgruppe ist und
* eine Bindungsstelle zu einem benachbarten Atom angibt.

10. Organometallische Verbindung nach einem der Ansprüche 1-9, wobei die organometallische Verbindung durch eine von Formel 1A bis 1D dargestellt ist: 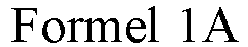 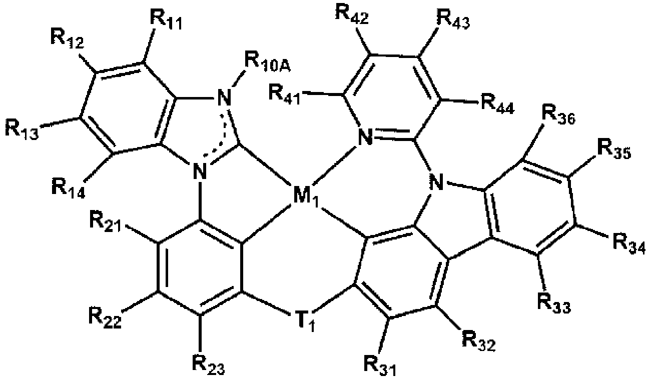 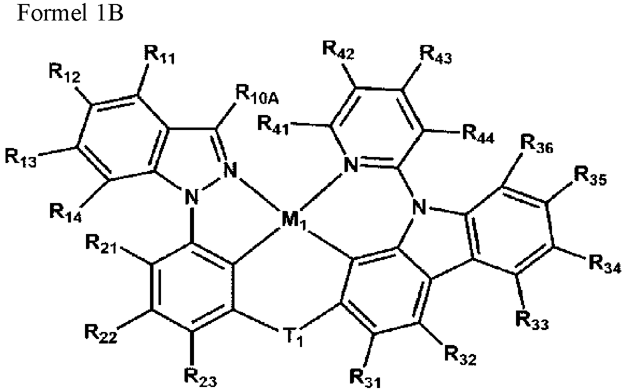 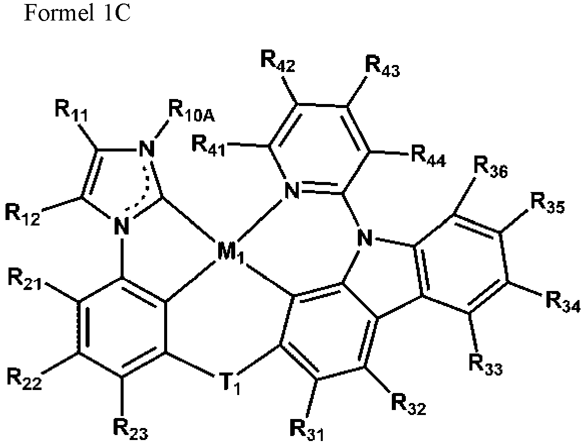 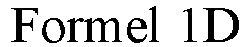 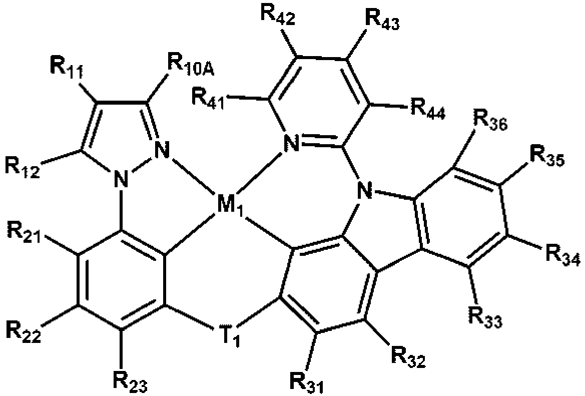
wobei in Formel 1A bis 1D
M₁, T₁, R_{10A}, R₁₁ und R₁₂ wie in Anspruch 1 definiert sind,
R₁₃ und R₁₄ jeweils wie in Verbindung mit R₁₀ in Anspruch 1 definiert sind,
R₂₁ bis R₂₃ jeweils wie in Verbindung mit R₂₀ in Anspruch 1 definiert sind,
R₃₁ bis R₃₆ jeweils wie in Verbindung mit R₃₀ in Anspruch 1 definiert sind,
R₄₁ bis R₄₄ jeweils wie in Verbindung mit R₄₀ in Anspruch 1 definiert sind und
mindestens eines von R₁₁ bis R₁₄, R₂₁ bis R₂₃, R₃₁ bis R₃₆ und R₄₁ bis R₄₄ in Formel 1A und 1B eine durch Formel 2 dargestellte Gruppe ist und
mindestens eines von R₁₁, R₁₂, R₂₁ bis R₂₃, R₃₁ bis R₃₆ und R₄₁ bis R₄₄ in Formel 1C und 1D eine durch Formel 2 dargestellte Gruppe ist.

11. Organometallische Verbindung nach Anspruch 1, wobei es sich bei der organometallischen Verbindung um eine oder mehrere von Verbindung 1 bis 218 handelt: 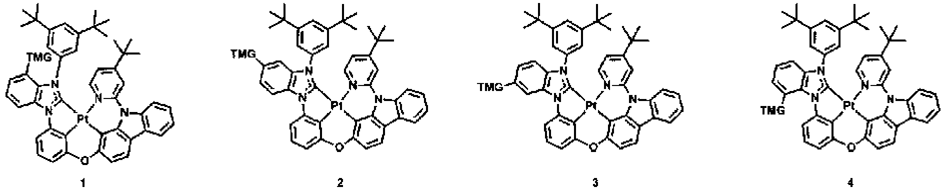 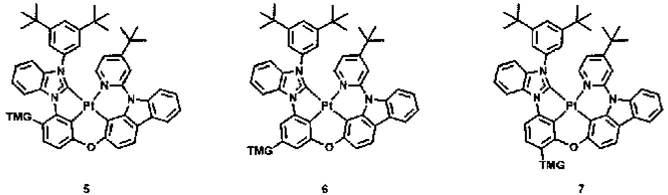 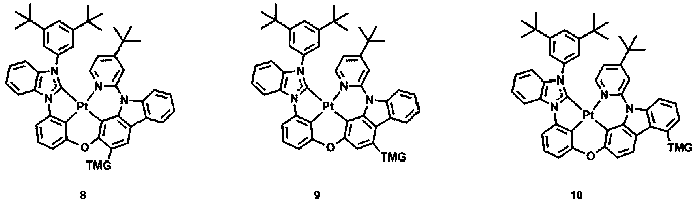 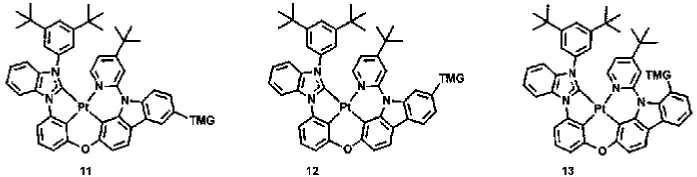 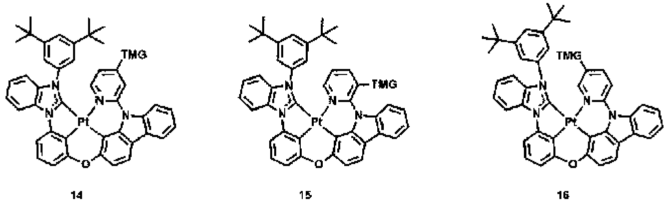 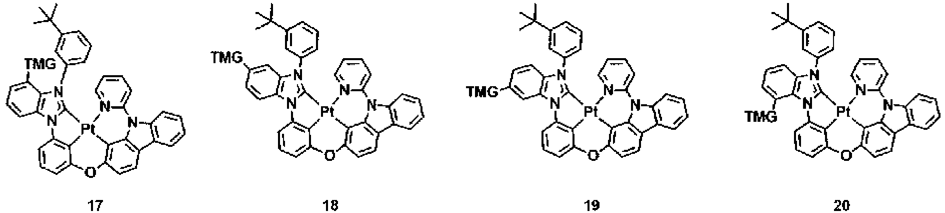 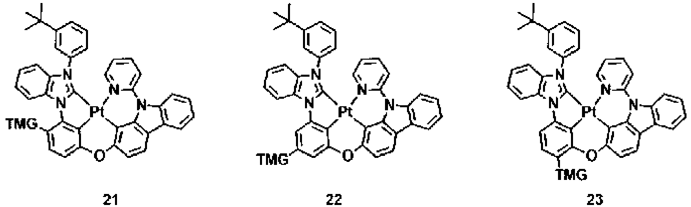 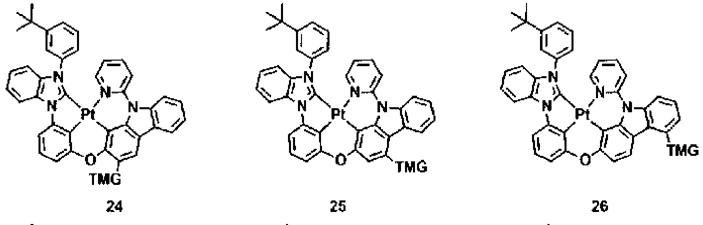 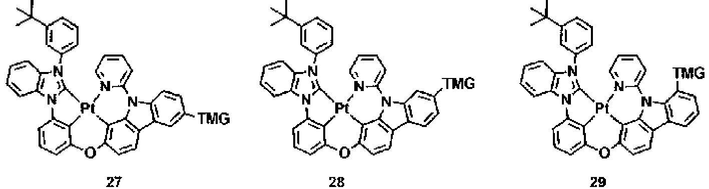 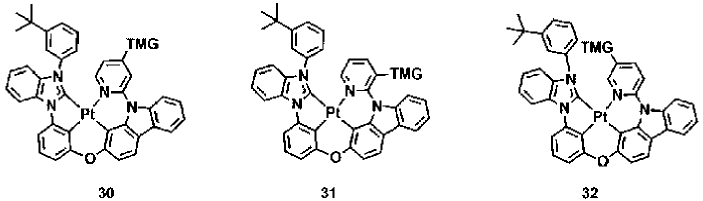 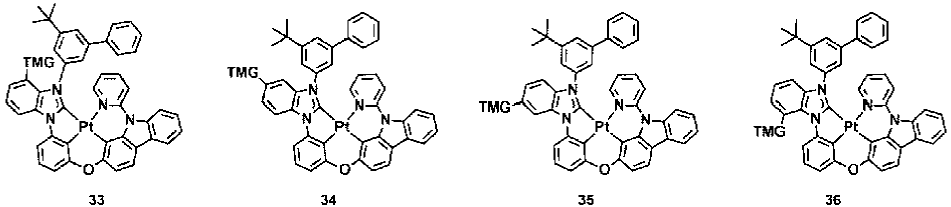 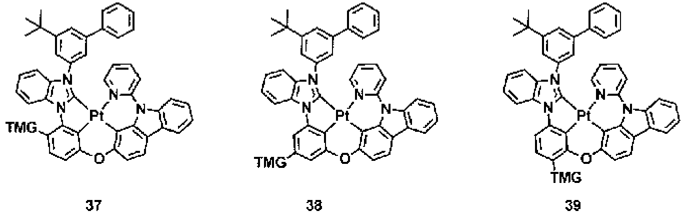 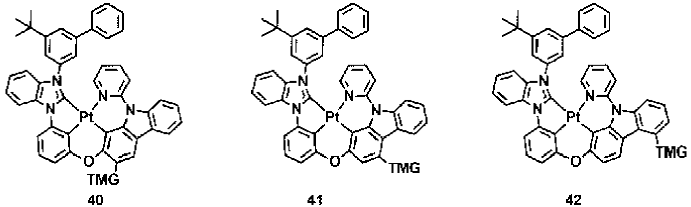 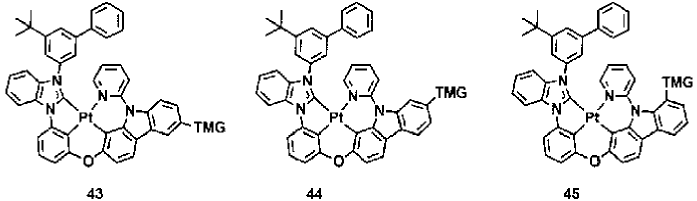 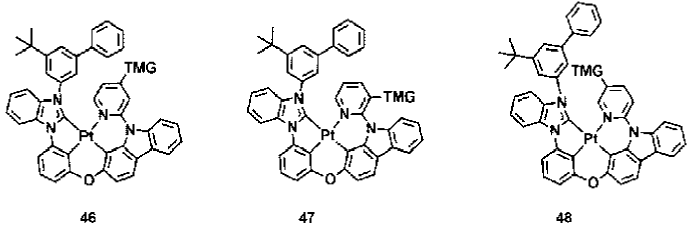 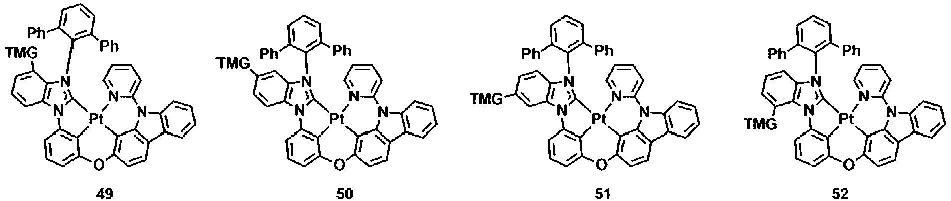 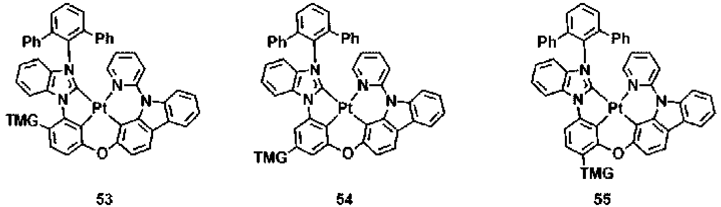 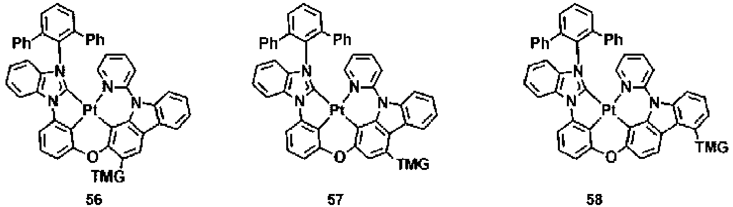 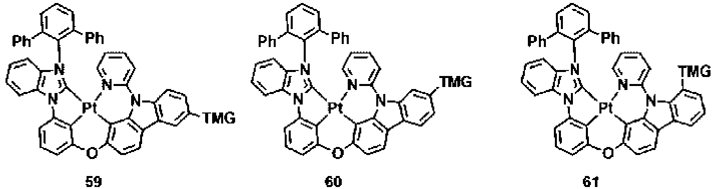 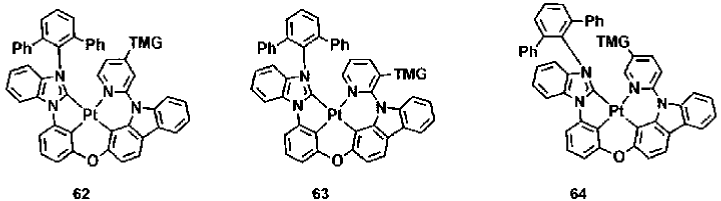 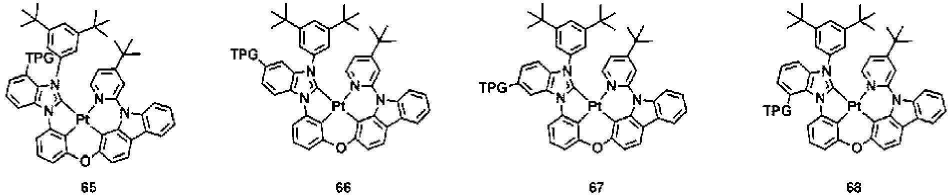 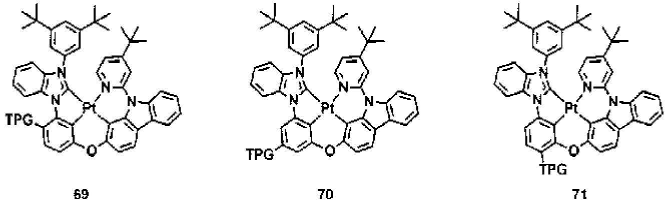 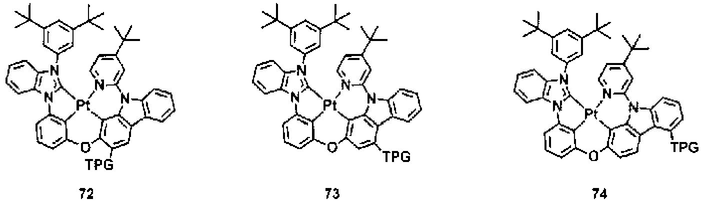 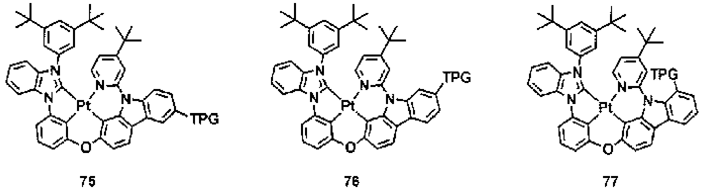 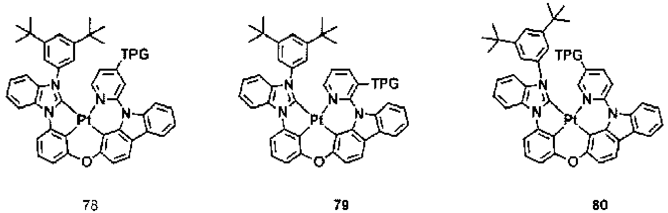 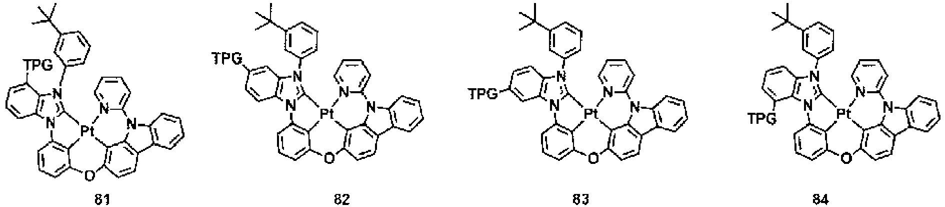 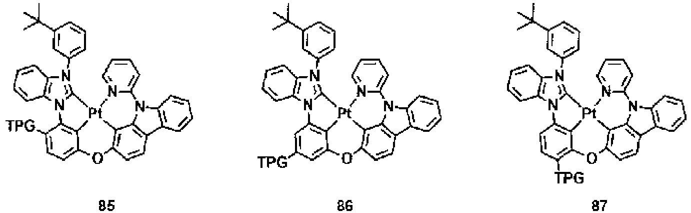 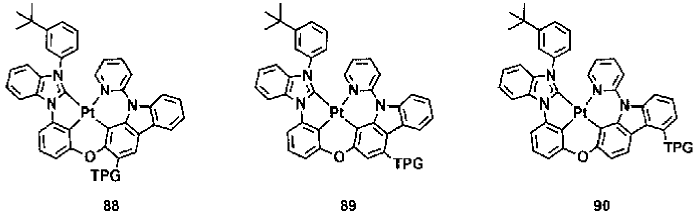 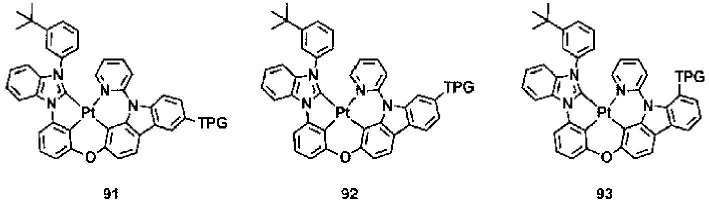 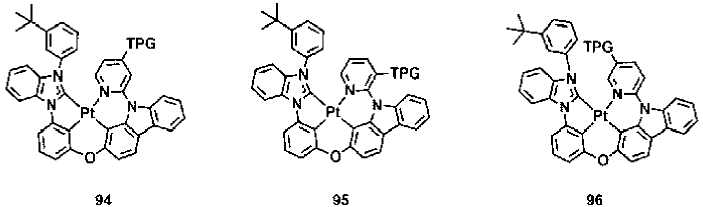 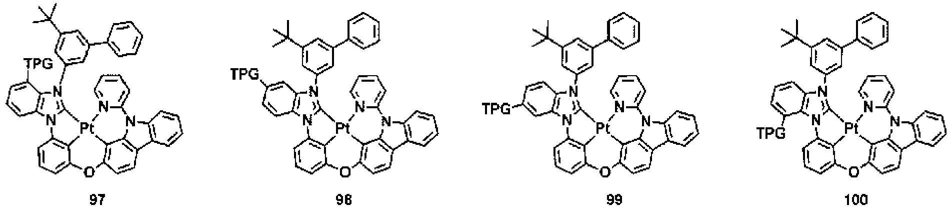 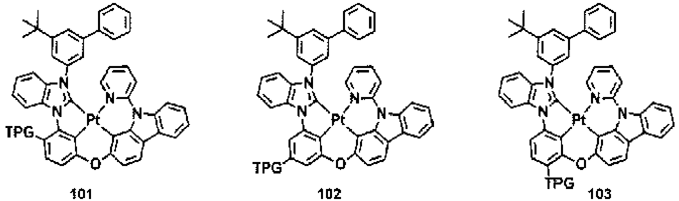 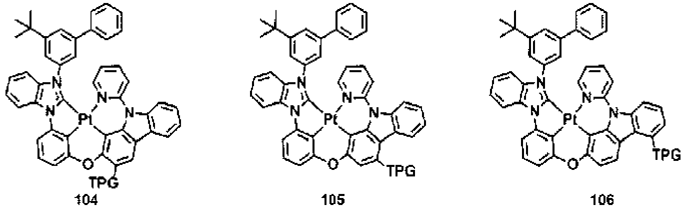 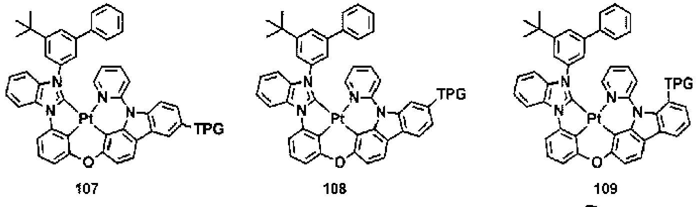 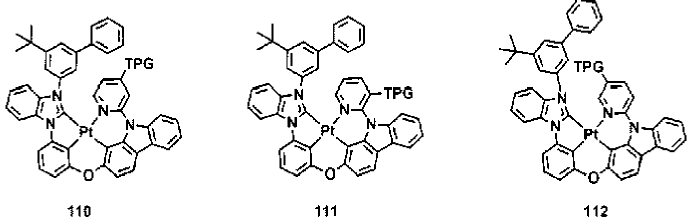 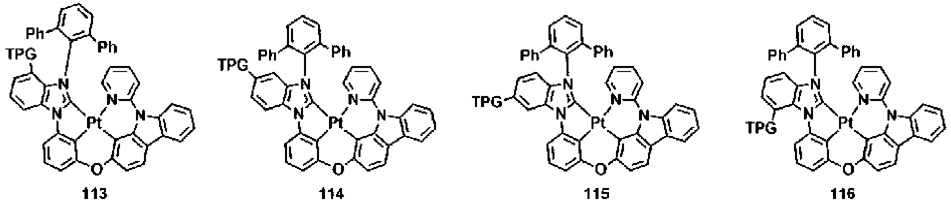 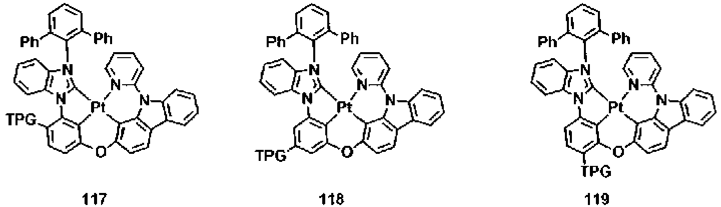 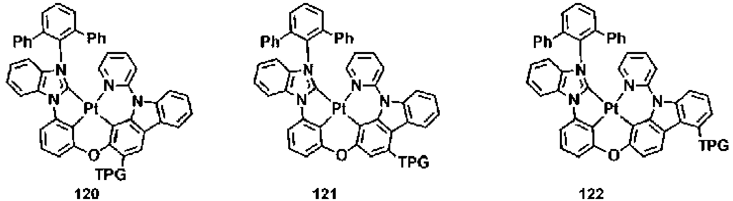 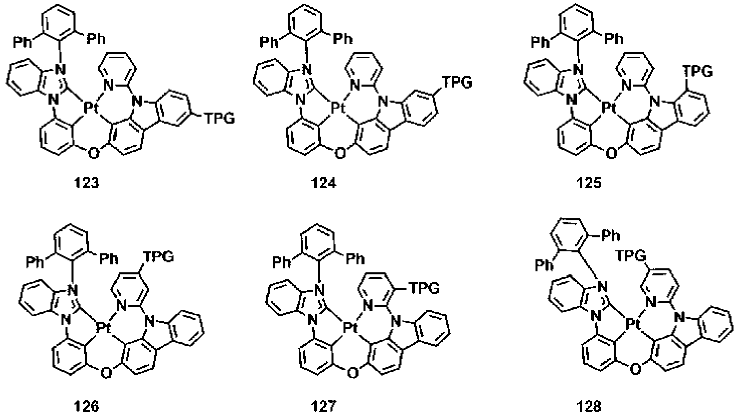 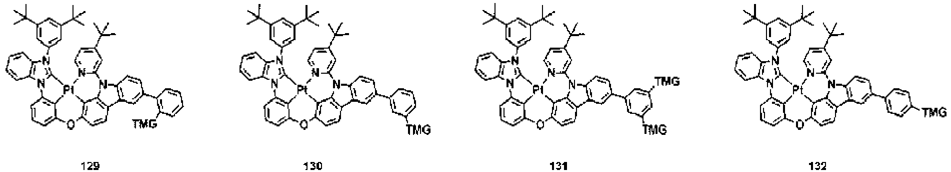 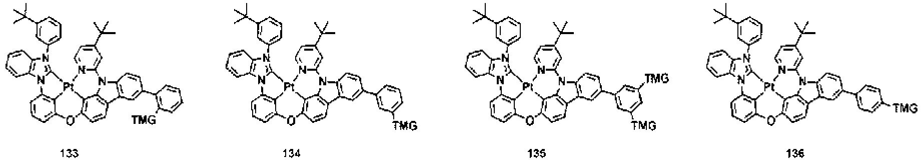 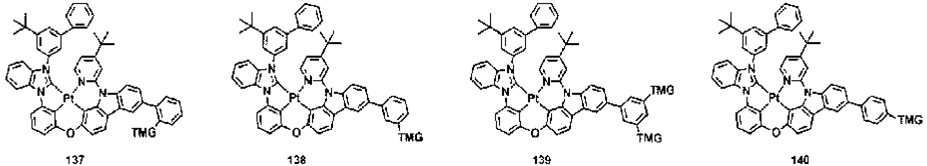 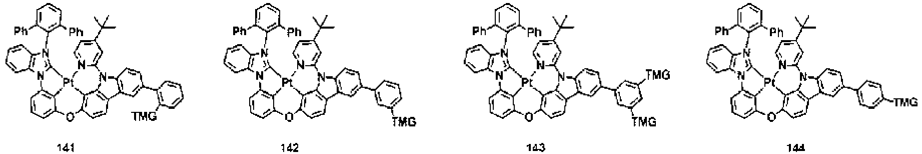 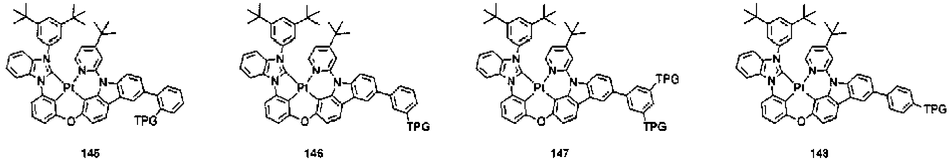 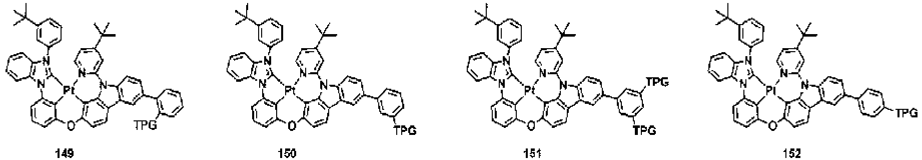 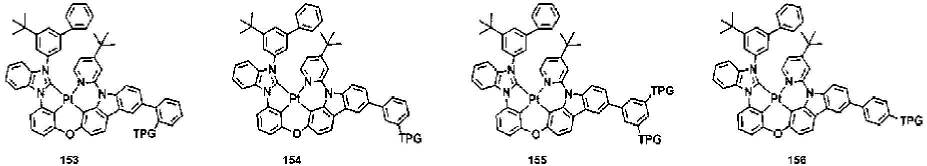 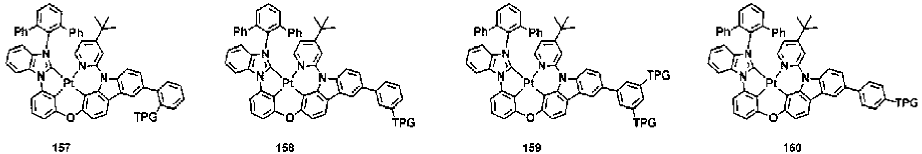 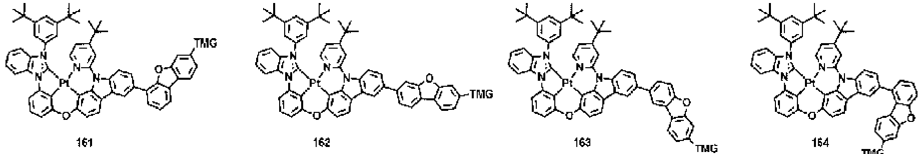 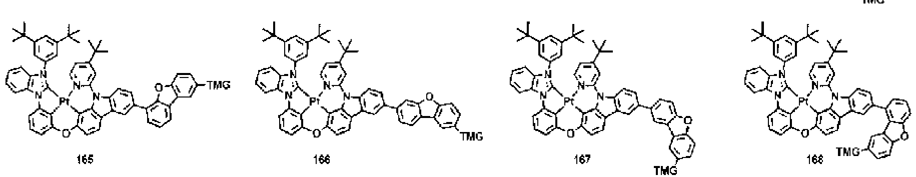 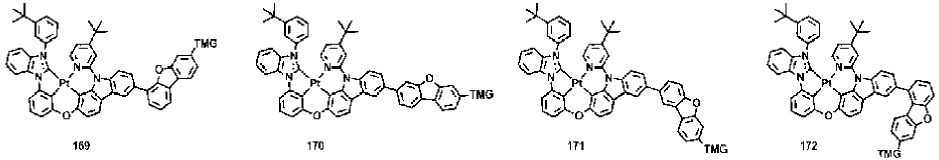 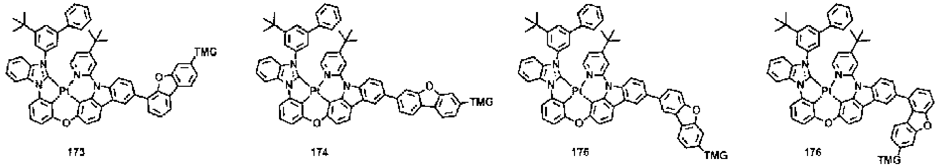 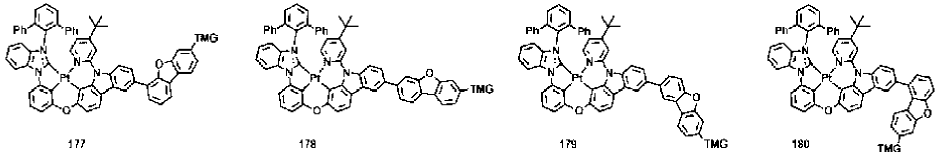 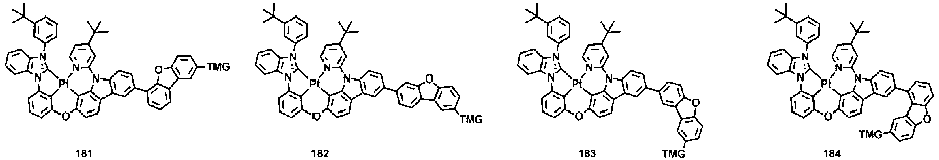 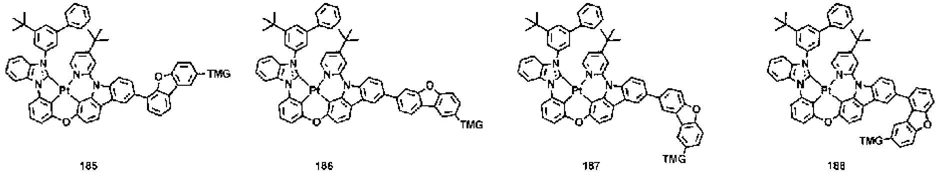 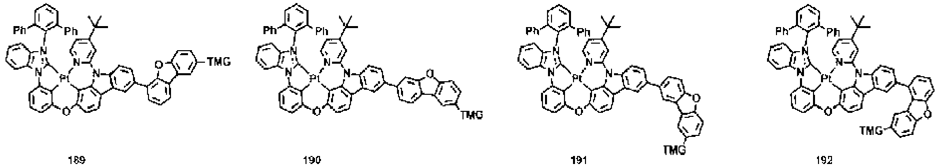 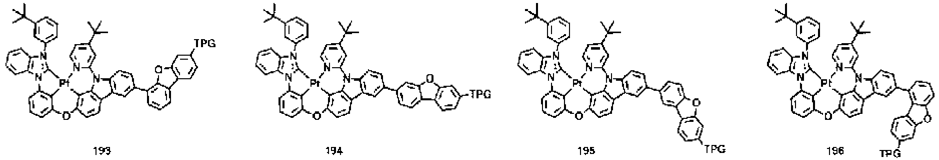 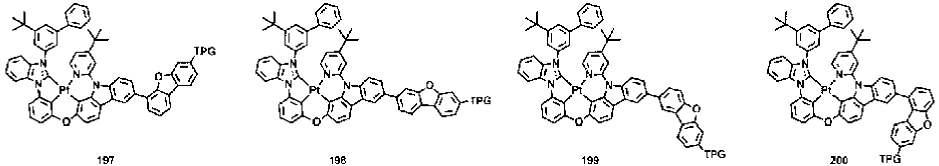 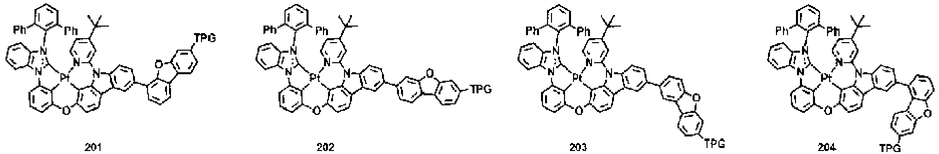 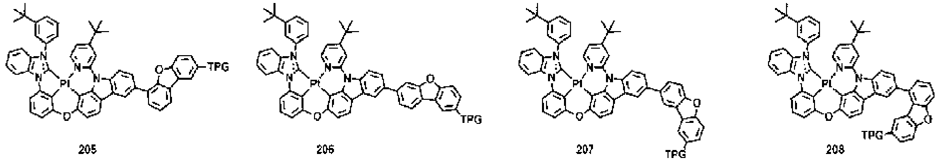 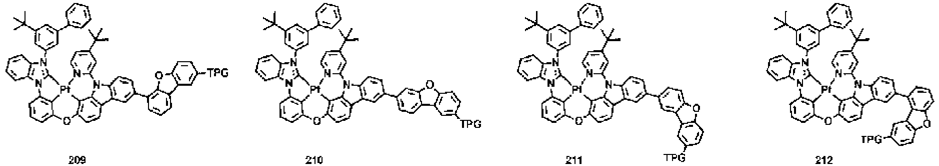 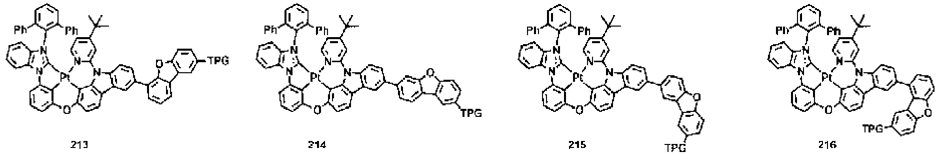 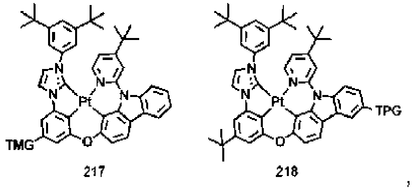 wobei "TMG" eine Trimethylgermylgruppe ist und "TPG" eine Triphenylgermylgruppe ist.

12. Organische lichtemittierende Vorrichtung, umfassend:
eine erste Elektrode;
eine zweite Elektrode; und
eine organische Schicht, die zwischen der ersten Elektrode und der zweiten Elektrode angeordnet ist,
wobei die organische Schicht eine Emissionsschicht umfasst und
wobei die organische Schicht ferner mindestens eine organometallische Verbindung nach einem der Ansprüche 1-11 umfasst.

13. Organische lichtemittierende Vorrichtung nach Anspruch 12, wobei die Emissionsschicht die mindestens eine organometallische Verbindung umfasst.

14. Organische lichtemittierende Vorrichtung nach Anspruch 13, wobei die Emissionsschicht ferner einen Wirt umfasst und eine Menge des Wirts in der Emissionsschicht größer ist als eine Menge der mindestens einen organometallischen Verbindung in der Emissionsschicht; und/oder
wobei die Emissionsschicht blaues Licht mit einer maximalen Emissionswellenlänge in einem Bereich von 410 Nanometern bis 490 Nanometern emittiert; und/oder
wobei mindestens 80 % der gesamten Lumineszenzemission aus der Emissionsschicht von der mindestens einen organometallischen Verbindung abgeleitet sind.

15. Organische lichtemittierende Vorrichtung nach einem der Ansprüche 12-14, wobei
die erste Elektrode eine Anode ist,
die zweite Elektrode eine Kathode ist,
die organische Schicht ferner eine Lochtransportregion, die zwischen der ersten Elektrode und der Emissionsschicht angeordnet ist, und eine Elektronentransportregion, die zwischen der Emissionsschicht und der zweiten Elektrode angeordnet ist, umfasst,
wobei die Lochtransportregion eine Lochinjektionsschicht, eine Lochtransportschicht, eine Elektronensperrschicht, eine Pufferschicht oder eine Kombination davon umfasst und
die Elektronentransportregion eine Lochsperrschicht, eine Elektronentransportschicht, eine Elektroneninjektionsschicht oder eine Kombination davon umfasst.

## Revendications

1. Composé organométallique représenté par la Formule 1 : 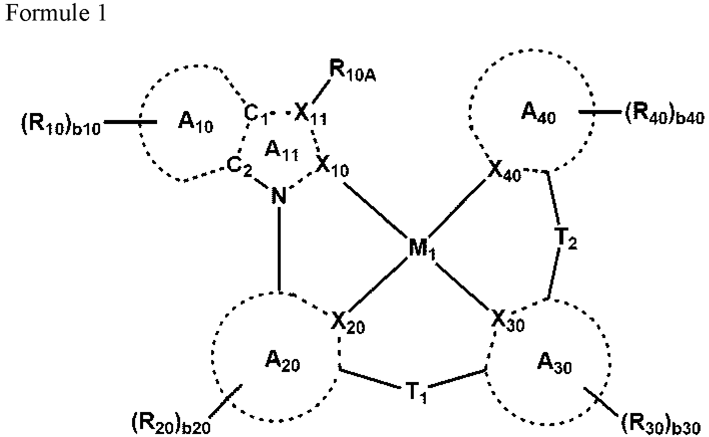 dans lequel, dans la Formule 1,
M₁ est un métal de transition,
X₁₀, X₁₁, X₂₀, X₃₀ et X₄₀ sont chacun indépendamment C ou N, à condition que l'un de X₁₀ et X₁₁ soit N, et l'autre de X₁₀ et X₁₁ soit C,
le cycle A₁₀ est présent ou absent,
lorsque le cycle A₁₀ est présent, le cycle A₁₀ est un groupe C₅-C₃₀ carbocyclique ou un groupe C₁-C₃₀ hétérocyclique, dans lequel chacun de C₁ et C₂ est C,
lorsque le cycle A₁₀ n'est pas présent, C₁ est C(R₁₁) et C₂ est C(R₁₂),
le cycle A₁₁ est un cycle pyrazole ou un cycle imidazole,
le cycle A₂₀, le cycle A₃₀ et le cycle A₄₀ sont chacun indépendamment un groupe C₅-C₃₀ carbocyclique ou un groupe C₁-C₃₀ hétérocyclique,
T₁ et T₂ sont chacun indépendamment une liaison simple, *-N(R₅₁)-*', *-B(R₅₁)-*', *-P(R₅₁)-*', *-C(R₅₁)(R₅₂)-*', *-Si(R₅₁)(R₅₂)-*', *-Ge(R₅₁)(R₅₂)-*', *-S-*', *-Se-*', *-O-*', *-C(=O)-*', *-S(=O)-*', *-S(=O)₂-*', *-C(R₅₁)=C(R₅₂)-*', *-C(=S)-*' ou *-C=C-*',
R₁₀ à R₁₂, R_{10A}, R₂₀, R₃₀, R₄₀, R₅₁ et R₅₂ sont chacun indépendamment un groupe représenté par la Formule 2, hydrogène, deutérium, -F, -Cl, -Br, -I, -SF₅, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₆₀ alkyle substitué ou non substitué, un groupe C₂-C₆₀ alcényle substitué ou non substitué, un groupe C₂-C₆₀ alkynyle substitué ou non substitué, un groupe C₁-C₆₀ alkoxy substitué ou non substitué, un groupe C₁-C₆₀ alkylthio substitué ou non substitué, un groupe C₃-C₁₀ cycloalkyle substitué ou non substitué, un groupe C₁-C₁₀ hétérocycloalkyle substitué ou non substitué, un groupe C₃-C₁₀ cycloalcényle substitué ou non substitué, un groupe C₁-C₁₀ hétérocycloalcényle substitué ou non substitué, un groupe C₆-C₆₀ aryle substitué ou non substitué, un groupe C₇-C₆₀ alkyle aryle substitué ou non substitué, un groupe C₇-C₆₀ aryle alkyle substitué ou non substitué, un groupe C₆-C₆₀ aryloxy substitué ou non substitué, un groupe C₆-C₆₀ arylthio substitué ou non substitué, un groupe C₁-C₆₀ hétéroaryle substitué ou non substitué, groupe C₂-C₆₀ alkyle hétéroaryle substitué ou non substitué, un groupe C₂-C₆₀ hétéroaryle alkyle substitué ou non substitué, un groupe C₁-C₆₀ hétéroaryloxy substitué ou non substitué, un groupe C₁-C₆₀ hétéroarylthio substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -Si(Q₃)(Q₄)(Q₅), -B(Q₆)(Q₇), -P(Q₈)(Q₉) ou -P(=O)(Q₈)(Q₉),
au moins deux d'une pluralité de R₁₀ sont éventuellement liés ensemble pour former un groupe C₅-C₃₀ carbocyclique substitué ou non substitué ou un groupe C₁-C₃₀ hétérocyclique substitué ou non substitué,
au moins deux d'une pluralité de R₂₀ sont éventuellement liés ensemble pour former un groupe C₅-C₃₀ carbocyclique substitué ou non substitué ou un groupe C₁-C₃₀ hétérocyclique substitué ou non substitué,
au moins deux d'une pluralité de R₃₀ sont éventuellement liés ensemble pour former un groupe C₅-C₃₀ carbocyclique substitué ou non substitué ou un groupe C₁-C₃₀ hétérocyclique substitué ou non substitué,
au moins deux d'une pluralité de R₄₀ sont éventuellement liés ensemble pour former un groupe C₅-C₃₀ carbocyclique substitué ou non substitué ou un groupe C₁-C₃₀ hétérocyclique substitué ou non substitué,
au moins deux éléments voisins parmi R₁₀, R_{10A}, R₂₀, R₃₀, R₄₀, R₅₁ et R₅₂ sont éventuellement liés ensemble pour former un groupe C₅-C₃₀ carbocyclique substitué ou non substitué ou un groupe C₁-C₃₀ hétérocyclique substitué ou non substitué,
b10, b20, b30 et b40 sont chacun indépendamment un nombre entier de 1 à 10,
au moins un élément parmi R₁₀, R₁₁, R₁₂, R₂₀, R₃₀ ou R₄₀ est un groupe représenté par la Formule 2, 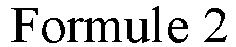 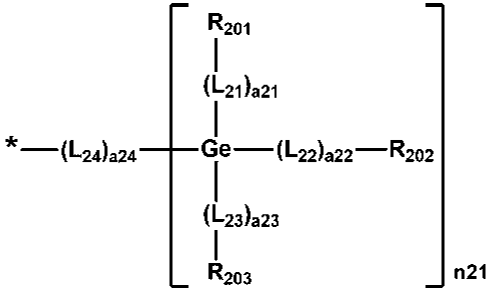 dans lequel, dans la Formule 2,
L₂₁ à L₂₄ sont chacun indépendamment un groupe C₅-C₆₀ carbocyclique substitué ou non substitué ou un groupe C₁-C₆₀ hétérocyclique substitué ou non substitué,
a21 à a24 sont chacun indépendamment un nombre entier de 0 à 3,
R₂₀₁ à R₂₀₃ sont chacun indépendamment un groupe C₁-C₆₀ alkyle substitué ou non substitué, un groupe C₂-C₆₀ alcényle substitué ou non substitué, un groupe C₂-C₆₀ alkynyle substitué ou non substitué, un groupe C₁-C₆₀ alkoxy substitué ou non substitué, un groupe C₁-C₆₀ alkylthio substitué ou non substitué, un groupe C₃-C₁₀ cycloalkyle substitué ou non substitué, un groupe C₁-C₁₀ hétérocycloalkyle substitué ou non substitué, un groupe C₃-C₁₀ cycloalcényle substitué ou non substitué, un groupe C₁-C₁₀ hétérocycloalcényle substitué ou non substitué, un groupe C₆-C₆₀ aryle substitué ou non substitué, un groupe C₇-C₆₀ alkyle aryle substitué ou non substitué, un groupe C₇-C₆₀ aryle alkyle substitué ou non substitué, un groupe C₆-C₆₀ aryloxy substitué ou non substitué, un groupe C₆-C₆₀ arylthio substitué ou non substitué, un groupe C₁-C₆₀ hétéroaryle substitué ou non substitué, un groupe C₂-C₆₀ hétéroaryle alkyle substitué ou non substitué, un groupe C₁-C₆₀ hétéroaryloxy substitué ou non substitué, un groupe C₁-C₆₀ hétéroarylthio substitué ou non substitué, un groupe polycyclique condensé non aromatique monovalent substitué ou non substitué ou un groupe hétéropolycyclique condensé non aromatique monovalent substitué ou non substitué,
n21 est un nombre entier de 1 à 5,
au moins un substituant du groupe C₅-C₆₀ carbocyclique substitué, le groupe C₁-C₆₀ hétérocyclique substitué, le groupe C₁-C₆₀ alkyle substitué, le groupe C₂-C₆₀ alcényle substitué, le groupe C₂-C₆₀ alkynyle substitué, le groupe C₁-C₆₀ alkoxy substitué, le groupe C₁-C₆₀ alkylthio substitué, le groupe C₃-C₁₀ cycloalkyle substitué, le groupe C₁-C₁₀ hétérocycloalkyle substitué, le groupe C₃-C₁₀ cycloalcényle substitué, le groupe C₁-C₁₀ hétérocycloalcényle substitué, le groupe C₆-C₆₀ aryle substitué, le groupe C₇-C₆₀ alkyle aryle substitué, le groupe C₇-C₆₀ aryle alkyle substitué, le groupe C₆-C₆₀ aryloxy substitué, le groupe C₆-C₆₀ arylthio substitué, le groupe C₁-C₆₀ hétéroaryle substitué, le groupe C₂-C₆₀ alkyle hétéroaryle substitué, le groupe C₂-C₆₀ hétéroaryle alkyle substitué, le groupe C₁-C₆₀ hétéroaryloxy substitué, le groupe C₁-C₆₀ hétéroarylthio substitué, le groupe polycyclique condensé non aromatique monovalent substitué et le groupe hétéropolycyclique condensé non aromatique monovalent substitué est :
deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₆₀ alkyle, un groupe C₂-C₆₀ alcényle, un groupe C₂-C₆₀ alkynyle et un groupe C₁-C₆₀ alkoxy ou un groupe C₁-C₆₀ alkylthio ;
un groupe C₁-C₆₀ alkyle, un groupe C₂-C₆₀ alcényle, un groupe C₂-C₆₀ alkynyle, un groupe C₁-C₆₀ alkoxy ou un groupe C₁-C₆₀ alkylthio, chacun étant non substitué ou substitué par au moins un élément parmi deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₇-C₆₀ alkyle aryle, un groupe C₆-C₆₀ aryloxy, un groupe C₆-C₆₀ arylthio, un groupe C₁-C₆₀ hétéroaryle, un groupe C₂-C₆₀ alkyle hétéroaryle, un groupe C₁-C₆₀ hétéroaryloxy, un groupe C₁-C₆₀ hétéroarylthio, un groupe polycyclique condensé non aromatique monovalent, un groupe hétéropolycyclique condensé non aromatique monovalent, -N(Q₁₁)(Q₁₂), -Si(Q₁₃)(Q₁₄)(Q₁₅), -B(Q₁₆)(Q₁₇), -P(Q₁₈)(Q₁₉), - P(=O)(Q₁₈)(Q₁₉), ou une combinaison de ceux-ci ;
un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₇-C₆₀ alkyle aryle, un groupe C₆-C₆₀ aryloxy, un groupe C₆-C₆₀ arylthio, un groupe C₁-C₆₀ hétéroaryle, un groupe C₂-C₆₀ alkyle hétéroaryle, un groupe C₁-C₆₀ hétéroaryloxy, un groupe C₁-C₆₀ hétéroarylthio, un groupe polycyclique condensé non aromatique monovalent ou un groupe hétéropolycyclique condensé non aromatique monovalent, chacun étant non substitué ou substitué par au moins un élément parmi deutérium, -F, -Cl, -Br, -I, -SF₅, -CD₃, -CD₂H, -CDH₂, -CF₃, - CF₂H, -CFH₂, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₆₀ alkyle, un groupe C₂-C₆₀ alcényle, un groupe C₂-C₆₀ alkynyle, un groupe C₁-C₆₀ alkoxy, un groupe C₁-C₆₀ alkylthio, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₇-C₆₀ alkyle aryle, un groupe C₇-C₆₀ aryle alkyle, un groupe C₆-C₆₀ aryloxy, un groupe C₆-C₆₀ arylthio, un groupe C₁-C₆₀ hétéroaryle, un groupe C₂-C₆₀ alkyle hétéroaryle, un groupe C₂-C₆₀ hétéroaryle alkyle, un groupe C₁-C₆₀ hétéroaryloxy, un groupe C₁-C₆₀ hétéroarylthio, un groupe polycyclique condensé non aromatique monovalent, un groupe hétéropolycyclique condensé non aromatique monovalent, -N(Q₂₁)(Q₂₂), -Si(Q₂₃)(Q₂₄)(Q₂₅), - B(Q₂₆)(Q₂₇), -P(Q₂₈)(Q₂₉), -P(=O)(Q₂₈)(Q₂₉), ou une combinaison de ceux-ci ;
-N(Q₃₁)(Q₃₂), -Si(Q₃₃)(Q₃₄)(Q₃₅), -B(Q₃₆)(Q₃₇), -P(Q₃₈)(Q₃₉) ou -P(=O)(Q₃₈)(Q₃₉) ; ou
une combinaison de ceux-ci,
Q₁ à Q₉, Q₁₁ à Q₁₉, Q₂₁ à Q₂₉ et Q₃₁ à Q₃₉ sont chacun indépendamment hydrogène, deutérium, -F, -Cl, -Br, -I, -SF₅, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₆₀ alkyle, un groupe C₂-C₆₀ alcényle, un groupe C₂-C₆₀ alkynyle, un groupe C₁-C₆₀ alkoxy, un groupe C₁-C₆₀ alkylthio, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₇-C₆₀ alkyle aryle, un groupe C₇-C₆₀ aryle alkyle, un groupe C₆-C₆₀ aryloxy, un groupe C₆-C₆₀ arylthio, un groupe C₁-C₆₀ hétéroaryle, un groupe C₂-C₆₀ alkyle hétéroaryle, un groupe C₂-C₆₀ hétéroaryle alkyle, un groupe C₁-C₆₀ hétéroaryloxy, un groupe C₁-C₆₀ hétéroarylthio, un groupe polycyclique condensé non aromatique monovalent ou un groupe hétéropolycyclique condensé non aromatique monovalent, chacun étant non substitué ou substitué par au moins un élément parmi deutérium, un groupe C₁-C₆₀ alkyle, un groupe C₆-C₆₀ aryle ou une combinaison de ceux-ci, et
* et *' indiquent chacun un site de liaison à un atome voisin.

2. Composé organométallique selon la revendication 1, dans lequel une fraction est représentée par : 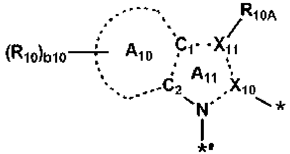
dans la Formule 1 est représenté par l'une des Formules A10(1) à A10(4) : 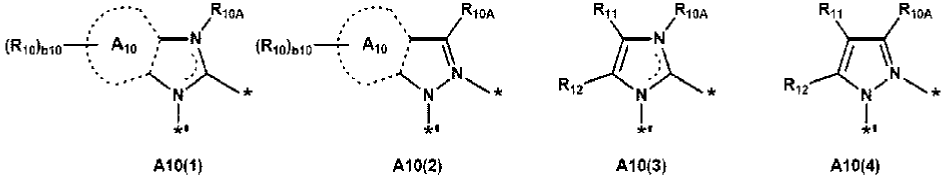
dans lequel, dans les Formules A10(1) à A10(4),
le cycle A₁₀ est un groupe C₅-C₃₀ carbocyclique ou un groupe C₁-C₃₀ hétérocyclique,
R_{10A}, R₁₀ à R₁₂, et b10 sont tels que définis selon la revendication 1,
au moins deux d'une pluralité de R₁₀ sont éventuellement liés ensemble pour former un groupe C₅-C₃₀ carbocyclique substitué ou non substitué ou un groupe C₁-C₃₀ hétérocyclique substitué ou non substitué,
au moins deux éléments voisins parmi R₁₀ et R₁₀ₐ sont éventuellement liés ensemble pour former un groupe C₅-C₃₀ carbocyclique substitué ou non substitué ou un groupe C₁-C₃₀ hétérocyclique substitué ou non substitué,
* indique un site de liaison à M₁, et
*' indique un site de liaison au cycle A₂₀.

3. Composé organométallique selon la revendication 1 ou 2, dans lequel une fraction est représentée par : 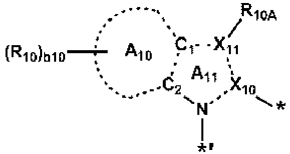
dans la Formule 1 est représenté par les Formules A10-1, A10-2, A10(3) ou A10(4) : 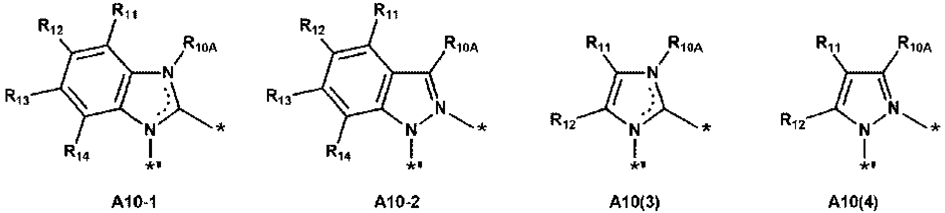
dans lequel dans les Formules A10-1, A10-2, A10(3) et A10(4),
R_{10A}, R₁₁ et R₁₂ sont définis selon la revendication 1,
R₁₃ et R₁₄ sont chacun tels que définis en relation avec R₁₀ selon la revendication 1,
au moins deux éléments parmi Ru à R₁₄, et R₁₀ₐ sont éventuellement liés ensemble pour former un groupe C₅-C₃₀ carbocyclique substitué ou non substitué ou un groupe C₁-C₃₀ hétérocyclique substitué ou non substitué,
* indique un site de liaison à M₁ dans la Formule 1, et
*' indique un site de liaison au cycle A₂₀ dans la Formule 1.

4. Composé organométallique selon l'une quelconque des revendications 1 à 3, dans lequel le cycle A₂₀ dans la Formule 1 est représenté par l'une des Formules A20(1) à A20(15) : 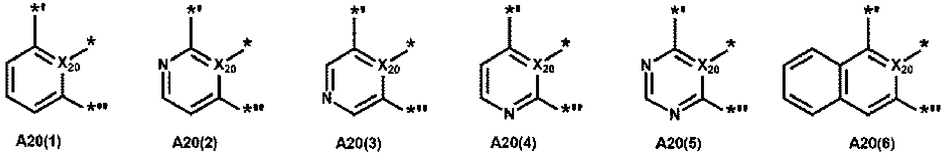 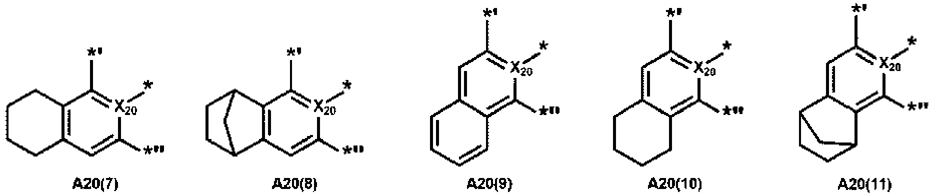 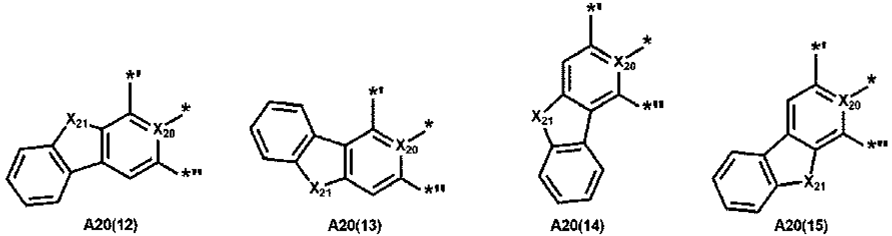
dans lequel, dans les Formules A20(1) à A20(15),
X₂₀ est C ou N,
X₂₁ est O, S, N(R₂₆), C(R₂₆)(R₂₇) ou Si(R₂₆)(R₂₇), R₂₆ et R₂₇ étant tels que définis en relation avec R₂₀ selon la revendication 1,
* indique un site de liaison à M₁ dans la Formule 1,
*' indique un site de liaison à N dans la Formule 1, et
*" indique un site de liaison à T₁ dans la Formule 1 ; et/ou
dans lequel le cycle A₃₀ dans la Formule 1 est représenté par l'une des Formules A30(1) à A30(12) : 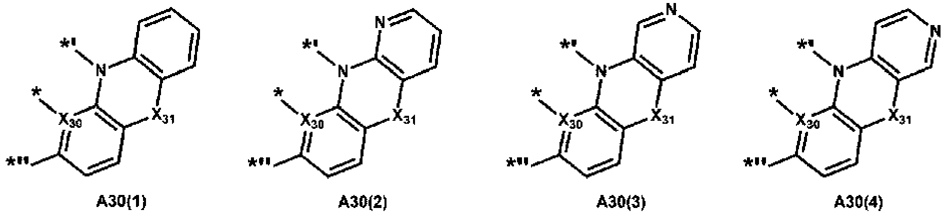 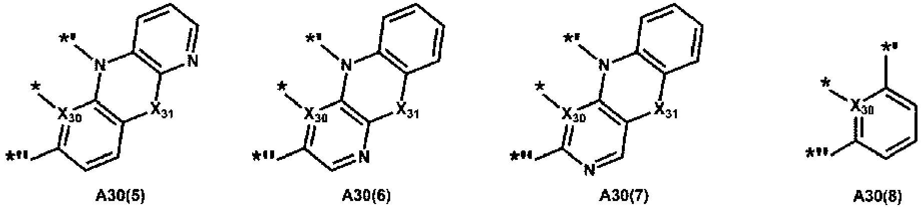 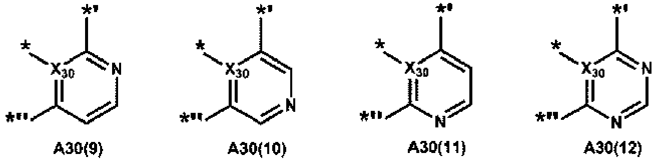
dans lequel, dans les Formules A30(1) à A30(12),
X₃₀ est C ou N,
X₃₁ est une liaison simple, O, S, N(R₃₇), C(R₃₇)(R₃₈) ou Si(R₃₇)(R₃₈), R₃₇ et R₃₈ étant chacun tels que définis en relation avec R₃₀ selon la revendication 1,
* indique un site de liaison à M₁ dans la Formule 1,
*' indique un site de liaison à T₂ dans la Formule 1, et
*" indique un site de liaison à T₁ dans la Formule 1.

5. Composé organométallique selon l'une quelconque des revendications 1 à 4, dans lequel le cycle A₄₀ dans la Formule 1 est représenté par l'une des Formules A40(1) à A40(34) : 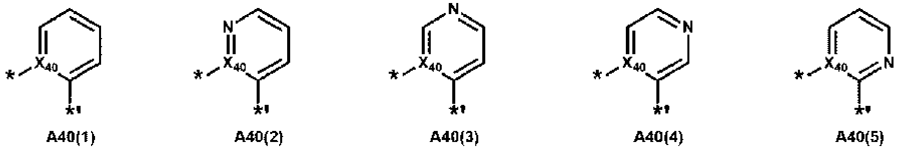 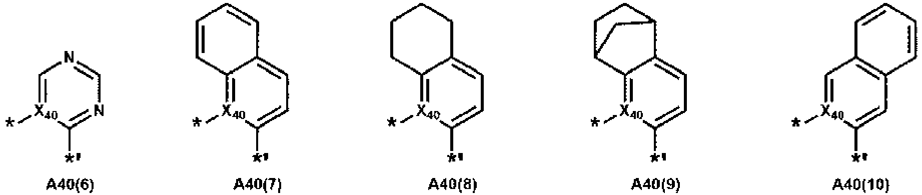 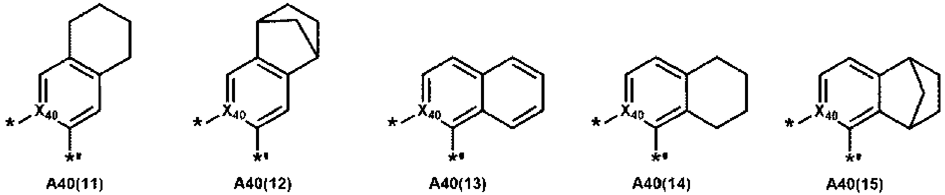 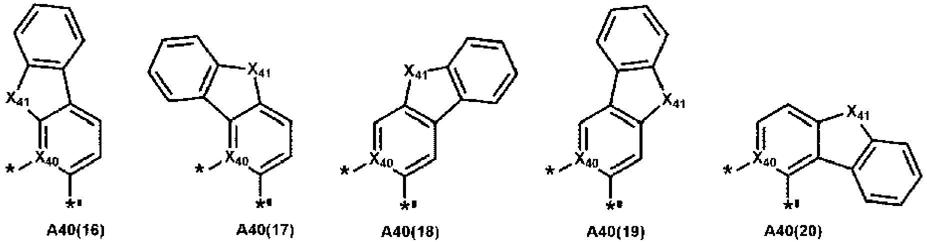 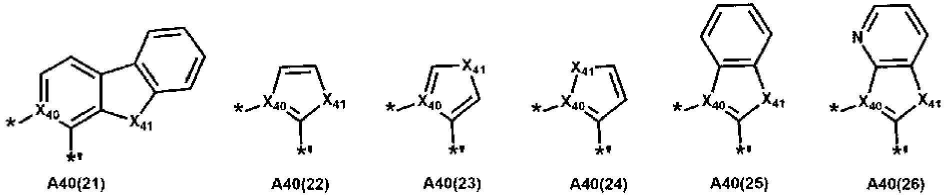 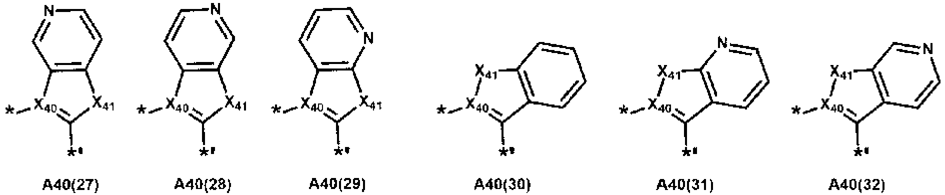 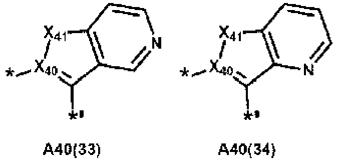
dans lequel, dans les Formules A40(1) à A40(34),
X₄₀ est C ou N,
X₄₁ est une liaison simple, O, S, N(R₄₇), C(R₄₇)(R₄₈) ou Si(R₄₇)(R₄₈), R₄₇ et R₄₈ étant chacun tels que définis en relation avec R₄₀ selon la revendication 1,
* indique un site de liaison à M₁ dans la Formule 1, et
*' indique un site de liaison à T₂ dans la Formule 1 ; et/ou
dans lequel L₂₁ à L₂₄ dans la Formule 2 sont chacun indépendamment un groupe benzène, un groupe naphthalène, un groupe anthracène, un groupe phénanthrène, un groupe triphénylène, un groupe pyrène, un groupe chrysène, un groupe cyclopentadiène, un groupe 1,2,3,4-tétrahydronaphthalène, un groupe pyrrole, un groupe thiophène, un groupe furane, un groupe indole, un groupe indène, un groupe benzothiophène, un groupe benzofurane, un groupe carbazole, un groupe fluorène, un groupe dibenzofurane ou un groupe dibenzothiophène, chacun étant non substitué ou substitué par au moins un élément parmi deutérium, -F, -Cl, -Br, -I, -CD₃, -CD₂H, - CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe sulfonique ou un sel de celui-ci, un groupe acide phosphorique ou un sel de celui-ci, un groupe C₁-C₂₀ alkyle, un groupe C₁-C₂₀ alkoxy, un groupe C₁-C₂₀ alkylthio, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe biphényle, un groupe terphényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe furanyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzoïmidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe benzocarbazolyle, un groupe imidazopyridinyle, un groupe imidazopyrimidinyle, un groupe azacarbazolyle, un groupe azadibenzofuranyle, un groupe azadibenzothiophényle, - Si(Q₃₃)(Q₃₄)(Q₃₅), ou une combinaison de ceux-ci, et
Q₃₃ à Q₃₅ sont chacun indépendamment un groupe méthyle, un groupe éthyle, un groupe n-propyle, un groupe isopropyle, un groupe n-butyle, un groupe sec-butyle, un groupe isobutyle, un groupe tert-butyle, un groupe n-pentyle, un groupe tert-pentyle, un groupe néopentyle, un groupe isopentyle, un groupe sec-pentyle, un groupe 3-pentyle, un groupe sec-isopentyle, un groupe phényle, un groupe biphényle ou un groupe naphthyle, chacun étant non substitué ou substitué par au moins un élément parmi deutérium, -F, un groupe C₁-C₁₀ alkyle, un groupe phényle, ou une combinaison de ceux-ci.

6. Composé organométallique selon l'une quelconque des revendications 1 à 5, dans lequel a21 et a24 dans la Formule 2 sont chacun indépendamment 0 ou 1 ; et/ou
dans lequel R₂₀₁ à R₂₀₃ dans la Formule 2 sont chacun indépendamment :
un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe n-hexyle, un groupe isohexyle, un groupe sec-hexyle, un groupe tert-hexyle, un groupe n-heptyle, un groupe isoheptyle, un groupe sec-heptyle, un groupe tert-heptyle, un groupe n-octyle, un groupe isooctyle, un groupe sec-octyle, un groupe tert-octyle, un groupe n-nonyle, un groupe isononyle, un groupe sec-nonyle, un groupe tertnonyle, un groupe n-décyle, un groupe isodécyle, un groupe sec-décyle ou un groupe tert-décyle, chacun étant non substitué ou substitué par au moins un élément parmi deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₂₀ alkoxy, un groupe C₁-C₂₀ alkylthio, un groupe cyclopentyle, un groupe cyclohexyle, un groupe cycloheptyle, un groupe cyclooctyle, un groupe adamantanyle, un groupe norbornanyle, un groupe norboményle, un groupe cyclopentényle, un groupe cyclohexényle, un groupe cycloheptényle, un groupe phényle, un groupe naphthyle, un groupe pyridinyle, un groupe pyrimidinyle, ou une combinaison de ceux-ci ; ou
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe pyridinyle ou un groupe pyrimidinyle, chacun étant non substitué ou substitué par au moins un élément parmi deutérium, -F, -Cl, -Br, -I, -CD₃, -CD₂H, -CDH₂, - CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₂₀ alkoxy, un groupe C₁-C₂₀ alkylthio, un groupe cyclopentyle, un groupe cyclohexyle, un groupe cycloheptyle, un groupe cyclooctyle, un groupe adamantanyle, un groupe norbornanyle, un groupe norboményle, un groupe cyclopentényle, un groupe cyclohexényle, un groupe cycloheptényle, un groupe phényle, un groupe naphthyle, un groupe pyridinyle, un groupe pyrimidinyle, ou une combinaison de ceux-ci.

7. Composé organométallique selon l'une quelconque des revendications 1 à 6, dans lequel un groupe représenté par la Formule 2 est représenté par la Formule 2(1) : 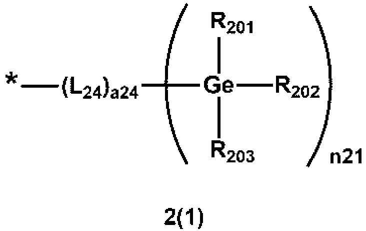
dans lequel, dans la formule 2(1),
L₂₄, R₂₀₁ à R₂₀₃ et n21 sont tels que définis selon la revendication 1,
a24 est 0 ou 1, et
* indique un site de liaison à un atome voisin.

8. Composé organométallique selon l'une quelconque des revendications 1 à 7, dans lequel chaque groupe représenté par la Formule 2 est indépendamment un groupe représenté par l'une des Formules 2-1 à 2-4 : 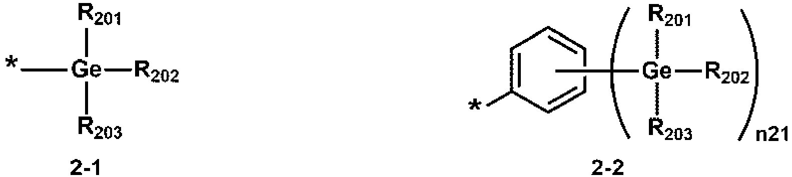 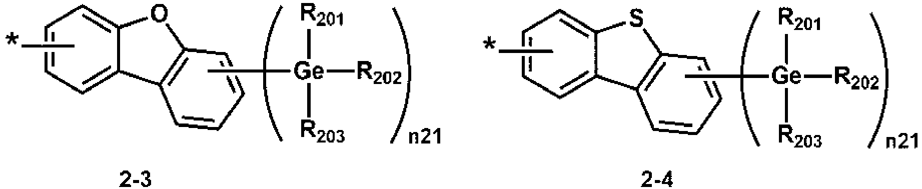
dans lequel, dans les Formules 2-1 à 2-4,
R₂₀₁ à R₂₀₃ et n21 sont tels que définis selon la revendication 1, et
* indique un site de liaison à un atome voisin.

9. Composé organométallique selon l'une quelconque des revendications 1 à 8, dans lequel chaque groupe représenté par la Formule 2 est indépendamment un groupe représenté par l'une des Formules 2-101 à 2-134 : 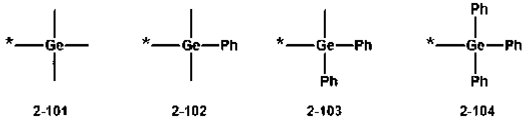 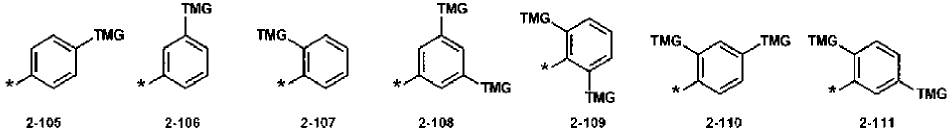 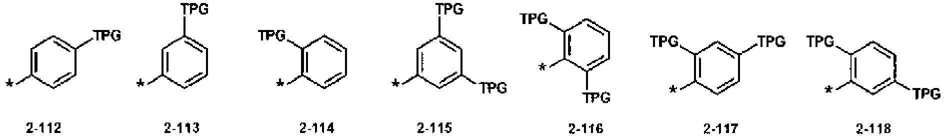 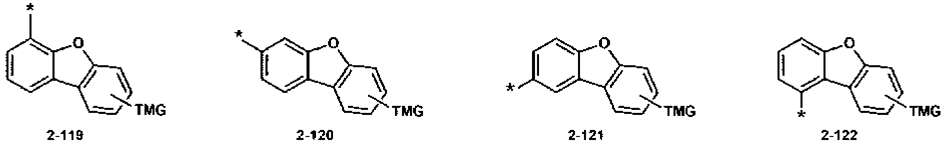 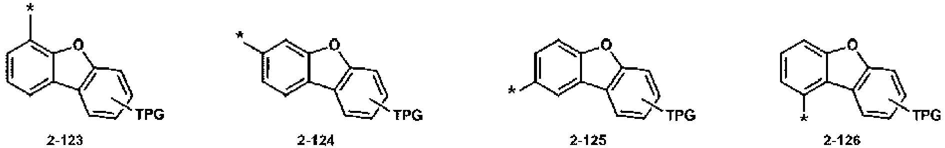 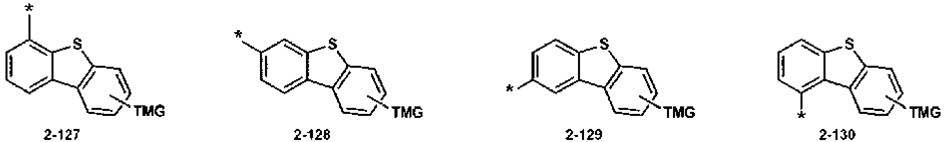 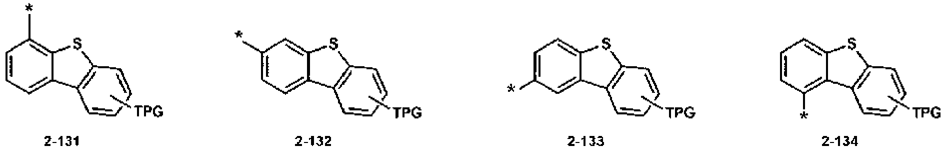
dans lequel, dans les Formules 2-101 à 2-134,
« TMG » est un groupe triméthyl-germyle,
« TPG » est un groupe triphényl-germyle, et
* indique un site de liaison à un atome voisin.

10. Composé organométallique selon l'une quelconque des revendications 1 à 9, ledit composé organométallique étant représenté par l'une des Formules 1A à 1D : 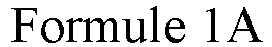 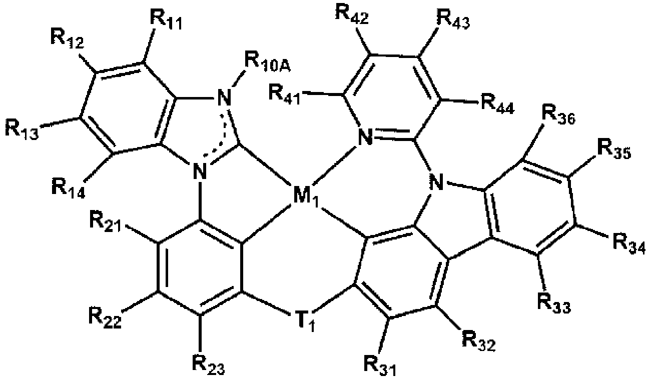 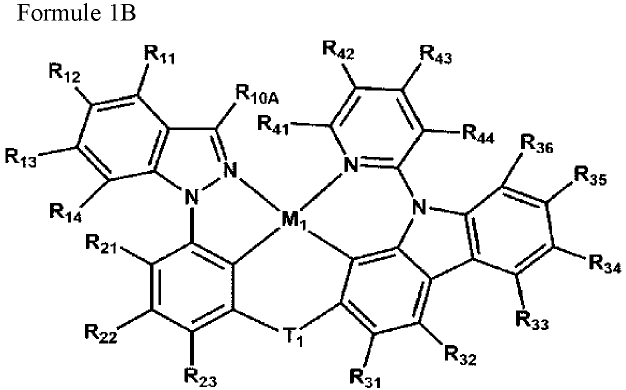 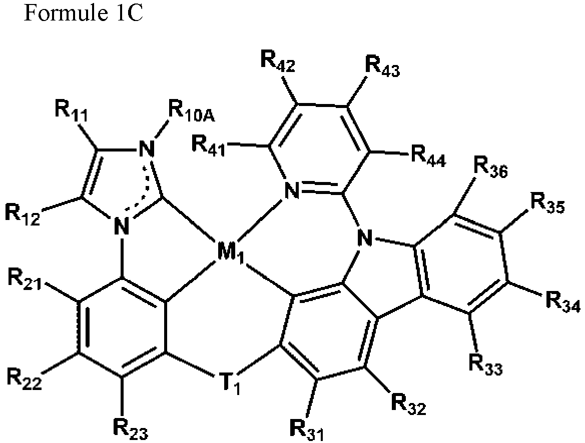 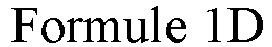 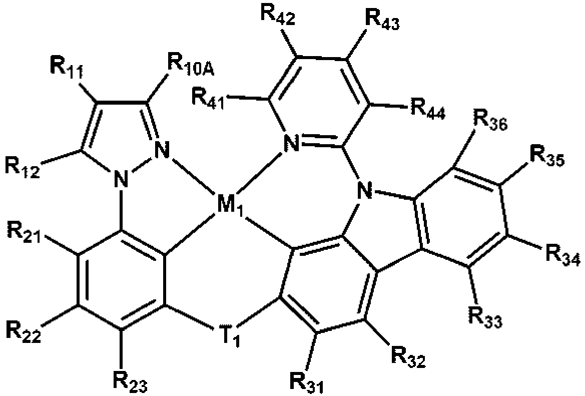
dans lequel, dans les Formules 1A à 1D,
M₁, T₁, R_{10A}, R₁₁ et R₁₂ sont tels que définis selon la revendication 1,
R₁₃ et R₁₄ sont chacun tels que définis en relation avec R₁₀ selon la revendication 1,
R₂₁ à R₂₃ sont chacun tels que définis en relation avec R₂₀ selon la revendication 1,
R₃₁ à R₃₆ sont chacun tels que définis en relation avec R₃₀ selon la revendication 1,
R₄₁ à R₄₄ sont chacun tels que définis en relation avec R₄₀ selon la revendication 1, et
au moins un élément parmi Ru à R₁₄, R₂₁ à R₂₃, R₃₁ à R₃₆ et R₄₁ à R₄₄ dans les Formules 1A et 1B est un groupe représenté par la Formule 2, et
au moins un élément parmi R₁₁, R₁₂, R₂₁ à R₂₃, R₃₁ à R₃₆ et R₄₁ à R₄₄ dans les Formules 1C et 1D est un groupe représenté par la Formule 2.

11. Composé organométallique selon la revendication 1, ledit composé organométallique étant représenté par un ou plusieurs des composés 1 à 218 : 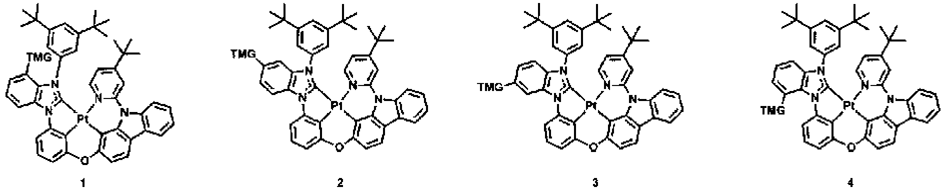 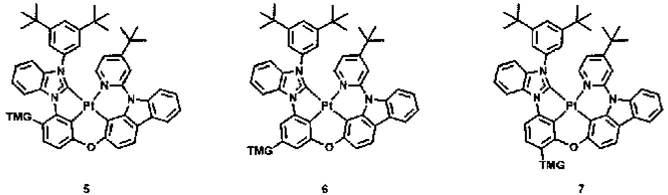 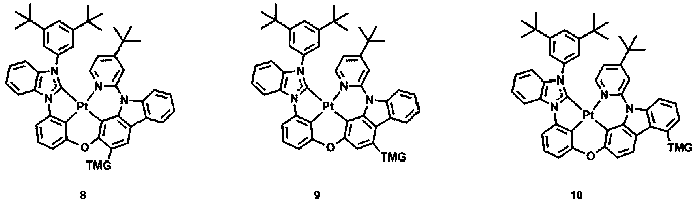 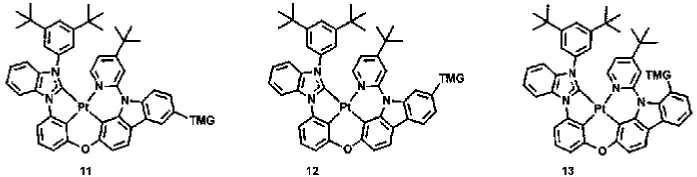 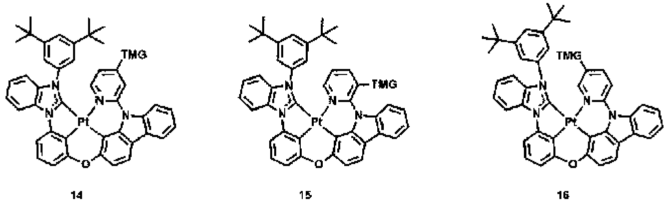 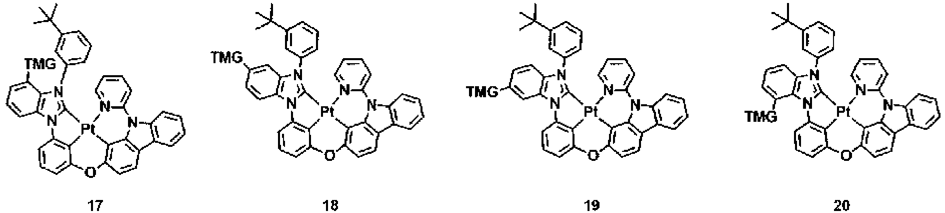 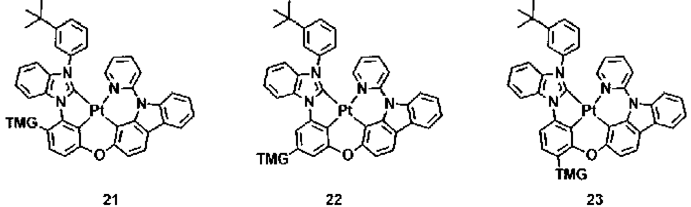 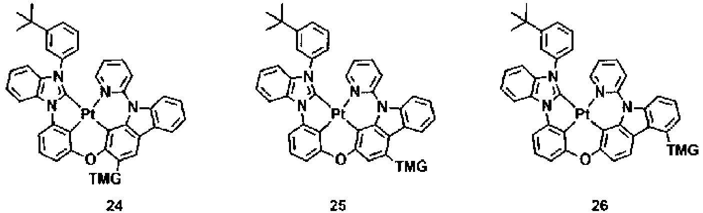 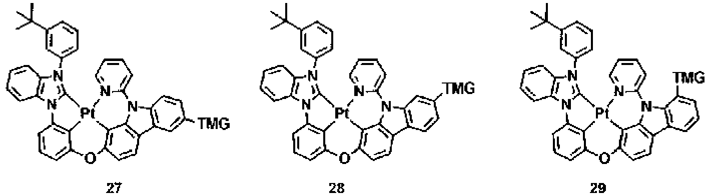 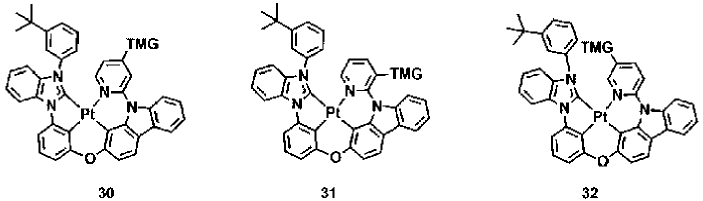 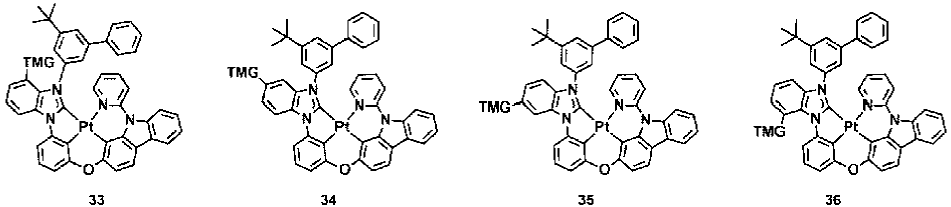 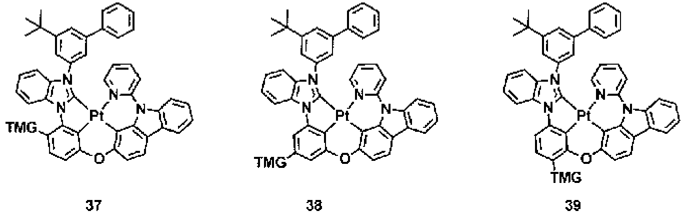 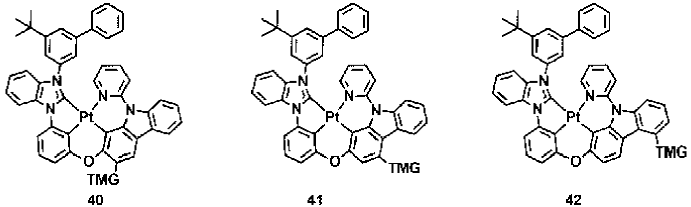 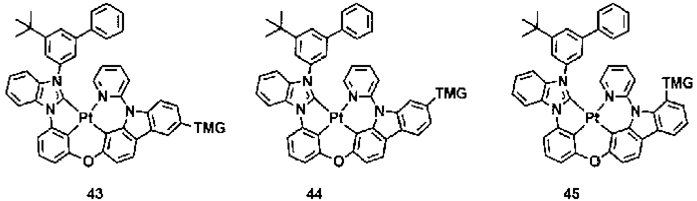 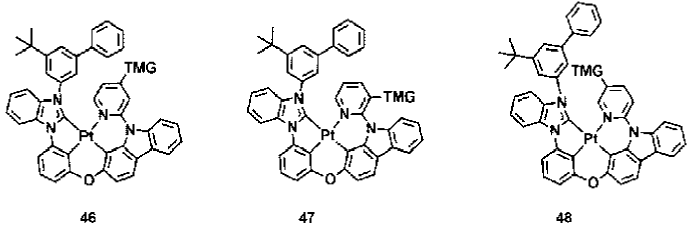 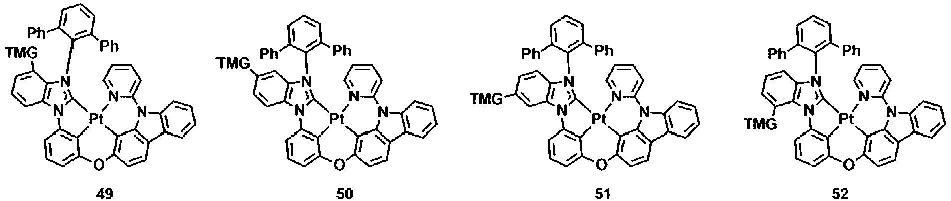 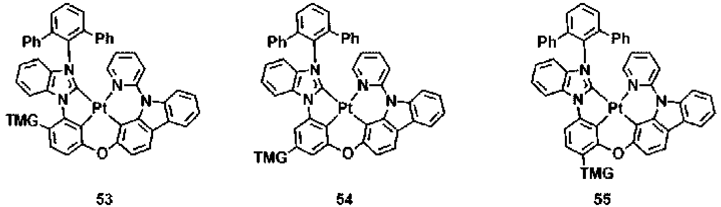 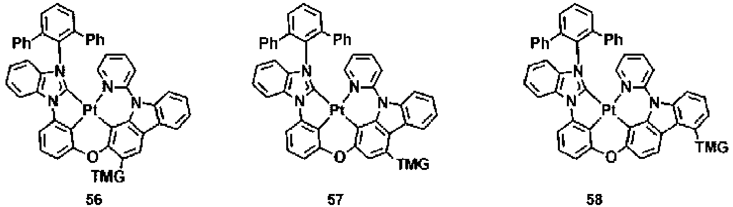 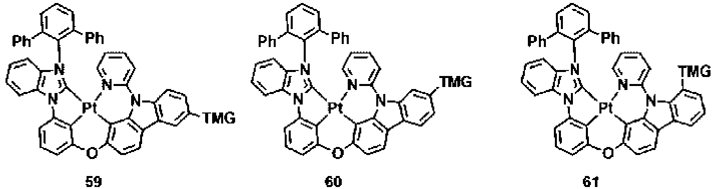 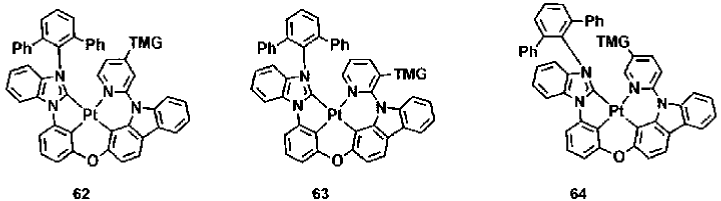 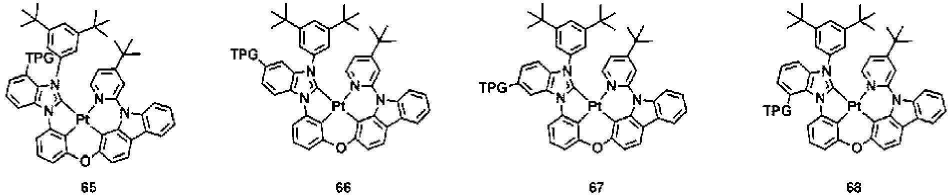 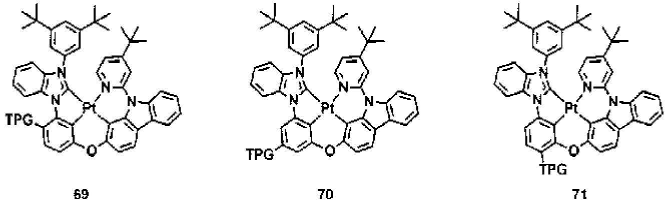 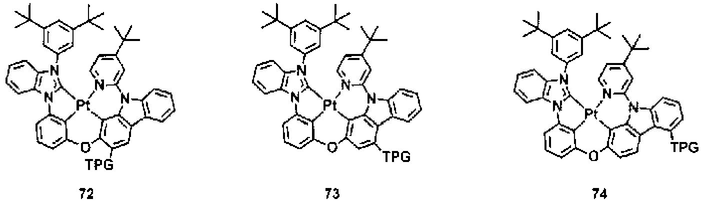 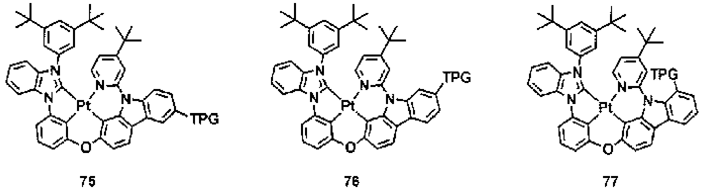 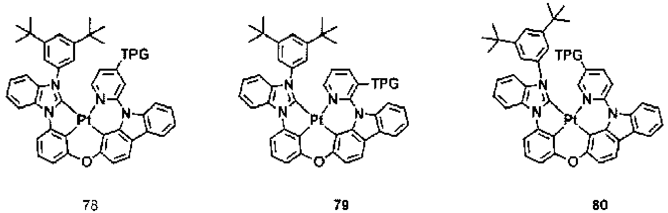 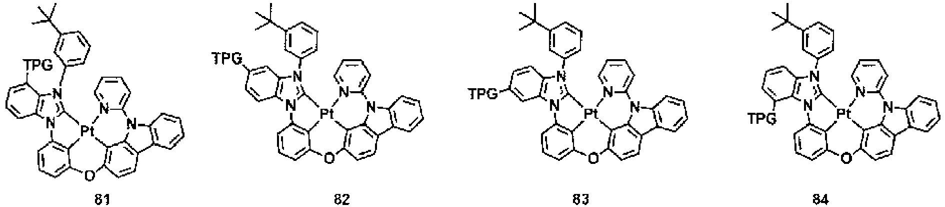 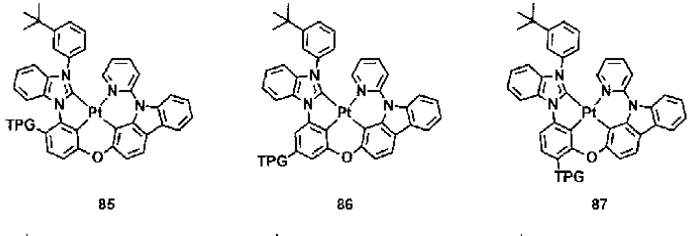 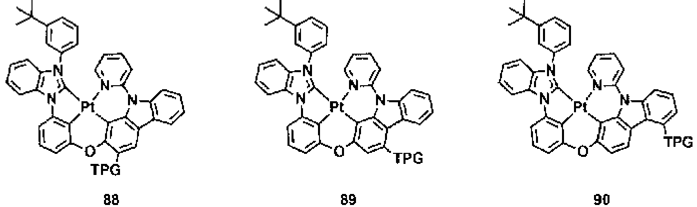 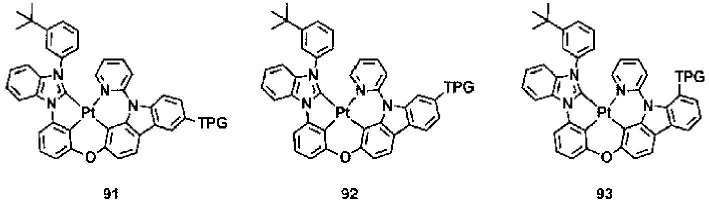 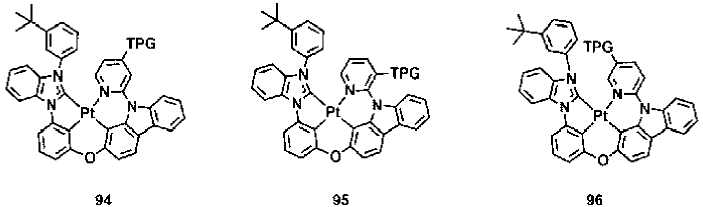 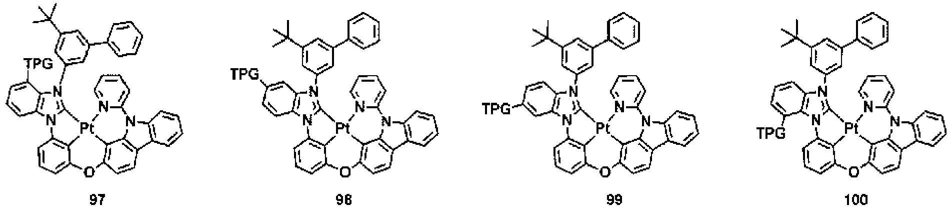 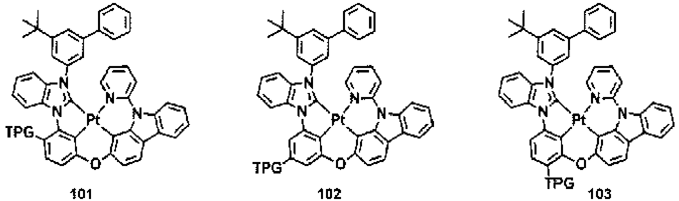 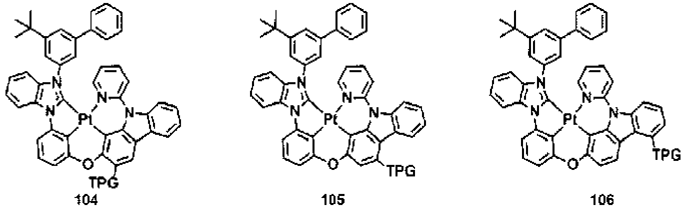 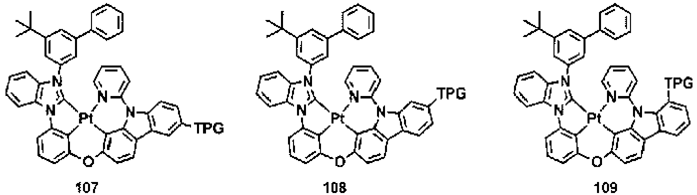 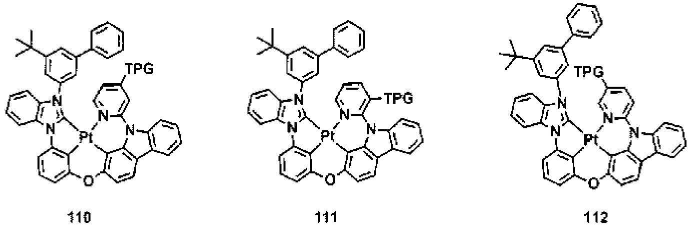 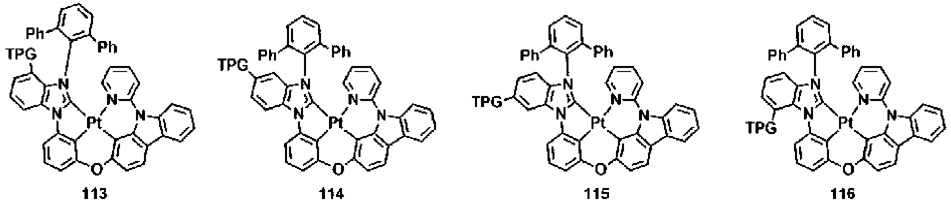 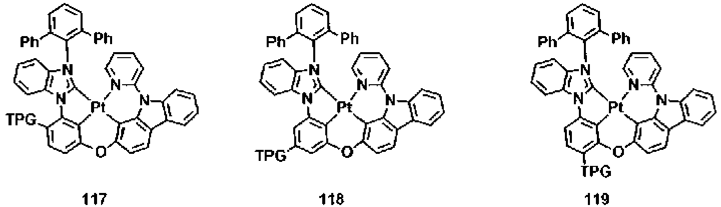 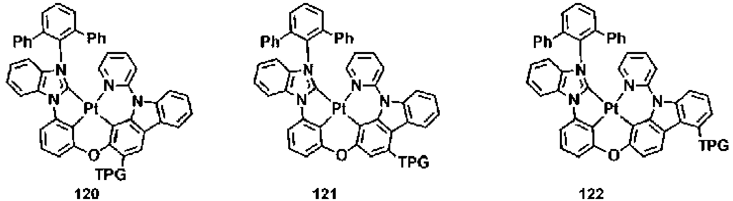 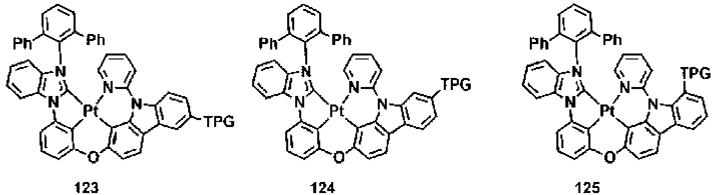 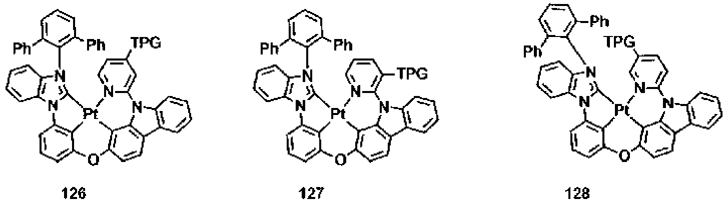 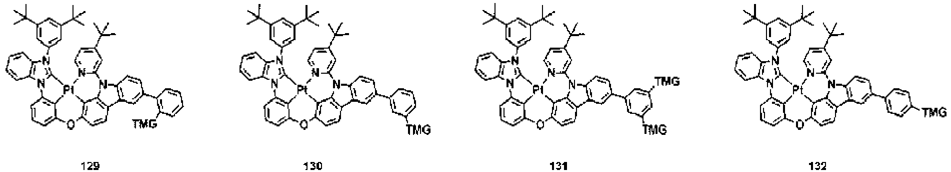 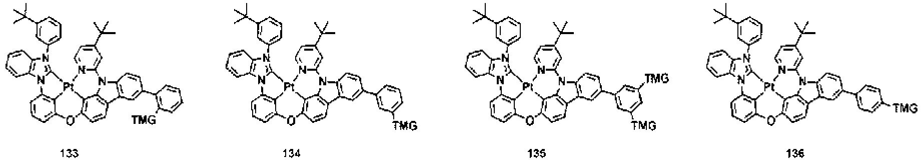 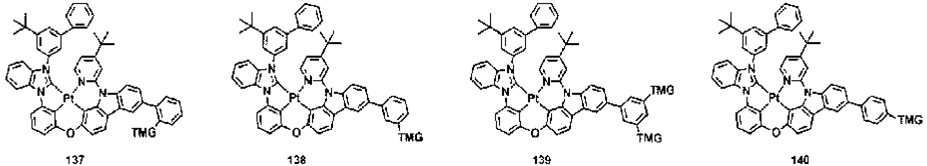 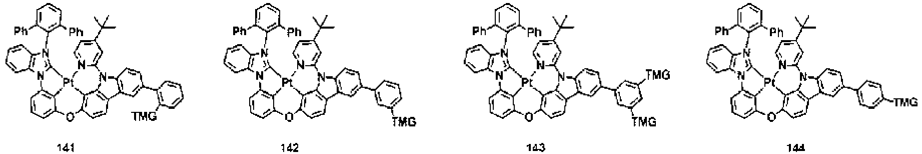 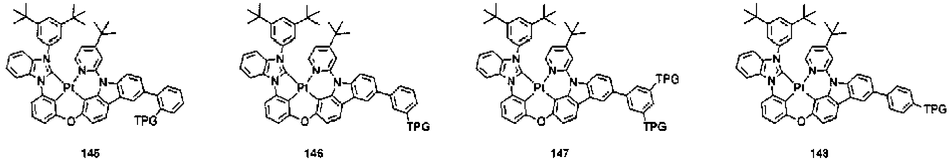 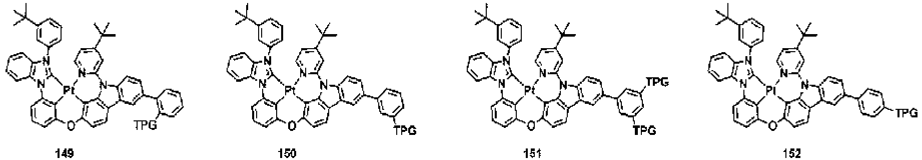 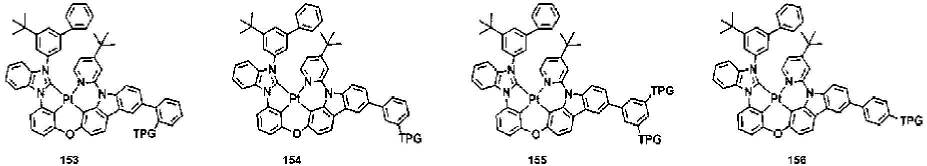 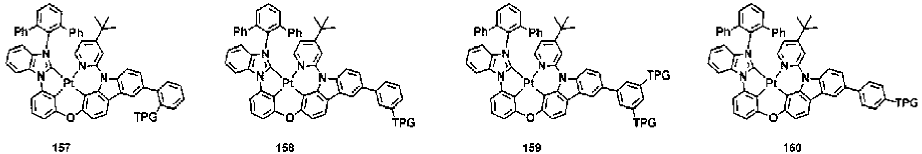 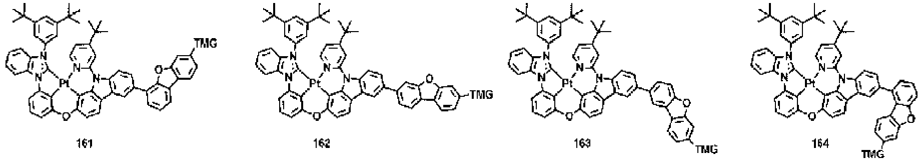 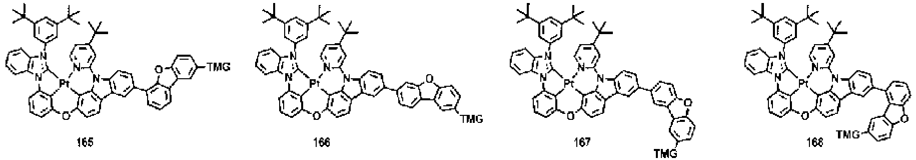 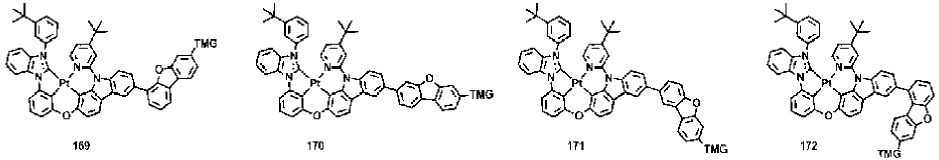 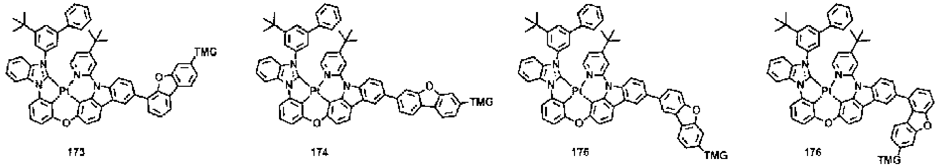 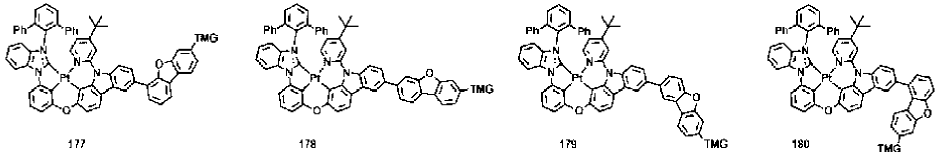 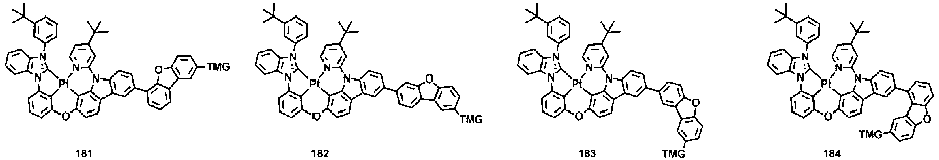 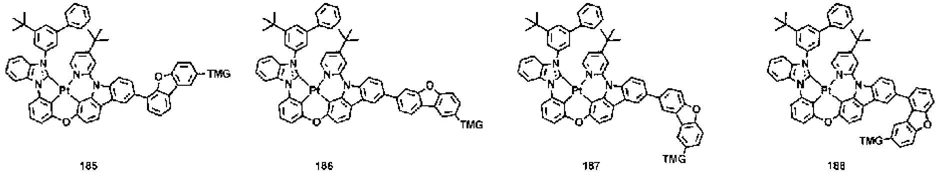 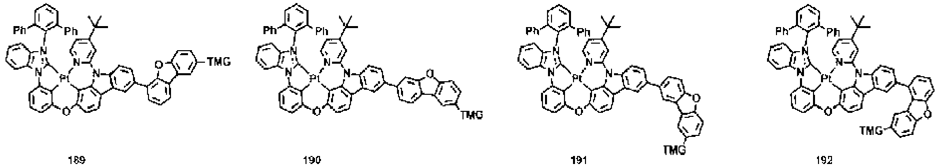 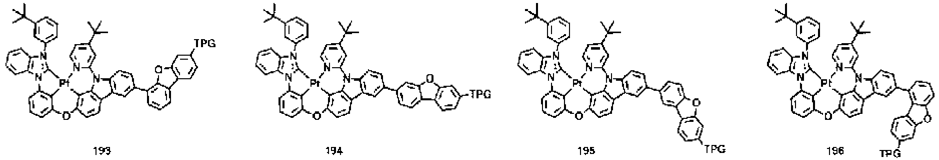 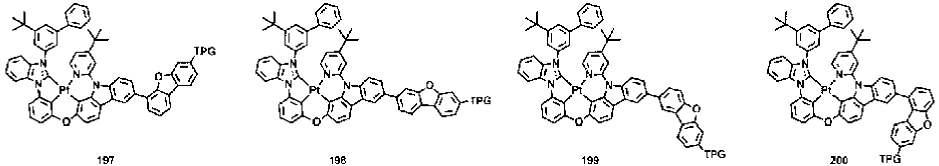 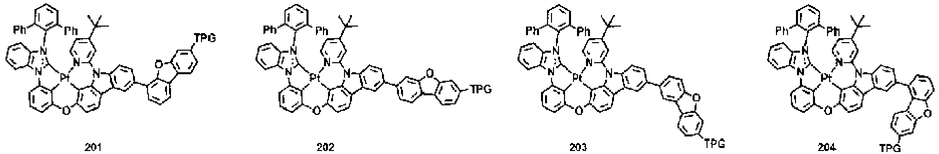 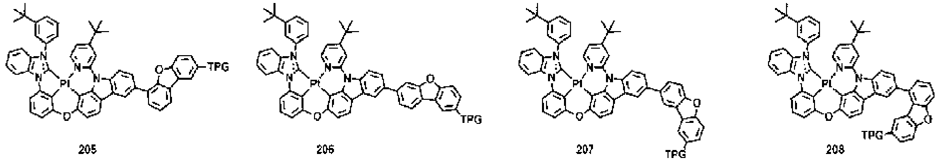 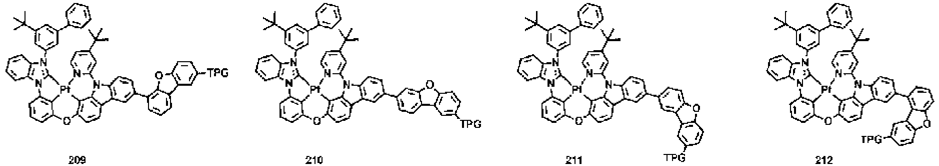 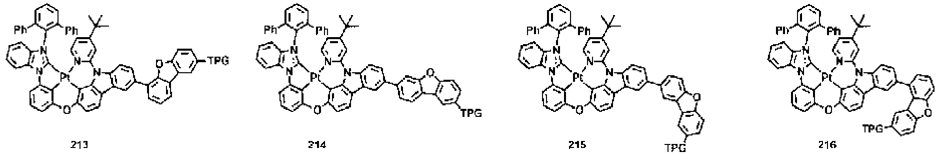 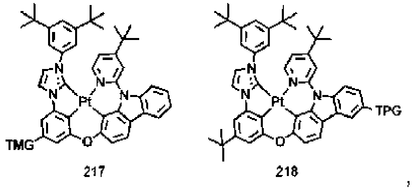 dans lequel « TMG » est un groupe triméthyl-germyle et « TPG » est un groupe triphényl-germyle.

12. Dispositif électroluminescent organique comprenant :
une première électrode ;
une deuxième électrode ; et
une couche organique disposée entre la première électrode et la deuxième électrode,
la couche organique comprenant une couche d'émission, et
la couche organique comprenant en outre au moins un composé organométallique selon l'une quelconque des revendications 1 à 11.

13. Dispositif électroluminescent organique selon la revendication 12, dans lequel la couche d'émission comprend l'au moins un composé organométallique.

14. Dispositif électroluminescent organique selon la revendication 13, dans lequel la couche d'émission comprend en outre un hôte, et une quantité de l'hôte dans la couche d'émission est supérieure à une quantité de l'au moins un composé organométallique dans la couche d'émission ; et/ou
dans lequel la couche d'émission émet une lumière bleue comportant une longueur d'onde d'émission maximale dans la plage de 410 nanomètres à 490 nanomètres ; et/ou
dans lequel au moins 80 % de l'émission de luminescence totale émise par la couche d'émission est dérivée de l'au moins un composé organométallique.

15. Dispositif électroluminescent organique selon l'une quelconque des revendications 12 à 14, dans lequel
la première électrode est une anode,
la seconde électrode est une cathode,
la couche organique comprend en outre une région de transport de trous disposée entre la première électrode et la couche d'émission et une région de transport d'électrons disposée entre la couche d'émission et la deuxième électrode,
la région de transport de trous comprend une couche d'injection de trous, une couche de transport de trous, une couche de blocage d'électrons, une couche tampon, ou une combinaison de celles-ci, et
la région de transport d'électrons comprend une couche de blocage de trous, une couche de transport d'électrons, une couche d'injection d'électrons, ou toute combinaison de celles-ci.
